(19) Europäisches Patentamt
European Patent Office
Office européen des brevets

(11) EP 4 738 008 A1

(12) EUROPEAN PATENT APPLICATION

(43) Date of publication:
**06.05.2026 Bulletin 2026/19**

(21) Application number: **25212298.1**

(22) Date of filing: **30.10.2025**

(51) International Patent Classification (IPC):
***G03F 7/00*** *(2006.01)* ***G03F 7/027*** *(2006.01)*

(52) Cooperative Patent Classification (CPC):
(C-Sets available)
**G03F 7/027; C08F 2/50; G03F 7/0002;** C08F 2/48;
G03F 7/0048 (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **05.11.2024 JP 2024194024**

(71) Applicant: **Canon Kabushiki Kaisha**
**Tokyo, 146-8501 (JP)**

(72) Inventors:
- **ITO, Yuto**
  **Ohta-ku, Tokyo 146-8501 (JP)**
- **ITO, Toshiki**
  **Ohta-ku, Tokyo 146-8501 (JP)**
- **KAWATA, Isao**
  **Ohta-ku, Tokyo 146-8501 (JP)**
- **IMAMURA, Hideki**
  **Ohta-ku, Tokyo 146-8501 (JP)**
- **NAKATA, Eiichi**
  **Ohta-ku, Tokyo 146-8501 (JP)**

(74) Representative: **TBK**
**Bavariaring 4-6**
**80336 München (DE)**

# (54) CURABLE COMPOSITION AND METHODS FOR FORMING FILM AND MANUFACTURING ARTICLE

(57) A curable composition includes a polymerizable compound (a), a photopolymerization initiator (b), and a solvent (d). The curable composition has a viscosity of 1.3 mPa·s to 60 mPa·s at 23°C and 1 atm. The amount of the solvent (d) ranges from more than 5% to 95% by volume relative to the entire curable composition. The boiling point of the solvent (d) is less than 250°C. The curable composition in a state excluding the solvent (d) has a viscosity of 8 mPa·s to 30 mPa·s at 23°C and 1 atm.

FIG. 1A

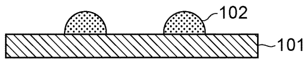


FIG. 1B

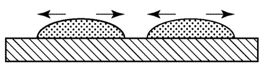

FIG. 1C

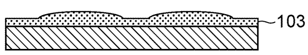


FIG. 1D

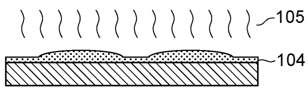


FIG. 1E

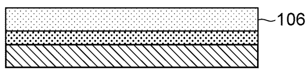


FIG. 1F

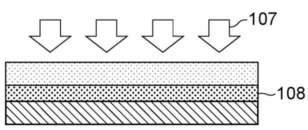


FIG. 1G

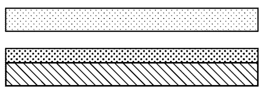

EP 4 738 008 A1

(52) Cooperative Patent Classification (CPC): (Cont.)

C-Sets
C08F 222/102, C08F 222/102

## Description

TECHNICAL FIELD

The present disclosure relates to a curable composition and methods for forming a film and producing an article.

BACKGROUND

In the field of semiconductor devices, microelectromechanical systems (MEMS), and similar technologies, miniaturization is increasingly demanded, and imprinting techniques (optical imprinting techniques) are attracting attention as microfabrication techniques. In imprinting techniques, a curable composition is fed (applied) onto a substrate and cured in a state where a mold having a fine relief pattern in the contact surface is in contact with the composition. Thus, the relief pattern of the mold is transferred to the cured film of the curable composition, thereby forming a pattern on the substrate. Imprinting techniques enable the formation of fine patterns (structures) with sizes of several nanometers on substrates.

An example of pattern formation using an imprinting technique will be described. First, a liquid curable composition is discretely dropped (applied) in a pattern formation region on a substrate. The droplets of the curable composition in the pattern formation region spread over the surface of the substrate. This phenomenon is called pre-spreading. Next, the curable composition on the substrate is brought into contact with (pressed on) the contact face of a mold. Consequently, the droplets of the curable composition spread throughout the gap between the substrate and the mold due to capillary action. This phenomenon is called spreading. In addition, the curable composition fills the recesses of the mold pattern due to capillary action. This phenomenon is called filling. The duration required to complete such spreading and filling is called filling time. After completion of filling, the curable composition is irradiated with light to be cured. The cured composition on the substrate is then separated from the mold. Thus, a cured pattern of the curable composition is formed by transferring the pattern of the mold to the curable composition on the substrate through these steps. At this point, the cured pattern of the curable composition formed on the substrate has a residual film. The residual film is a cured film remaining between the recesses of the cured film of the curable composition (protrusions of the mold pattern) and the substrate.

Also, photolithography for manufacturing semiconductor devices requires the substrate to be planarized. For example, in extreme ultraviolet lithography (EUV), which is a technique of photolithography that has been attracting attention in recent years, the relief pattern in the surface of the substrate to which the curable composition is fed must be restricted to several tens of nanometers or smaller because the focal depth at which the projected image is formed decreases as miniaturization progresses. Imprinting techniques also require planarization to the same extent as EUV to improve the degree of filling and line width accuracy of the curable composition. In a planarization technique (Japanese Patent Laid-Open No. 2019-140394), a flat surface is formed by dropping a curable composition discretely onto a substrate provided with a relief structure in an amount corresponding to the relief structure and subsequently curing the composition while being in contact with a mold having a flat surface.

In pattern formation methods and planarization techniques using imprinting, the curable composition on the substrate is brought into contact with a mold in a state where the droplets of the curable composition do not touch each other. This process inevitably causes air bubbles to be trapped between the mold, the substrate, and the composition. Consequently, it takes a long time for the air bubbles to diffuse across the mold and substrate to disappear, which is one of the factors that reduce productivity (throughput). Accordingly, a technique has been developed to merge the droplets of the curable composition on the substrate before bringing the curable composition into contact with the mold (see Japanese Patent Laid-Open No. 2022-188736).

The technique disclosed in Japanese Patent Laid-Open No. 2022-188736, requires that the curable composition fills the contact area (pattern formation region), reaching the ends (edges), between the mold and the substrate by bringing the mold into contact with (pressing the mold against) the liquid film of the curable composition formed through spreading the droplets. This phenomenon is called edge filling. The speed at which edge filling proceeds is called edge filling speed. In pattern formation methods and planarization techniques using imprinting, in which droplets of the curable composition on the substrate are brought into contact with a mold, it takes time to fill a desired area (pattern formation region), reaching the ends (edges). This is one of the factors that reduce productivity (throughput).

SUMMARY

Accordingly, the present disclosure provides a novel technique for curable compositions.

The present disclosure in its first aspect provides a curable composition as specified in claim 1. Optional features are specified in claims 3 and 5 to 16.

The present disclosure in its second aspect provides a curable composition as specified in claim 2. Optional

features are specified in claims 3 to 16.

The present disclosure in its third aspect provides a film formation method as specified in claim 17. Optional features are specified in claims 18 to 23.

The present disclosure in its fourth aspect provides a method for manufacturing an article as specified in claim 24.

Features of the present disclosure will become apparent from the following description of embodiments with reference to the attached drawings. The following description of embodiments is described by way of example.

BRIEF DESCRIPTION OF THE DRAWINGS

Figs. 1A to 1G are schematic representations illustrating a method for forming a pattern (film formation method) according to an aspect of the present disclosure.

Figs. 2A to 2D are schematic representations illustrating the flowing behavior of droplets of a curable composition during a waiting step.

Fig. 3 is a schematic representation illustrating the segregation of a surfactant during a contact step.

Fig. 4 is a schematic representation illustrating the contact step.

Fig. 5 is a plot of changes in edge filling speed with varying viscosity coefficient of a liquid film.

Fig. 6 is a plot of results from the same calculation as in Fig. 5 with the horizontal axis plotted as time/viscosity coefficient.

Fig. 7 is a plot of changes in edge filling speed with varying average liquid film thickness.

Fig. 8 is a plot of the relationship between average liquid film thickness and edge filling speed.

DESCRIPTION OF THE EMBODIMENTS

Embodiments of the present disclosure will now be described with reference to the drawings. However, it should be appreciated that the embodiments described below are not intended to limit the scope of the appended claims. Although the embodiments include several features, not all of those features are necessarily essential and may be combined as needed. In the accompanying drawings, the same or similar parts are designated by the same reference numerals and thus description thereof is omitted.

Curable Composition

Curable composition (A) disclosed herein is for ink jet methods. Curable composition (A) disclosed herein contains component (a) that is a polymerizable compound and component (b) that is a photopolymerization initiator, and a solvent that is component (d) and may also contain component (c) that is a surfactant and other component (e). In the description presented herein, non-volatile component composition (A') is defined as the part of the curable composition (A) excluding component (d).

The term "cured film" used herein refers to a film formed by polymerizing a curable composition to cure the composition on a substrate. The cured film is not particularly limited in shape and may have a pattern in its surface. Also, a cured film remaining between the recesses of the cured film of the curable composition (protrusions of the mold pattern) and the substrate is referred to as a residual film.

Component (a): Polymerizable Compound

Component (a) consists of one or more polymerizable compounds. The term "polymerizable compound" mentioned herein refers to a compound that reacts with a polymerizing factor, such as a radical, produced from a photopolymerization initiator (component (b)) and forms a polymer film through a chain reaction (polymerization reaction).

Examples of such polymerizable compounds include radical-polymerizable compounds. Component (a) may be an individual polymerizable compound or a combination of a plurality of (two or more) polymerizable compounds.

Radical-polymerizable compounds include (meth)acrylic compounds, styrene-based compounds, vinyl compounds, allyl compounds, fumaric compounds, and maleic compounds.

(Meth)acrylic compounds have one or more acryloyl groups or methacryloyl groups. Examples of monofunctional (meth)acrylic compounds containing one acryloyl or methacryloyl group include, but are not limited to:
phenoxyethyl (meth)acrylate, phenoxy-2-methylethyl (meth)acrylate, phenoxyethoxyethyl (meth)acrylate, 3-phenoxy-2-hydroxypropyl (meth)acrylate, 2-phenylphenoxyethyl (meth)acrylate, 4-phenylphenoxyethyl (meth)acrylate, 3-(2-phenylphenyl)-2-hydroxypropyl (meth)acrylate, EO-modified p-cumylphenol (meth)acrylate, 2-bromophenoxyethyl (meth)acrylate, 2,4-dibromophenoxyethyl (meth)acrylate, 2,4,6-tribromophenoxyethyl (meth)acrylate, EO-modified phenoxy

(meth)acrylate, PO-modified phenoxy (meth)acrylate, polyoxyethylene nonylphenyl ether (meth)acrylate, isobornyl (meth)acrylate, 1-adamantyl (meth)acrylate, 2-methyl-2-adamantyl (meth)acrylate, 2-ethyl-2-adamantyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, 4-butylcyclohexyl (meth)acrylate, acryloylmorpholine, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth) acrylate, isopropyl (meth)acrylate, butyl (meth)acrylate, amyl (meth)acrylate, isobutyl (meth)acrylate, t-butyl (meth) acrylate, pentyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate, isostearyl (meth)acrylate, benzyl (meth)acrylate, tetrahydrofurfuryl (meth)acrylate, butoxyethyl (meth)acrylate, ethoxydiethylene glycol (meth) acrylate, polyethylene glycol mono(meth)acrylate, polypropylene glycol mono(meth)acrylate, methoxyethylene glycol (meth)acrylate, ethoxyethyl (meth)acrylate, methoxypolyethylene glycol (meth)acrylate, methoxypolypropylene glycol (meth)acrylate, diacetone (meth)acrylamide, isobutoxymethyl(meth)acrylamide, N,N-dimethyl(meth)acrylamide, t-octyl(meth)acrylamide, dimethylaminoethyl (meth)acrylate, diethylaminoethyl (meth)acrylate, 7-amino-3,7-dimethyloctyl (meth)acrylate, N,N-diethyl(meth)acrylamide, N,N-dimethylaminopropyl(meth)acrylamide, 1-, or 2-naphthyl (meth)acrylate, 1- or 2-naphthylmethyl (meth)acrylate, 3- or 4-phenoxybenzyl (meth)acrylate, cyanobenzyl (meth)acylate, and naphthylmethyl (meth)acrylate.

Examples of commercially available products of such monofunctional (meth)acrylic compounds include, but are not limited to:

Aronix (registered trademark) series M101, M102, M110, M111, M113, M117, M5700, TO-1317, M120, M150, and M156 (all produced by Toagosei); MEDOL 10, MIBDOL 10, CHDOL 10, MMDOL 30, MEDOL 30, MIBDOL 30, CHDOL 30, LA, IBXA, 2-MTA, HPA, and Biscoat series #150, #155, #158, #190, #192, #193, #220, #2000, #2100, and #2150 (all produced by Osaka Organic Chemical Industry); Light Acrylates BO-A, EC-A, DMP-A, THF-A, HOP-A, HOA-MPE, HOA-MPL, PO-A, P-200A, NP-4EA, and NP-8EA, and Epoxy Esters M-600A, POB-A, and OPP-EA (all produced by Kyoeisha Chemical); KAYARAD (registered trademark) series TC110S, R-564, and R-128H (all produced by Nippon Kayaku); NK Esters AMP-10G, AMP-20G, and A-LEN-10 (all produced by Shin-Nakamura Chemical); FA-511A, FA-512A, and FA-513A (all produced by Resonac Corporation); PHE, CEA, PHE-2, PHE-4, BR-31, BR-31M, and BR-32 (all produced by Dai-ichi Kogyo Seiyaku); VP (produced by BASF); ACMO, DMAA, and DMAPAA (all produced by Kohjin); and HRD-01 (produced by Nippon Shokubai).

Examples of polyfunctional (meth)acrylic compounds containing two or more acryloyl or methacryloyl groups include, but are not limited to:

trimethylolpropane di(meth)acrylate, trimethylolpropane tri(meth)acrylate, EO-modified trimethylolpropane tri(meth)acrylate, PO-modified trimethylolpropane tri(meth)acrylate, EO, PO-modified trimethylolpropane tri(meth)acrylate, dimethylol tricyclodecane di(meth)acrylate, pentaerythritol tri(meth)acrylate, pentaerythritol tetra(meth)acrylate, ethylene glycol di(meth)acrylate, tetraethylene glycol di(meth)acrylate, polyethylene glycol di(meth)acrylate, polypropylene glycol di(meth)acrylate, 1,4-butanediol di(meth)acrylate, 1,6-hexanediol di(meth)acrylate, neopentyl glycol di(meth)acrylate, 1,9-nonanediol di(meth)acrylate, 1,10-decanediol di(meth)acrylate, 1,3-adamantanedimethanol di(meth)acrylate, tris(2-hydroxyethyl)isocyanurate tri(meth)acrylate, tris(acryloyloxy)isocyanurate, bis(hydroxymethyl)tricyclodecane di(meth) acrylate, dipentaerythritol penta(meth)acrylate, dipentaerythritol hexa(meth)acrylate, EO-modified 2,2-bis(4-((meth)acryloxy)phenyl)propane, PO-modified 2,2-bis(4-((meth)acryloxy)phenyl)propane, EO, PO-modified 2,2-bis(4-((meth)acryloxy)phenyl)propane, o-, m- or p-benzene di(meth)acrylate, and o-, m-, or p-xylene di(meth)acrylate.

Examples of commercially available products of such polyfunctional (meth)acrylic compounds include, but are not limited to:

Yupimer (registered trademark) UV series SA1002 and SA2007 (both produced by Mitsubishi Chemical); Biscoat series #195, #230, #215, #260, #335HP, #295, #300, #360, #700, GPT, and 3PA (all produced by Osaka Organic Chemical Industry); Light Acrylates 4EG-A, 9EG-A, NP-A, DCP-A, BP-4EA, BP-4PA, TMP-A, PE-3A, PE-4A, and DPE-6A (all produce by Kyoeisha Chemical); KAYARAD (registered trademark) series PET-30, TMPTA, R-604, DPHA, DPCA-20, -30, -60 and -120, HX-620, D-310, and D-330 (all produced by Nippon Kayaku); Aronix (registered trademark) series M208, M210, M215, M220, M240, M305, M309, M310, M315, M325, and M400 (all produced by Toagosei); Ripoxy (registered trademark) series VR-77, VR-60, and VR-90 (all produced by Resonac Corporation); OGSOL EA-0200 and OGSOL EA-0300 (both produced by Osaka Gas Chemicals); and SR295 and SR355 (both produced by Sartomer).

In the above-presented compounds, (meth)acrylate refers to an acrylate or a methacrylate having an alcohol residue equivalent to that of the acrylate. Also, a (meth)acryloyl group refers to both acryloyl and methacryloyl groups collectively. EO represents ethylene oxide, and EO-modified compound A is a compound in which the (meth)acrylic acid residue and the alcohol residue of compound A are bound to each other with an ethylene oxide block structure therebetween. PO represents propylene oxide, and PO-modified compound B is a compound in which the (meth)acrylic acid residue and the alcohol residue of compound B are bound to each other with a propylene oxide block structure therebetween.

Specific examples of styrene-based compounds include, but are not limited to:
styrene; alkyl styrenes, such as 2,4-dimethyl-α-methylstyrene, o-methylstyrene, m-methylstyrene, p-methylstyrene, 2,4-dimethylstyrene, 2,5-dimethylstyrene, 2,6-dimethylstyrene, 3,4-dimethylstyrene, 3,5-dimethylstyrene, 2,4,6-trimethylstyrene, 2,4,5-trimethylstyrene, pentamethylstyrene, o-ethylstyrene, m-ethylstyrene, p-ethylstyrene, diethylstyrene, triethylstyrene, propylstyrene, 2,4-diisopropylstyrene, butylstyrene, hexylstyrene, heptylstyrene, and octylstyrene; halogenated styrenes, such as fluorostyrene, o-chlorostyrene, m-chlorostyrene, p-chlorostyrene, o-bromostyrene, m-bromostyrene, p-bromostyrene, dibromostyrene, and iodostyrene; and other compounds having the styryl group as a polymerizable functional group, such as nitrostyrene, acetylstyrene, o-methoxystyrene, m-methoxystyrene, p-methoxystyrene, o-hydroxystyrene, m-hydroxystyrene, p-hydroxystyrene, 2-vinylbiphenyl, 3-vinylbiphenyl, 4-vinylbiphenyl, 1-vinyl naphthalene, 2-vinylnaphthalene, 4-vinyl-p-terphenyl, 1-vinylanthracene, α-methylstyrene, o-isopropenyltoluene, m-isopropenyltoluene, p-isopropenyltoluene, 2,3-dimethyl-α-methylstyrene, 3,5-dimethyl-α-methylstyrene, p-isopropyl-α-methylstyrene, α-ethylstyrene, α-chlorostyrene, divinylbenzene, diisopropylbenzene, and divinylbiphenyl.
Specific examples of vinyl compounds include, but are not limited to:
vinylpyridine, vinylpyrrolidone, vinyl carbazole, vinyl acetate, and acrylonitrile; conjugated diene monomers, such as butadiene, isoprene, and chloroprene; halogenated vinyl compounds, such as vinyl chloride and vinyl bromide; halogenated vinylidene compounds, such as vinylidene chloride, organic carboxylic acid vinyl esters and their derivatives, such as vinyl acetate, vinyl propionate, vinyl butyrate, vinyl benzoate, and divinyl adipate; and (meth)acrylonitrile and other compounds having the vinyl group as a polymerizable functional group.
(Meth)acrylonitrile mentioned herein refers to acrylonitrile and methacrylonitrile collectively.
Examples of acrylic compounds include, but are not limited to:
allyl acetate, allyl benzoate, diallyl adipate, diallyl terephthalate, diallyl isophthalate, and diallyl phthalate.
Examples of fumaric compounds include, but are not limited to:
dimethyl fumarate, diethyl fumarate, diisopropyl fumarate, di-sec-butyl fumarate, diisobutyl fumarate, di-n-butyl fumarate, di-2-ethylhexyl fumarate, and dibenzyl fumarate.
Examples of maleic compounds include, but are not limited to:
dimethyl maleate, diethyl maleate, diisopropyl maleate, di-sec-butyl maleate, diisobutyl maleate, di-n-butyl maleate, di-2-ethylhexyl maleate, and dibenzyl maleate.
Examples of other radical-polymerizable compounds include, but are not limited to:
itaconic acid dialkyl esters and their derivatives, such as dimethyl itaconate, diethyl itaconate, diisopropyl itaconate, di-sec-butyl itaconate, diisobutyl itaconate, di-n-butyl itaconate, DI-2-ethylhexyl itaconate, and dibenzyl itaconate; organic carboxylic acid N-vinylamide derivatives, such as N-methyl-N-vinylacetamide; and maleimide and its derivatives, such as N-phenylmaleimide and N-cyclohexylmaleimide.
When component (a) consists of a plurality of compounds having one or more polymerizable functional groups, the component (a) preferably includes both monofunctional and polyfunctional polymerizable compounds. The proportion of polyfunctional polymerizable compounds in component (a) is preferably 20% or more by mass, more preferably 25% or more by mass, and particularly 40% or more by mass. This is because combining monofunctional polymerizable and polyfunctional polymerizable compounds results in a cured film exhibiting an excellent balance of properties, including high mechanical strength, high dry etching resistance, and high heat resistance.
In the film formation method disclosed herein, it takes several milliseconds to several hundred seconds until the droplets of curable composition (A), discretely applied onto a substrate, merge to form a substantially continuous liquid film. Accordingly, a waiting step is advised. The waiting step allows the solvent (component (d)) to volatilize, but not the component (a). Accordingly, the boiling points of the one or more polymerizable compounds in component (a) are each preferably 250°C or more under normal pressure, more preferably 300°C or more, still more preferably 350°C or more. To impart high dry etching resistance and high heat resistance to the cured film of the curable composition (A), component (a) preferably includes at least a compound with an aromatic structure, an aromatic heterocyclic structure, an alicyclic structure, or the like. Note that normal pressure is defined as 1 atm (atmospheric pressure).
The boiling point of polymerizable compounds (component (a)) generally correlates with molecular weight. The molecular weights of the one or more polymerizable compounds in component (a) are each preferably 200 or more, more preferably 240 or more, still more preferably 250 or more. Even when a polymerizable compound has a molecular weight of 200 or less, the polymerizable compound can be favorably used as component (a) provided that the boiling point of the polymerizable compound is 250°C or more. Thus, the boiling points of the one or more polymerizable compounds in component (a) are each preferably 250°C or more under normal pressure.
Also, the vapor pressure of polymerizable compounds (component (a)) is preferably 0.001 mmHg or less at 80°C. When component (a) includes one or more polymerizable compounds, the vapor pressure of each polymerizable compound is desirably 0.001 mmHg or less at 80°C. This is because while it is preferable to heat the polymerizable compounds so as to accelerate the volatilization of the solvent (component (d)) described later, the volatilization of component (a) should be inhibited.
The boiling point and vapor pressure of organic compounds can be calculated according to, for example, Hansen

Solubility Parameters in Practice (HSPiP) 5th Edition, Ver. 5.3.04.

Ohnishi Parameter of Component (a)

The dry etching rate V, the total number of atoms N, the total number of carbon atoms $N_C$, and the total number of oxygen atoms $N_O$ in an organic compound have the following relationship (1):

$$V \propto N/(Nc - No) \quad (1)$$

In this relationship, N/(Nc - No) is known as "Ohnishi parameter" (hereinafter abbreviated to "OP"). For example, U.S. Patent Application Laid-Open No. 2020/0286740 discloses a technique to produce a photocurable composition highly resistant to dry etching using a polymerizable compound having a low OP.

Relationship (1) suggests that organic compounds containing a larger number of oxygen atoms or a lower number of aromatic ring structures or alicyclic structures exhibit higher OP and accordingly higher dry etching rate.

In the curable composition (A) disclosed herein, component (a) has an OP of 1.80 to 4.00. Preferably, the OP of component (a) is 2.00 to 3.50, particularly 2.40 to 3.00. When the OP of component (a) is 4.00 or less, the cured film of curable composition (A) exhibits high dry etching resistance. Also, when the OP of component (a) is 1.80 or more, the cured film of curable composition (A) can be easily removed after processing the underlayer using the cured film. For component (a) consisting of a plurality of polymerizable compounds $a_1$, $a_2$, ⋯, and $a_n$, the OP is calculated as the weighted average based on molar fractions (molar fraction weighted average), as expressed by the following equation (2):

$$OP = \sum_{i=n} n_i OP_i = n_1 OP_1 + n_2 OP_2 + \cdots + n_n OP_n \quad (2)$$

wherein $OP_n$ represents the OP of component $a_n$, and $n_n$ represents the molar fraction of component $a_n$ in the entirety of component (a).

Thus, the OP of component (a) consisting of two or more polymerizable compounds is calculated as the molar fraction weighted average of the $N/(N_C - N_O)$ values of the respective polymerizable compounds.

To control the OP of component (a) in the range of 1.80 to 2.70, preferably, component (a) includes at least compound (a-1) having two or more cyclic structures, at least one of which is an aromatic or aromatic heterocyclic structure.

Compound (a-1): Polymerizable Compound Having Aromatic, Aromatic Heterocyclic, or Alicyclic Structure

Component (a) may include polymerizable compound (a-1) having an aromatic, aromatic heterocyclic, or alicyclic structure. Preferably, the proportion of polymerizable compound (a-1) in component (a) is 65% or more by mass. When the proportion of polymerizable compound (a-1) is 65% or more by mass, the OP can be reduced to 2.70 or less.

The cyclic structure may be an aromatic structure, an aromatic heterocyclic structure, or an alicyclic structure.

The aromatic structure preferably has 6 to 22 carbon atoms, more preferably 6 to 18 carbon atoms, still more preferably 6 to 10 carbon atoms. Specific examples of the aromatic structure include:
a benzene ring, a naphthalene ring, an anthracene ring, a phenanthrene ring, a phenalene ring, a fluorene ring, a benzocyclooctene ring, an acenaphthylene ring, a biphenylene ring, an indene ring, an indane ring, a triphenylene ring, a pyrene ring, a chrysene ring, a perylene ring, and a tetrahydronaphthalene ring.

Among these aromatic rings, a benzene or naphthalene ring is preferred, and a benzene ring is more preferred. The aromatic structure may have a combined structure of a plurality of aromatic rings, and examples include a biphenyl ring and bisphenyl rings.

The aromatic heterocyclic structure preferably has 1 to 12 carbon atoms, more preferably 1 to 6 carbon atoms, still more preferably 1 to 5 carbon atoms. Specific examples of the aromatic heterocyclic structure include:
a thiophene ring, a furan ring, a pyrrole ring, an imidazole ring, a pyrazole ring, a triazole ring, a tetrazole ring, a thiazole ring, a thiadiazole ring, an oxadiazole ring, an oxazole ring, a pyridine ring, a pyradine ring, a pyrimidine ring, a pyridazine ring, an isoindole ring, an indole ring, an indazole ring, a purine ring, a quinolizine ring, an isoquinoline ring, a quinoline ring, naphthyridine rings including a phthalazine ring, a quinoxaline ring, a quinazoline ring, and a cinnoline ring, a carbazole ring, an acridine ring, a phenazine ring, a phenothiazine ring, a phenoxathiin ring, and a phenoxazine ring.

The alicyclic structure preferably has 3 or more carbon atoms, more preferably 4 or more carbon atoms, still more

preferably 6 or more carbon atoms. The alicyclic structure preferably has 22 or fewer carbon atoms, more preferably 18 or fewer carbon atoms, still more preferably 6 or fewer carbon atoms, further preferably 5 or fewer carbon atoms. Specific examples of the alicyclic structure include:
a cyclopropane ring, a cyclobutane ring, a cyclobutene ring, a cyclopentane ring, a cyclohexane ring, a cyclohexene ring, a cycloheptane ring, a cyclooctane ring, a dicyclopentadiene ring, a spirodecane ring, a spirononane ring, tetrahydrodicyclopentadiene rings, octahydronaphthalene rings, decahydronaphthalene rings, hexahydroindane rings, a bornane ring, a norbornane ring, a norbornene ring, an isobornane ring, tricyclodecane rings, a tetracyclododecane ring, and an adamantane ring.

Specific examples of polymerizable compound (a-1) with a boiling point of 250°C or more include, but are not limited to:

3-phenoxybenzyl acrylate (mPhOBzA, OP: 2.54, boiling point: 367.4°C, 80°C vapor pressure: 0.0004 mmHg, molecular weight: 254.3):

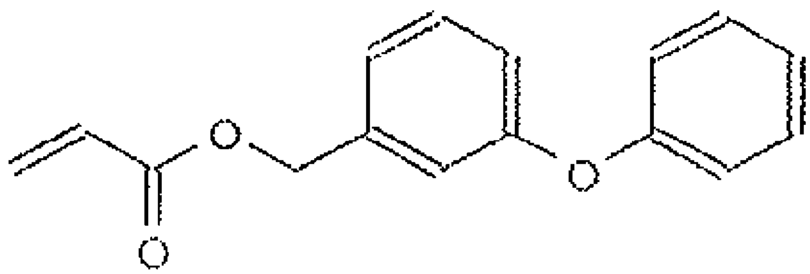

1-naphthyl acrylate (NaA, OP: 2.27, boiling point: 317°C, 80°C vapor pressure: 0.0422 mmHg, molecular weight: 198):

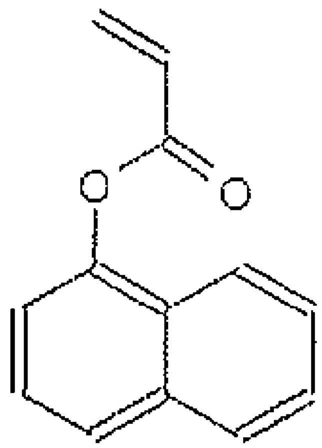

2-phenylphenoxyethyl acrylate (PhPhOEA, OP: 2.57, boiling point: 364.2°C, 80°C vapor pressure: 0.0006 mmHg, molecular weight: 268.3):

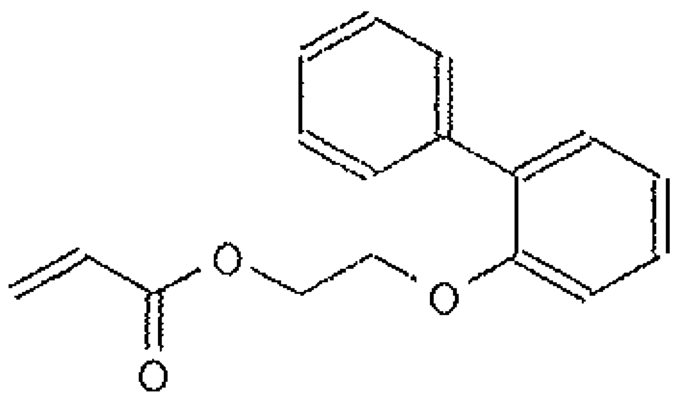

1-naphthylmethyl acrylate (Na1MA, OP: 2.33, boiling point: 342.1°C, 80°C vapor pressure: 0.042 mmHg, molecular weight: 212.2):

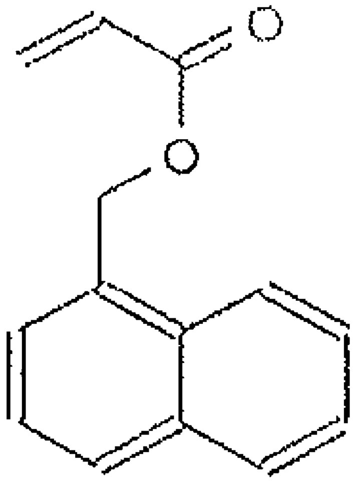

2-naphthylmethyl acrylate (Na2MA, OP: 2.33, boiling point: 342.1°C, 80°C vapor pressure: 0.042 mmHg, molecular weight: 212.2):

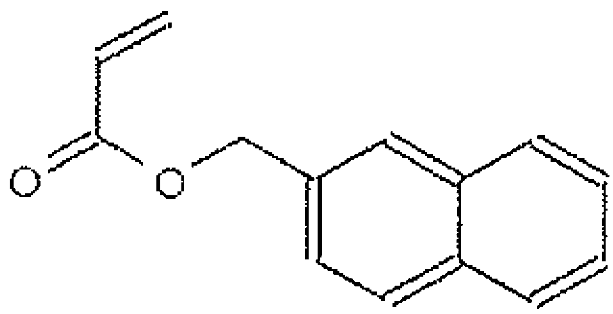

DPhPA (OP: 2.38, boiling point: 354.5°C, 80°C vapor pressure: 0.0022 mmHg, molecular weight: 266.3), represented by the following formula:

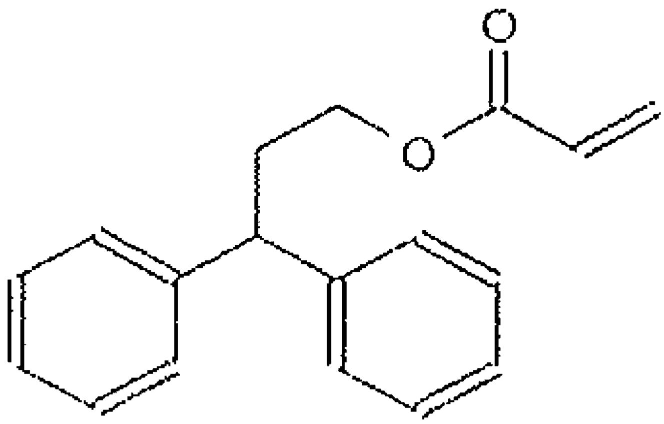

PhBzA (OP: 2.29, boiling point: 350.4°C, 80°C vapor pressure: 0.0022 mmHg, molecular weight: 238.3), represented by the following formula:

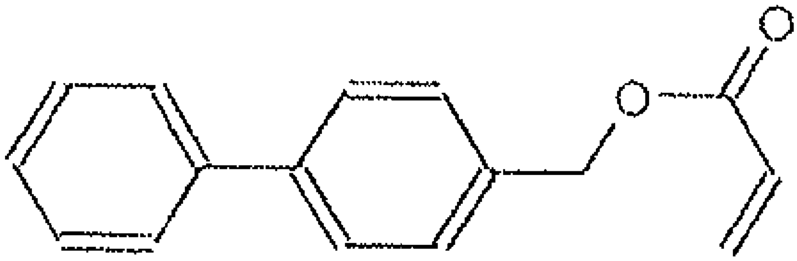

FLMA (OP: 2.20, boiling point: 349.3°C, 80°C vapor pressure: 0.0018 mmHg, molecular weight: 250.3), represented by the following formula:

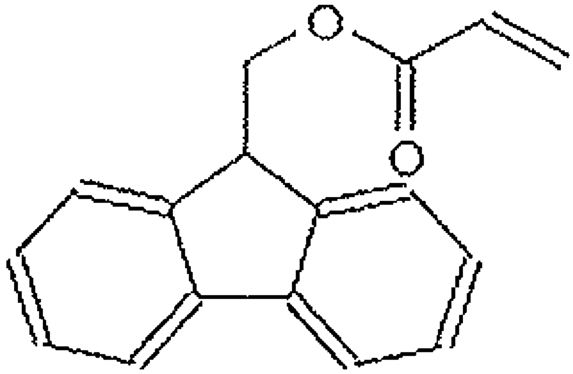

ATMA (OP: 2.13, boiling point: 414.9°C, 80°C vapor pressure: 0.0001 mmHg, molecular weight: 262.3), represented by the following formula:

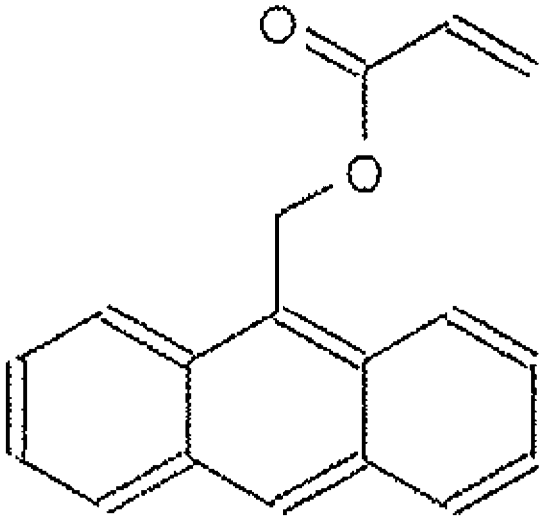

DNaMA (OP: 2.00, boiling point: 489.4°C, 80°C vapor pressure: < 0.0001 mmHg, molecular weight: 338.4), represented by the following formula:

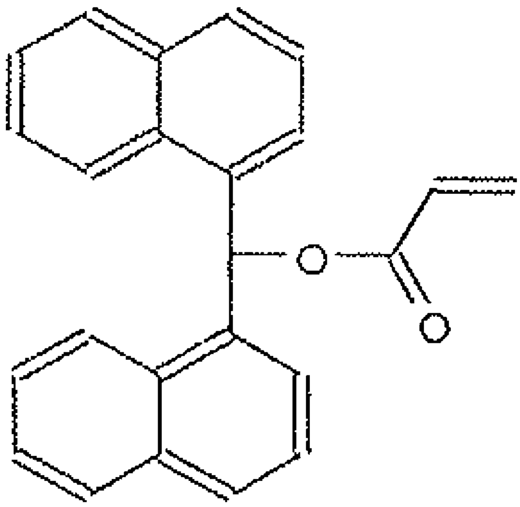

BPh44DA (OP: 2.63, boiling point: 444°C, 80°C vapor pressure: < 0.0001 mmHg, molecular weight: 322.3), represented by the following formula:

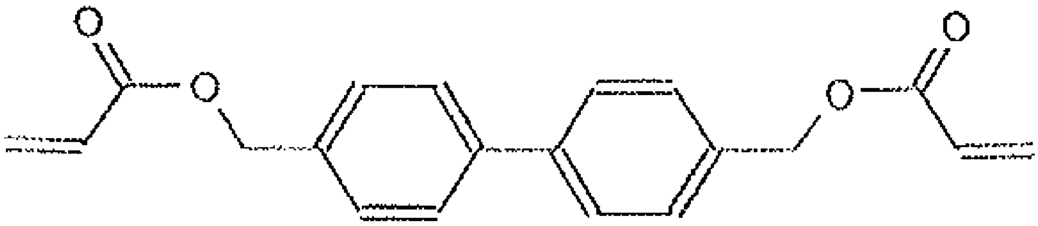

BPh43DA (OP: 2.63, boiling point: 439.5°C, 80°C vapor pressure: < 0.0001 mmHg, molecular weight: 322.3), represented by the following formula:

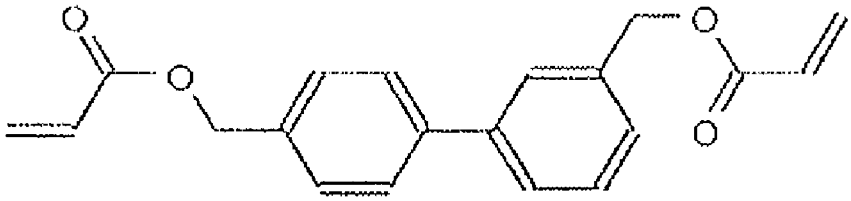

DPhEDA (OP: 2.63, boiling point: 410°C, 80°C vapor pressure: < 0.0001 mmHg, molecular weight: 322.3), represented by the following formula:

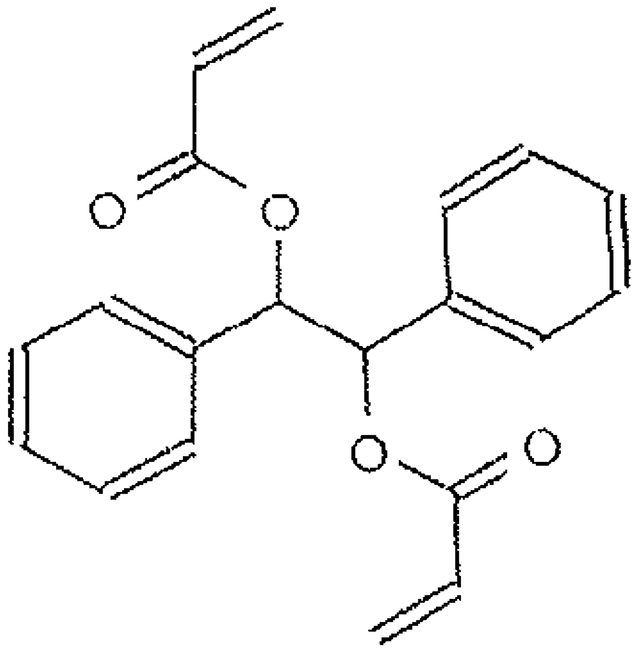

BPMDA (OP: 2.68, boiling point: 465.7°C, 80°C vapor pressure: < 0.0001 mmHg, molecular weight: 364.4), represented by the following formula:

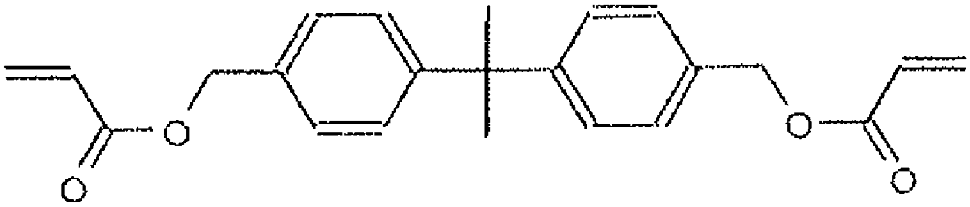

Na13MDA (OP: 2.71, boiling point: 438.8°C, 80°C vapor pressure: < 0.0001 mmHg, molecular weight: 296.3), represented by the following formula:

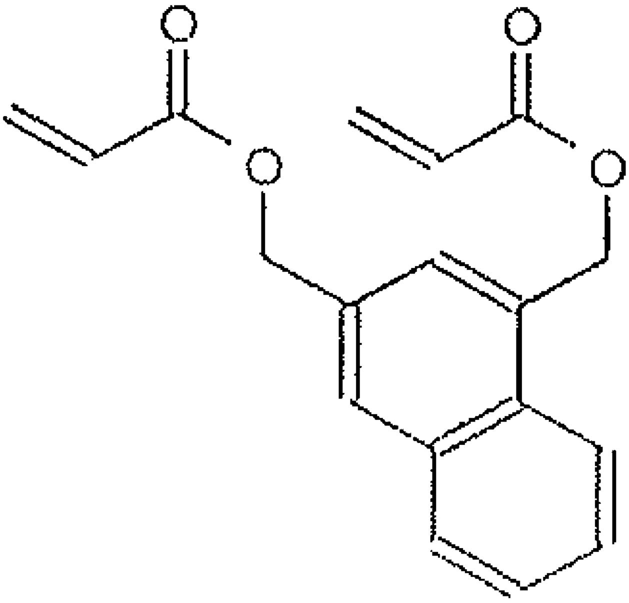

polymerizable compound (a-1-1) (OP: 2.40, boiling point: 333.4°C, 80°C vapor pressure: 0.0181 mmHg, molecular weight: 199.2), represented by the following formula:

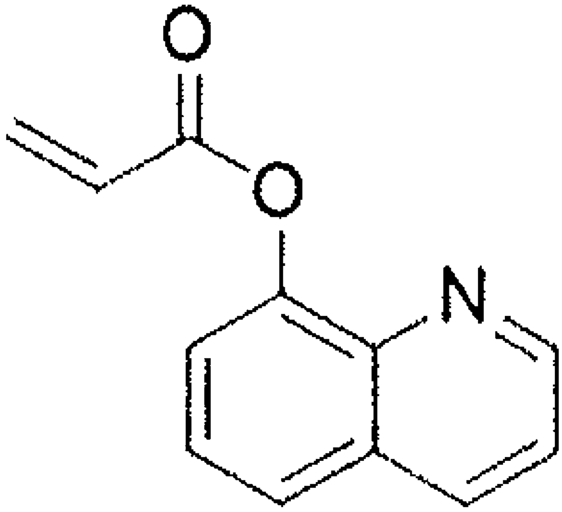

polymerizable compound (a-1-2) (OP: 2.40, boiling point: 333.4°C, 80°C vapor pressure: 0.0181 mmHg, molecular weight: 199.2), represented by the following formula:

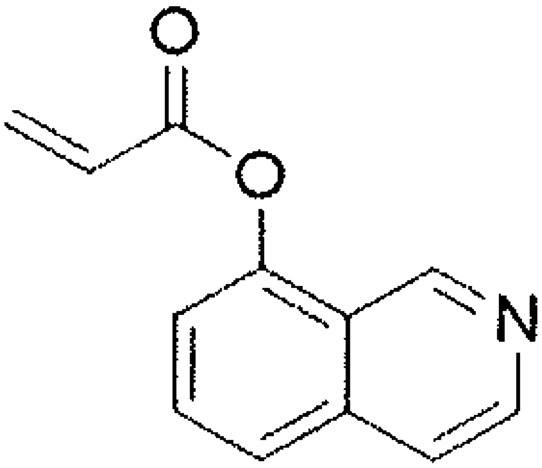

polymerizable compound (a-1-3) (OP: 1.86, boiling point: 369.5°C, 80°C vapor pressure: 0.0053 mmHg, molecular weight: 193.3), represented by the following formula:

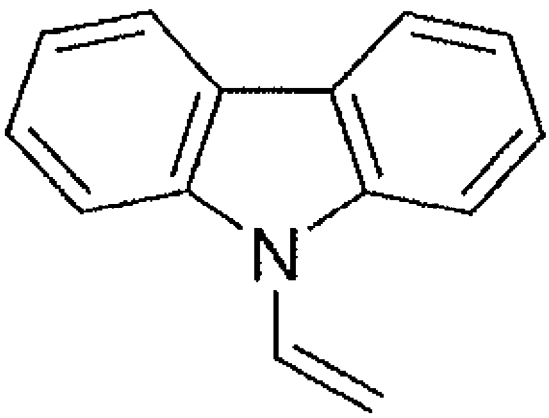

polymerizable compound (a-1-4) (OP: 2.85, boiling point: 438.8°C, 80°C vapor pressure: < 0.0001 mmHg, molecular weight: 296.3), represented by the following formula:

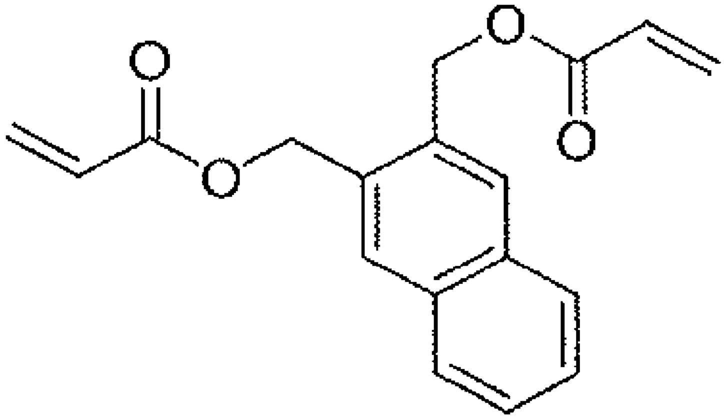

polymerizable compound (a-1-5) (OP: 2.71, boiling point: 438.8°C, 80°C vapor pressure: < 0.0001 mmHg, molecular weight: 296.3), represented by the following formula:

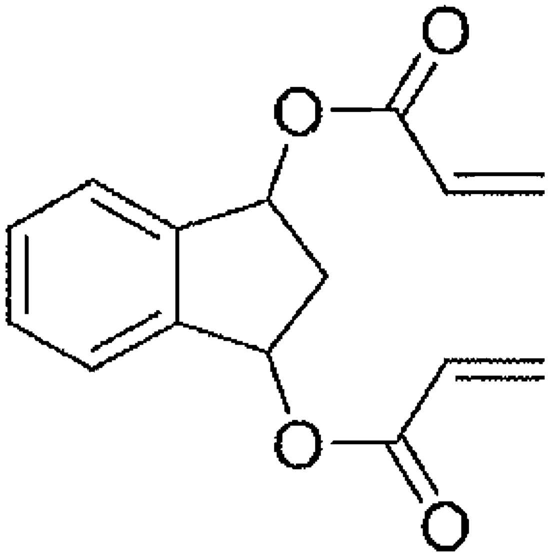

polymerizable compound (a-1-6) (OP: 2.87, boiling point: 421.0°C, 80°C vapor pressure: < 0.0001 mmHg, molecular weight: 338.4), represented by the following formula:

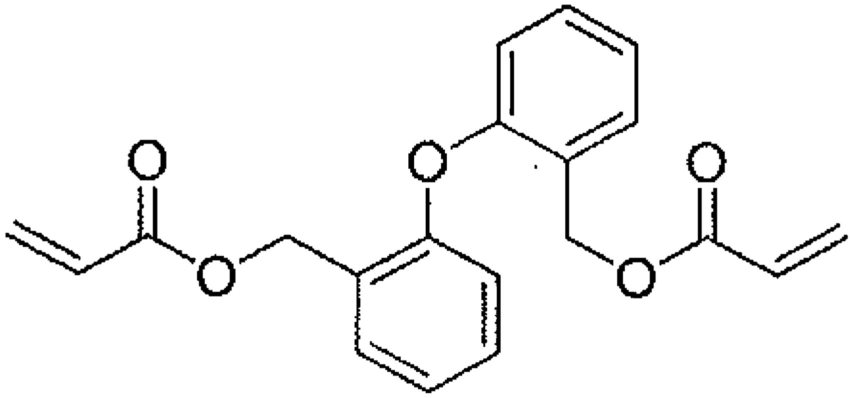

polymerizable compound (a-1-7) (OP: 2.87, boiling point: 465.2°C, 80°C vapor pressure: < 0.0001 mmHg, molecular weight: 338.4), represented by the following formula:

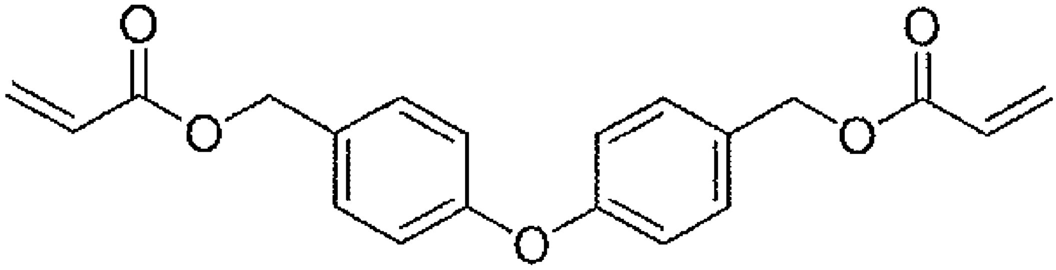

polymerizable compound (a-1-8) (OP: 2.68, boiling point: 465.7°C, 80°C vapor pressure: < 0.0001 mmHg, molecular weight: 364.4), represented by the following formula:

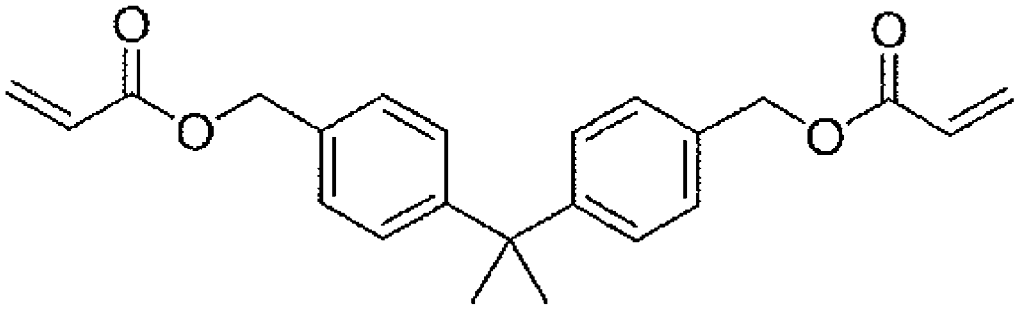

polymerizable compound (a-1-9) (OP: 2.50, boiling point: 433.1°C, 80°C vapor pressure: < 0.0001 mmHg, molecular weight: 320.3), represented by the following formula:

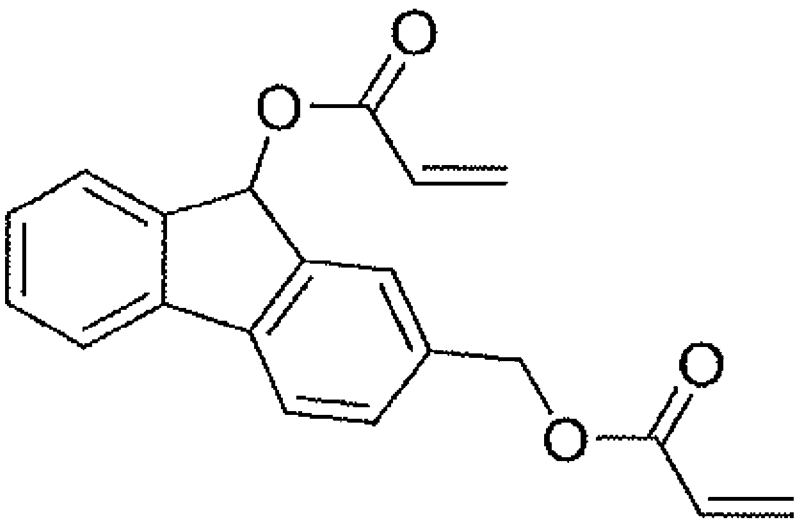

polymerizable compound (a-1-10) (OP: 2.64, boiling point: 468.1°C, 80°C vapor pressure: < 0.0001 mmHg, molecular weight: 326.4), represented by the following formula:

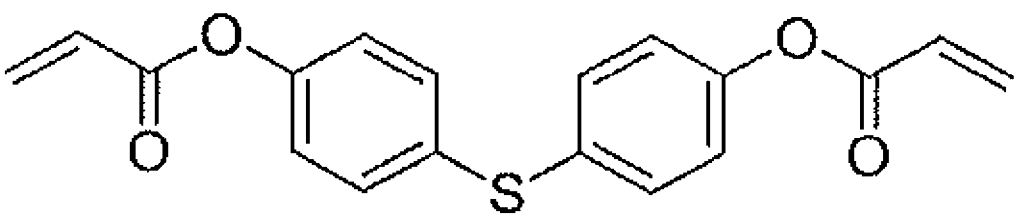

polymerizable compound (a-1-11) (OP: 3.25, boiling point: 553.4°C, 80°C vapor pressure: < 0.0001 mmHg, molecular weight: 358.4), represented by the following formula:

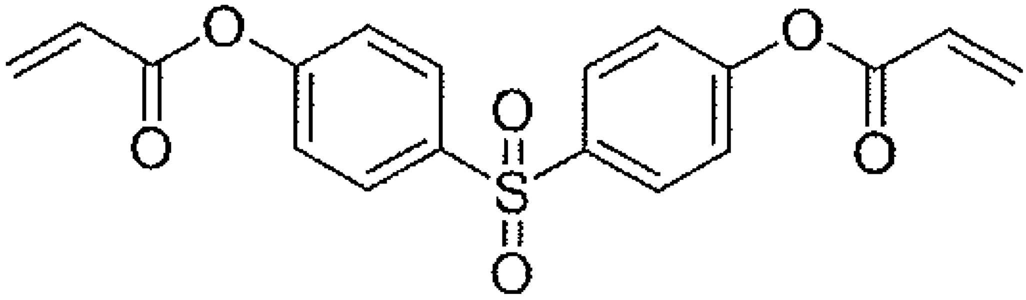

polymerizable compound (a-1-12) (OP: 2.63, boiling point: 443.9°C, 80°C vapor pressure: < 0.0001 mmHg, molecular weight: 322.4), represented by the following formula:

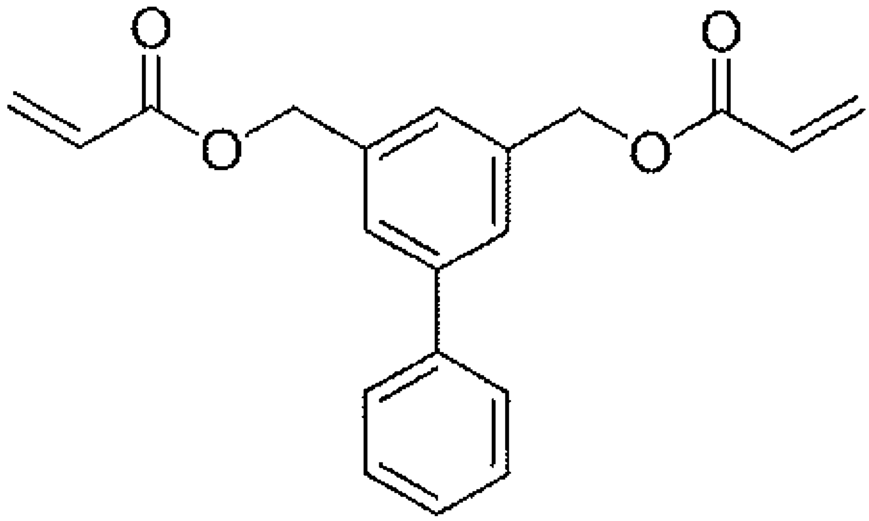

polymerizable compound (a-1-13) (OP: 2.89, boiling point: 509.3°C, 80°C vapor pressure: < 0.0001 mmHg, molecular weight: 406.4), represented by the following formula:

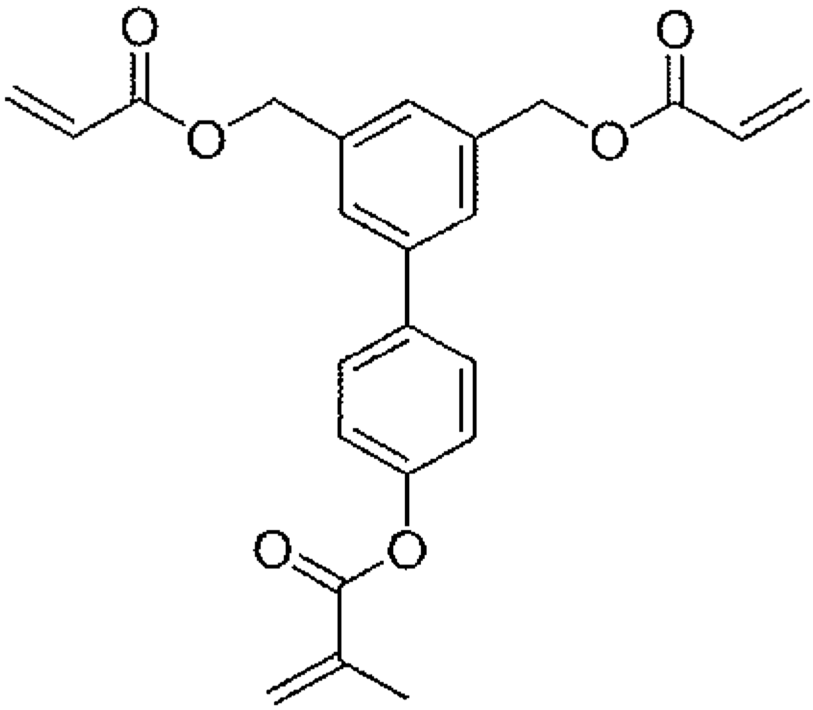

polymerizable compound (a-1-14) (OP: 2.63, boiling point: 450.0°C, 80°C vapor pressure: < 0.0001 mmHg, molecular weight: 322.4), represented by the following formula:

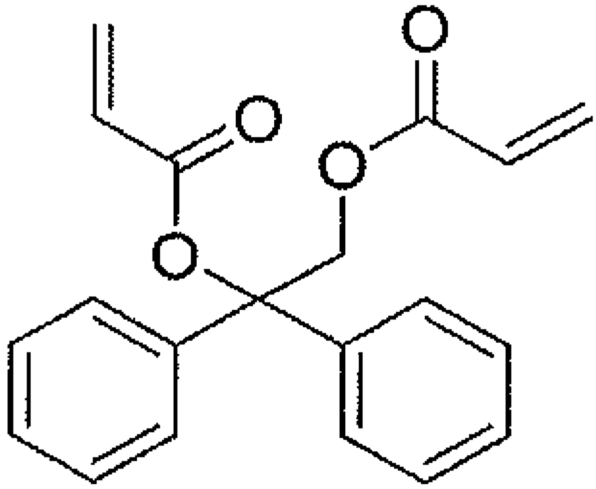

polymerizable compound (a-1-15) (OP: 3.00, boiling point: 476.5°C, 80°C vapor pressure: < 0.0001 mmHg, molecular weight: 366.4), represented by the following formula:

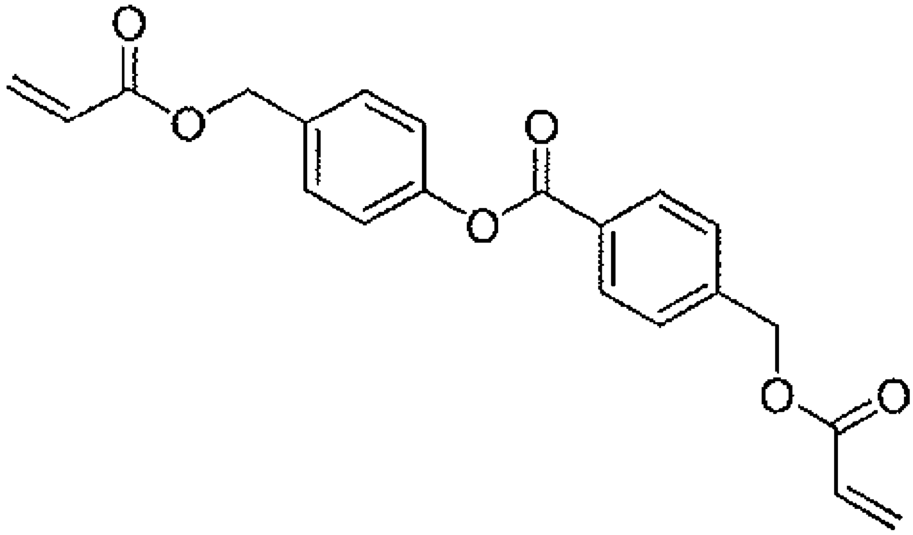

polymerizable compound (a-1-16) (OP: 2.68, boiling point: 447.4°C, 80°C vapor pressure: < 0.0001 mmHg, molecular weight: 364.4), represented by the following formula:

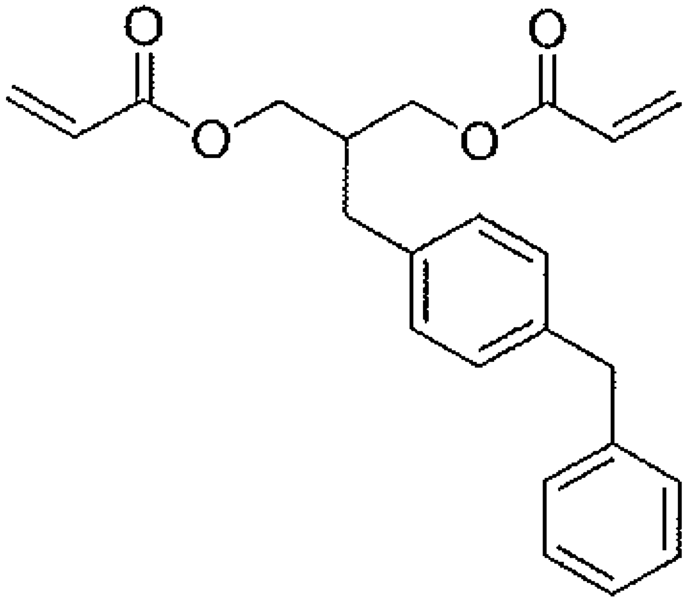

polymerizable compound (a-1-17) (OP: 2.36, boiling point: 543.8°C, 80°C vapor pressure: < 0.0001 mmHg, molecular weight: 398.5), represented by the following formula:

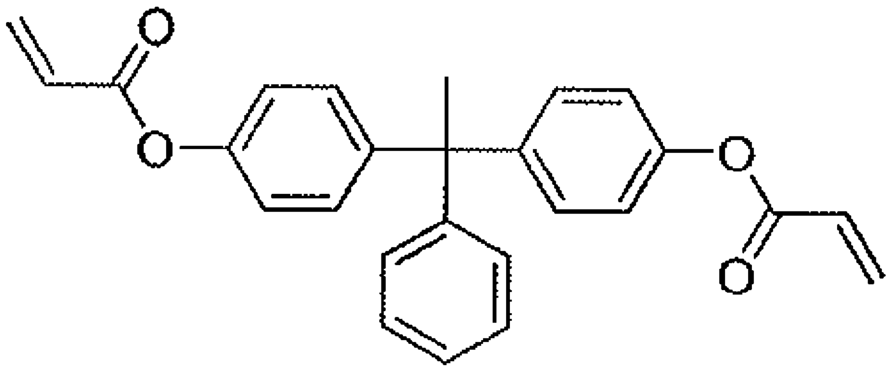

polymerizable compound (a-1-18) (OP: 3.27, boiling point: 526.9°C, 80°C vapor pressure: < 0.0001 mmHg, molecular weight: 396.4), represented by the following formula:

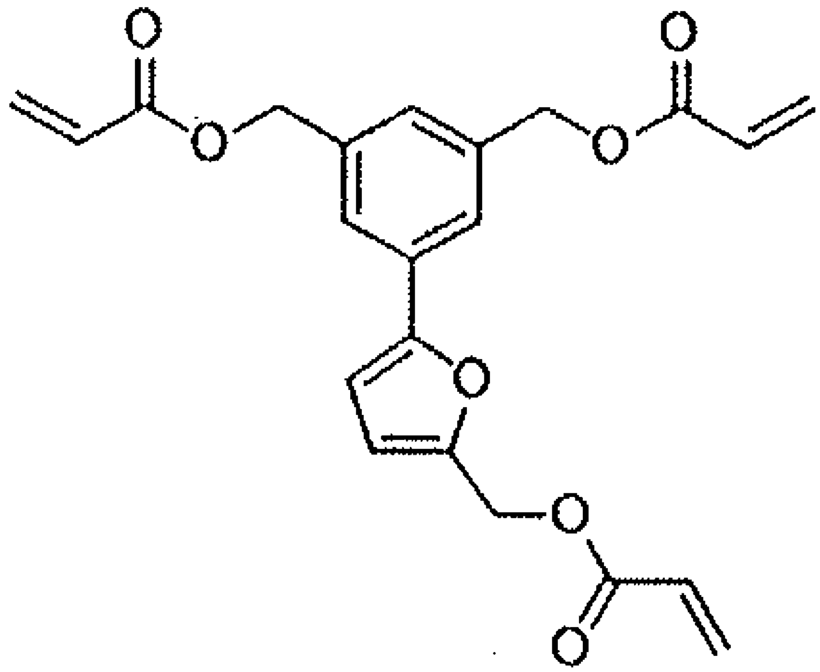

polymerizable compound (a-1-19) (OP: 2.71, boiling point: 333.7°C, 80°C vapor pressure: 0.0302 mmHg, molecular weight: 244.3), represented by the following formula:

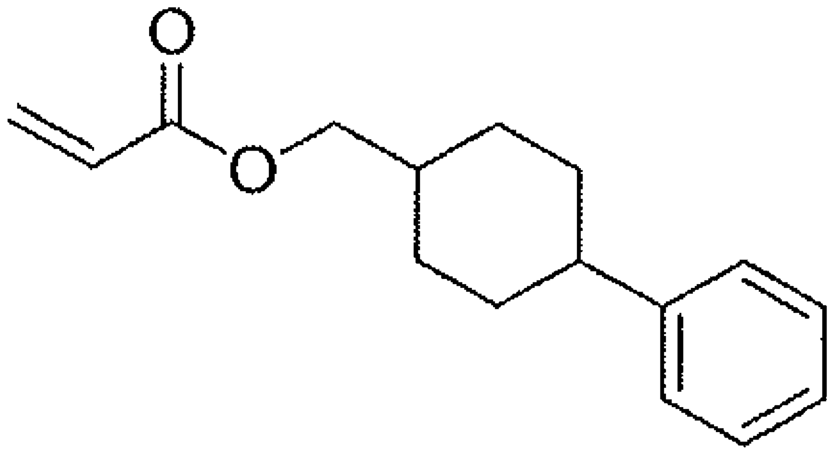

polymerizable compound (a-1-20) (OP: 2.73, boiling point: 333.7°C, 80°C vapor pressure: 0.0134 mmHg, molecular weight: 258.3), represented by the following formula:

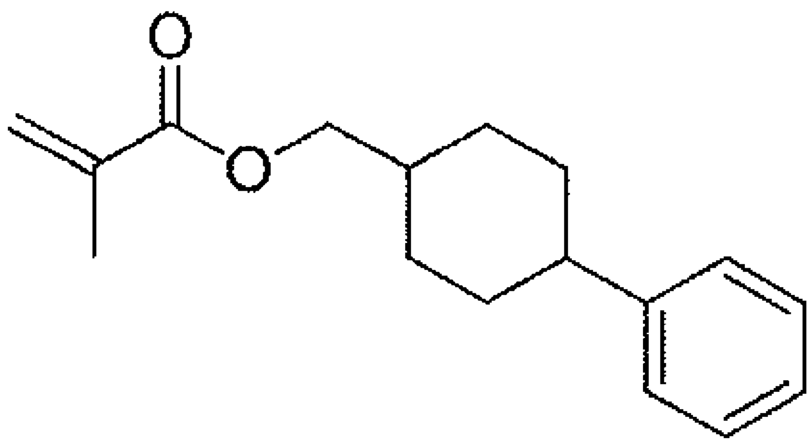

polymerizable compound (a-1-21) (OP: 2.71, boiling point: 319.2°C, 80°C vapor pressure: 0.0566 mmHg, molecular weight: 262.3), represented by the following formula:

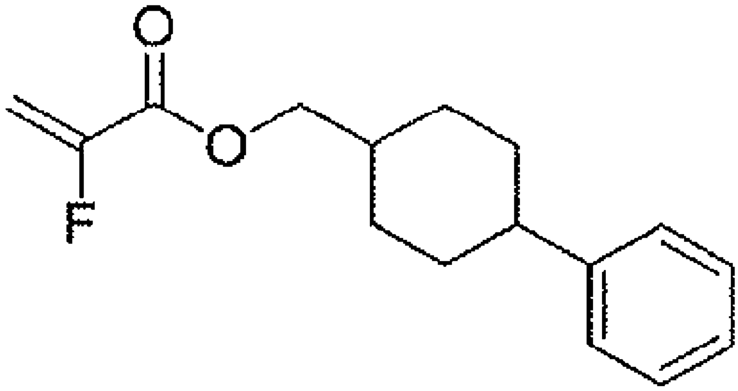

polymerizable compound (a-1-22) (OP: 2.71, boiling point: 336.9°C, 80°C vapor pressure: 0.0055 mmHg, molecular weight: 244.3), represented by the following formula:

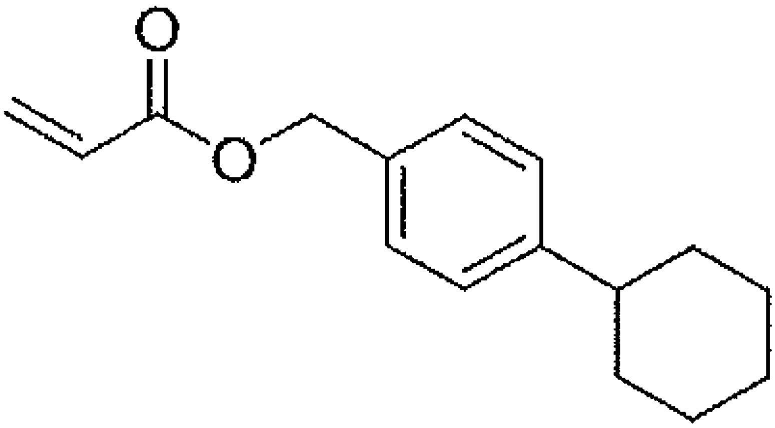

polymerizable compound (a-1-23) (OP: 3.00, boiling point: 370.9°C, 80°C vapor pressure: 0.0021 mmHg, molecular weight: 274.4), represented by the following formula:

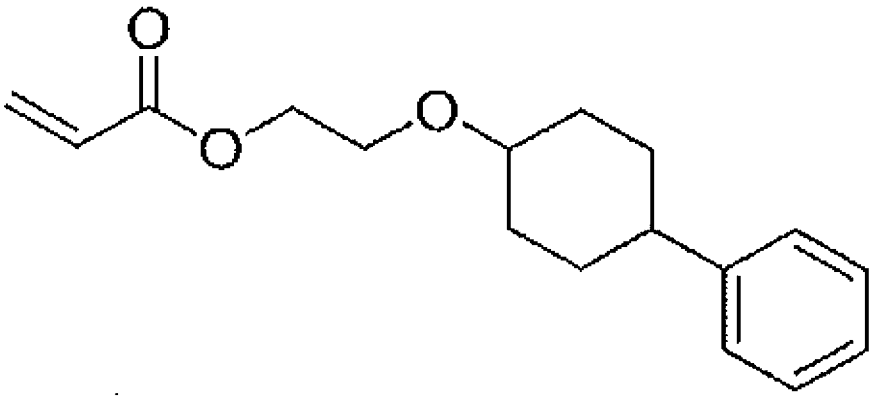

polymerizable compound (a-1-24) (OP: 3.00, boiling point: 376.4°C, 80°C vapor pressure: 0.0005 mmHg, molecular weight: 274.4), represented by the following formula:

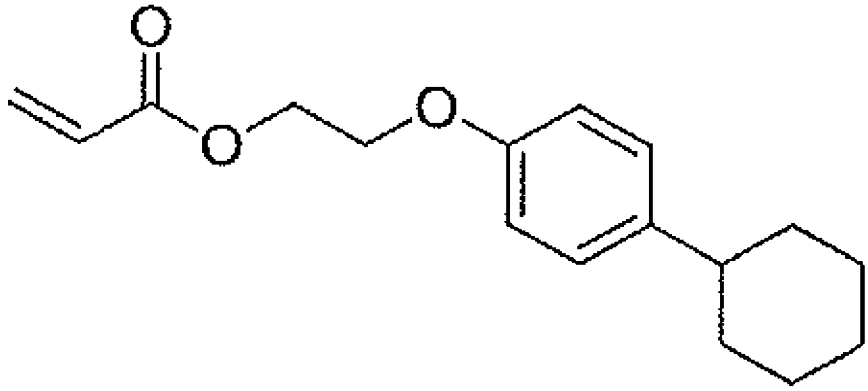

polymerizable compound (a-1-25) (OP: 3.00, boiling point: 379.4°C, 80°C vapor pressure: 0.0002 mmHg, molecular weight: 288.4), represented by the following formula:

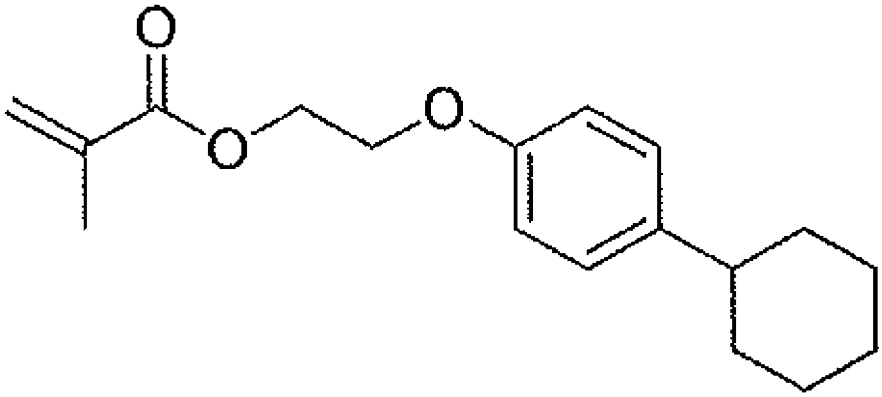

polymerizable compound (a-1-26) (OP: 2.33, boiling point: 360.8°C, 80°C vapor pressure: 0.0006 mmHg, molecular weight: 252.3), represented by the following formula:

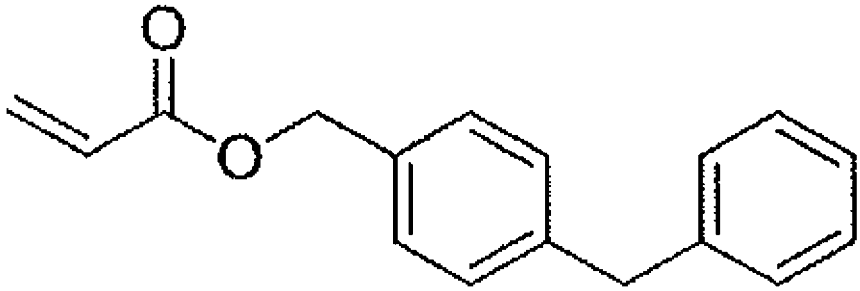

polymerizable compound (a-1-27) (OP: 2.54, boiling point: 371.5°C, 80°C vapor pressure: 0.0003 mmHg, molecular weight: 254.3), represented by the following formula:

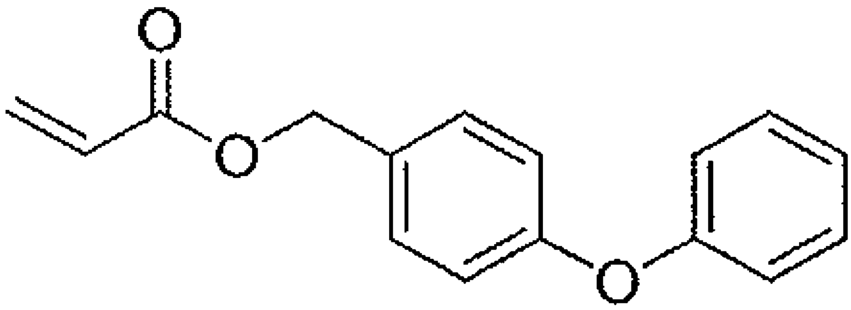

polymerizable compound (a-1-28) (OP: 2.57, boiling point: 381.2°C, 80°C vapor pressure: 0.0001 mmHg, molecular weight: 268.3), represented by the following formula:

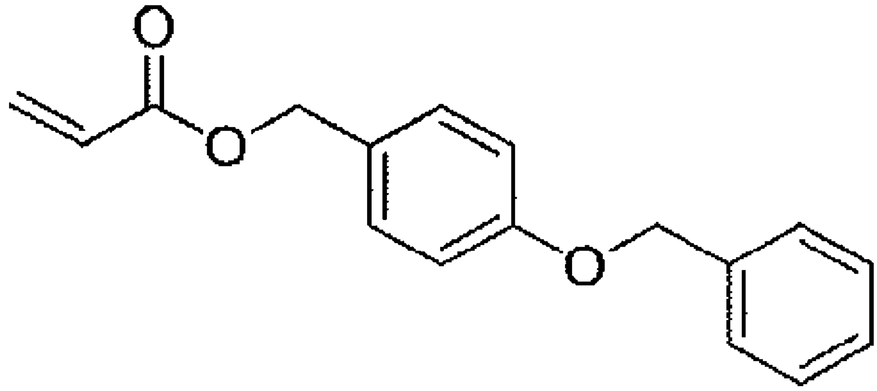

polymerizable compound (a-1-29) (OP: 2.57, boiling point: 381.8°C, 80°C vapor pressure: 0.0004 mmHg, molecular weight: 268.3), represented by the following formula:

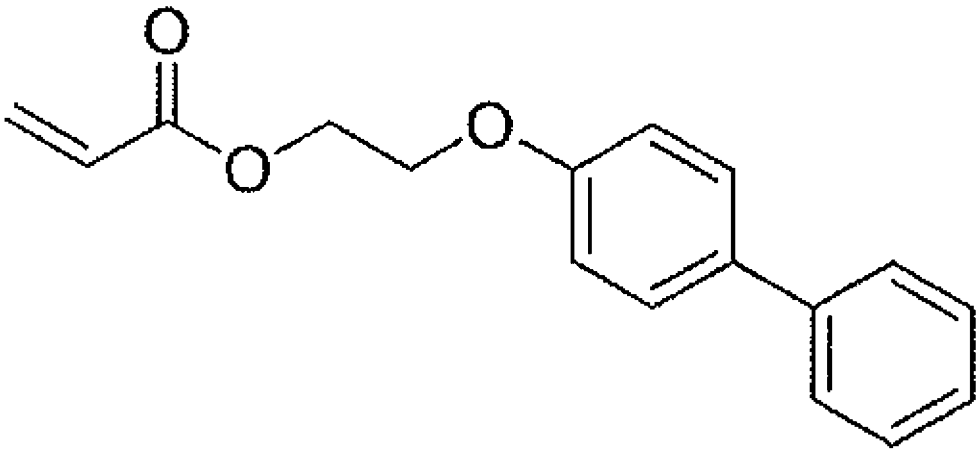

polymerizable compound (a-1-30) (OP: 2.50, boiling point: 487.4°C, 80°C vapor pressure: < 0.0001 mmHg, molecular weight: 374.4), represented by the following formula:

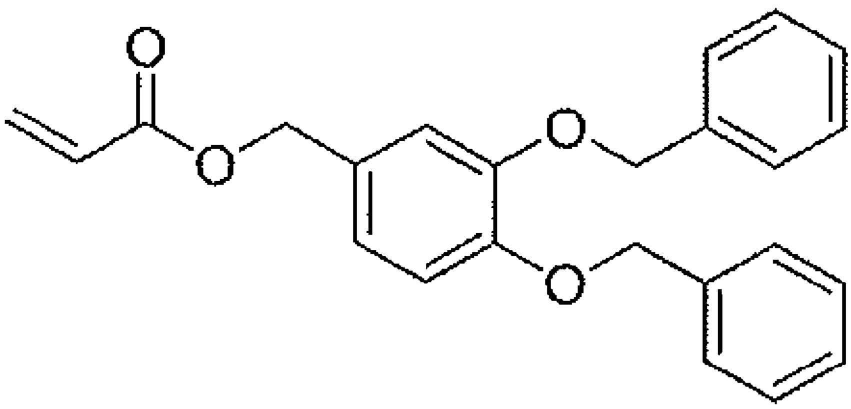

polymerizable compound (a-1-31) (OP: 2.67, boiling point: 417.2°C, 80°C vapor pressure: < 0.0001 mmHg, molecular weight: 268.3), represented by the following formula:

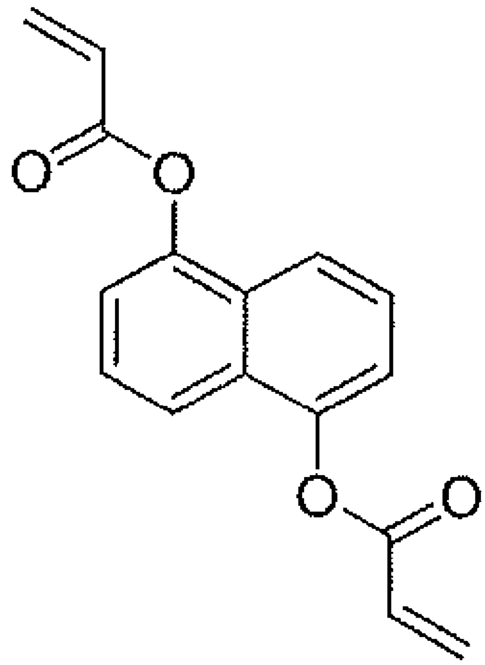

polymerizable compound (a-1-32) (OP: 2.67, boiling point: 417.2°C, 80°C vapor pressure: < 0.0001 mmHg, molecular weight: 268.3), represented by the following formula:

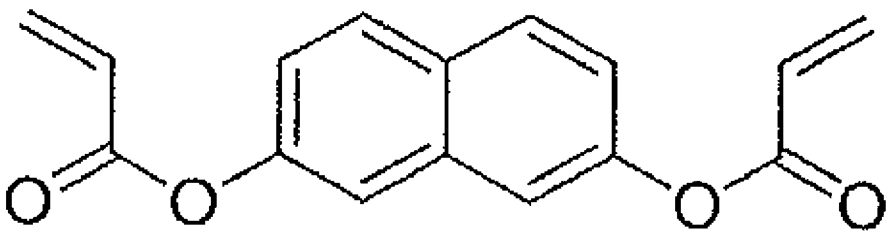

polymerizable compound (a-1-33) (OP: 2.67, boiling point: 417.2°C, 80°C vapor pressure: < 0.0001 mmHg, molecular weight: 268.3), represented by the following formula:

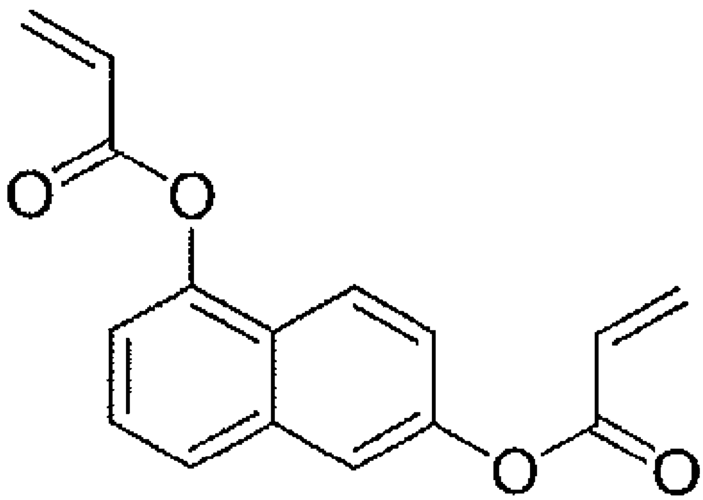

polymerizable compound (a-1-34) (OP: 2.67, boiling point: 417.2°C, 80°C vapor pressure: < 0.0001 mmHg, molecular weight: 268.3), represented by the following formula:

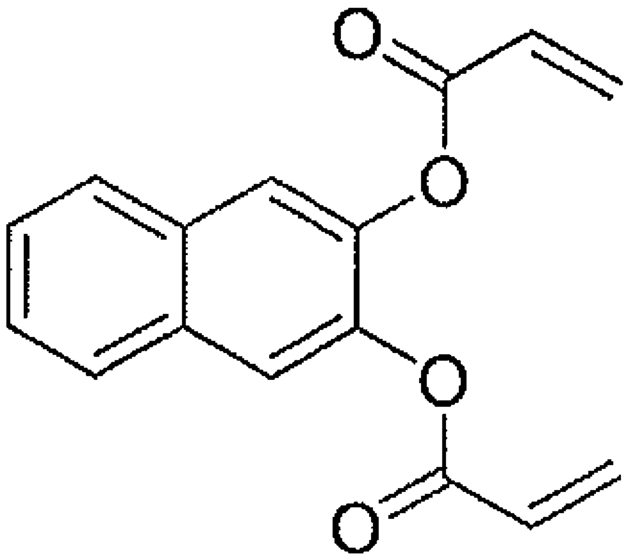

polymerizable compound (a-1-35) (OP: 2.71, boiling point: 438.8°C, 80°C vapor pressure: < 0.0001 mmHg, molecular weight: 296.3), represented by the following formula:

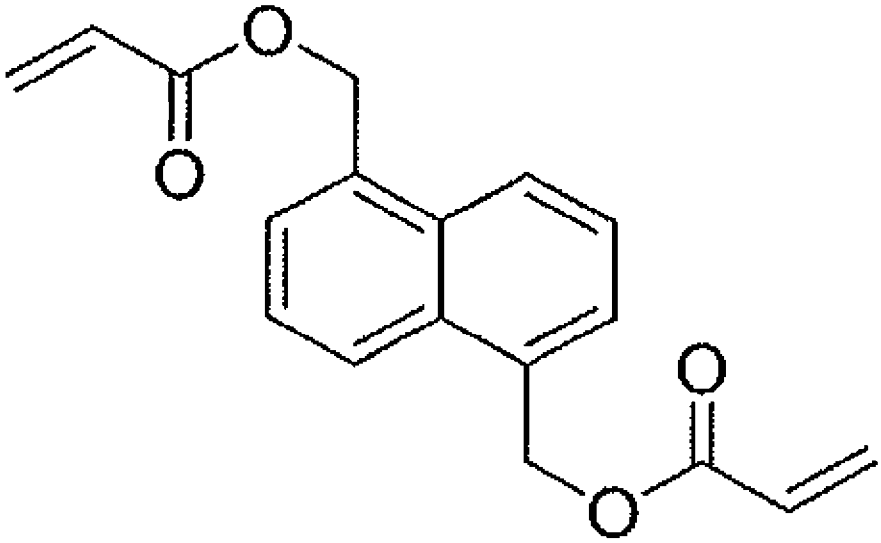

mXDA (OP: 3.20, boiling point: 335.9°C, 80°C vapor pressure: 0.0043 mmHg, molecular weight: 246.26, 23°C viscosity: 13 mPa·s), represented by the following formula:

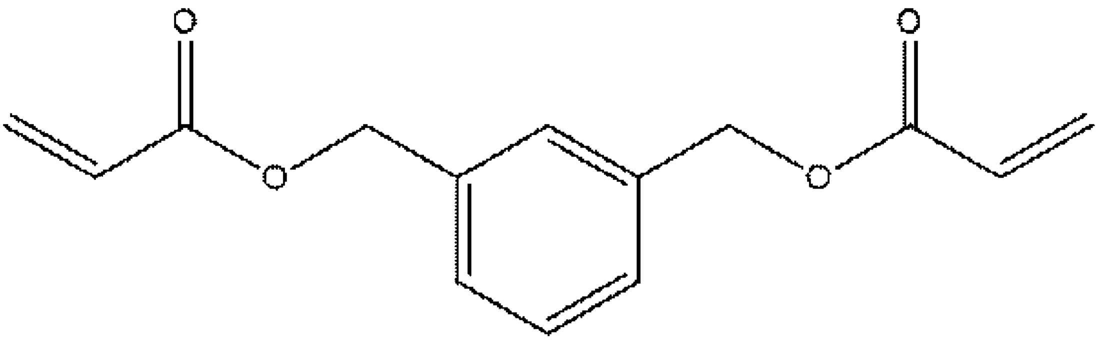

PhEDA (OP: 3.20, boiling point: 327.8°C, 80°C vapor pressure: 0.0057 mmHg, molecular weight: 246.26, 23°C viscosity: 23 mPa·s), represented by the following formula:

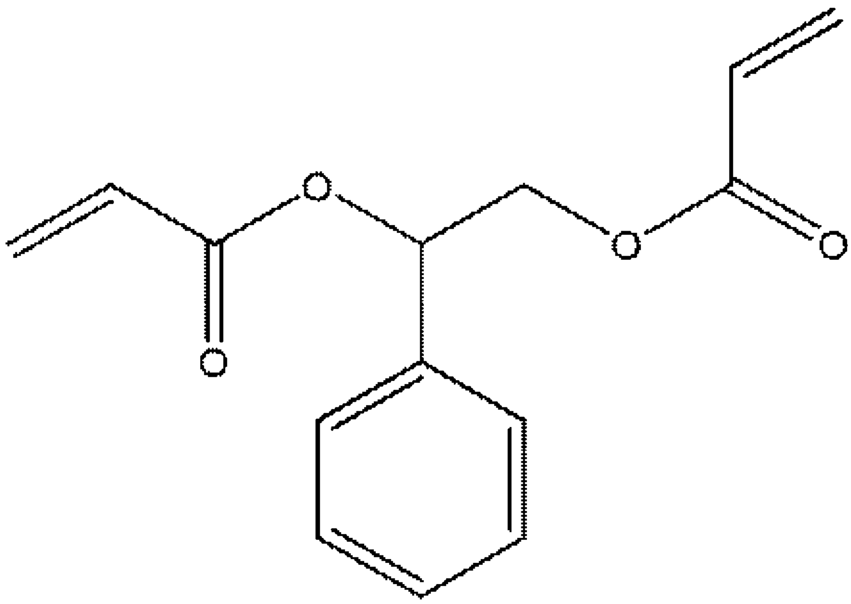

PhPDA (OP: 3.18, boiling point: 339.7°C, 80°C vapor pressure: 0.0017 mmHg, molecular weight: 260.29, 23°C viscosity: 38 mPa·s), represented by the following formula:

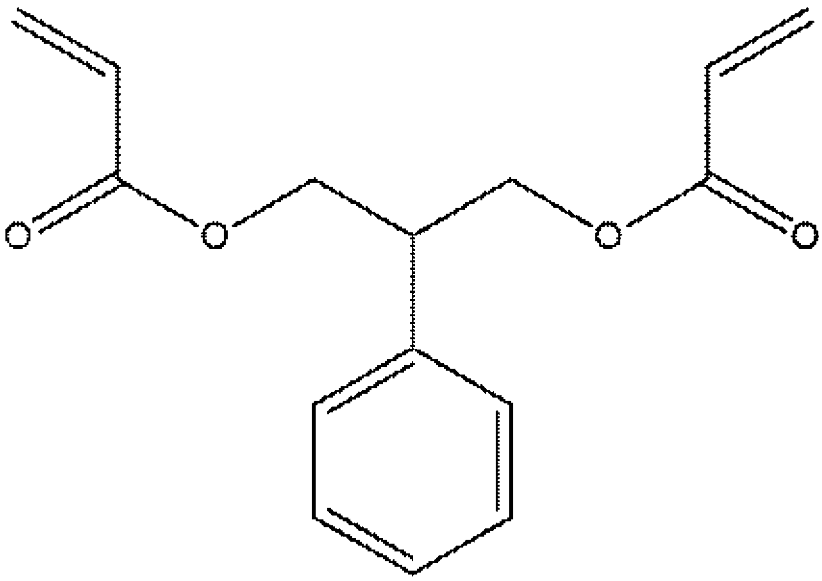

Na26MDA (OP: 2.71, boiling point: * °C, 80°C vapor pressure: * mmHg, molecular weight: 296.32, 23°C viscosity: 117 mPa·s), represented by the following formula:

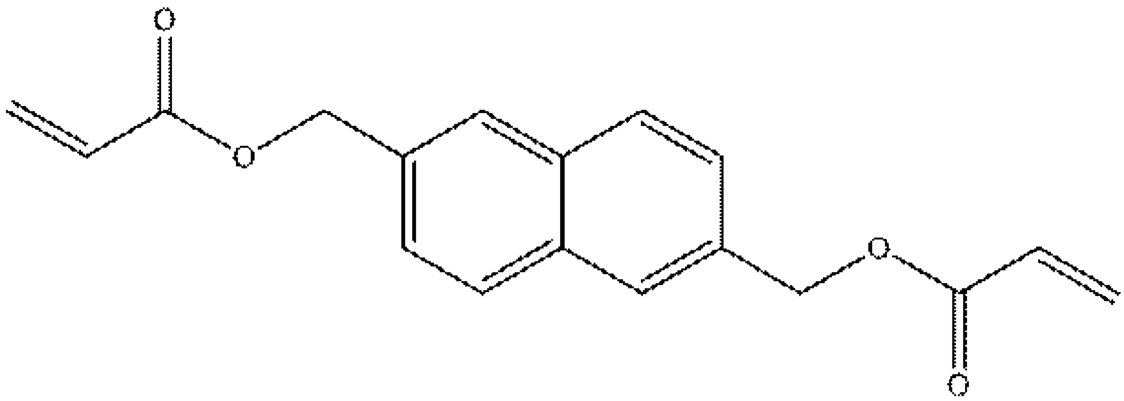

TMD47DA (OP: 3.38, boiling point: 365.4°C, 80°C vapor pressure: 0.0035 mmHg, molecular weight: 334.4, 23°C viscosity: 20 mPa·s), represented by the following formula:

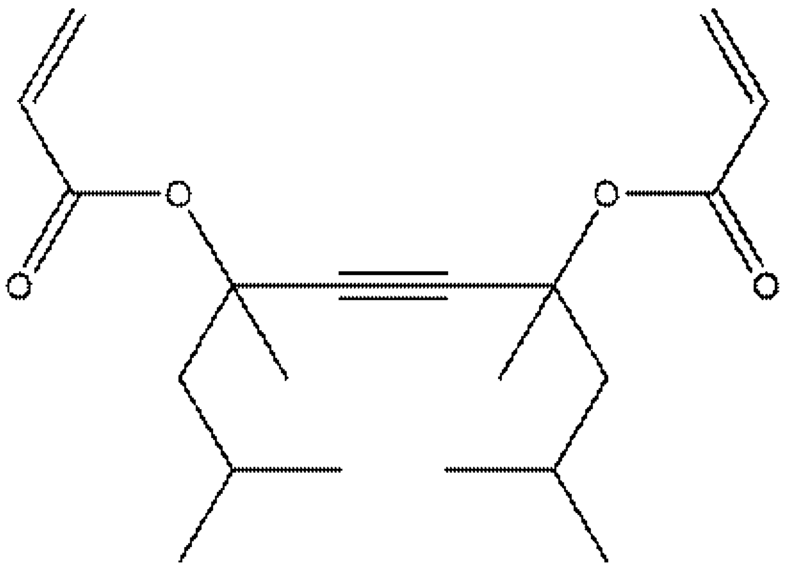

NDODA (OP: 3.91, boiling point: 322.2°C, 80°C vapor pressure: 0.0174 mmHg, molecular weight: 268.35, 23°C viscosity: 8 mPa·s), represented by the following formula:

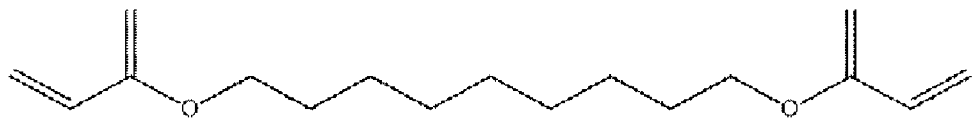

DDODA (OP: 3.83, boiling point: 338.5°C, 80°C vapor pressure: 0.00067 mmHg, molecular weight: 282.38, 23°C viscosity: 9 mPa·s), represented by the following formula:

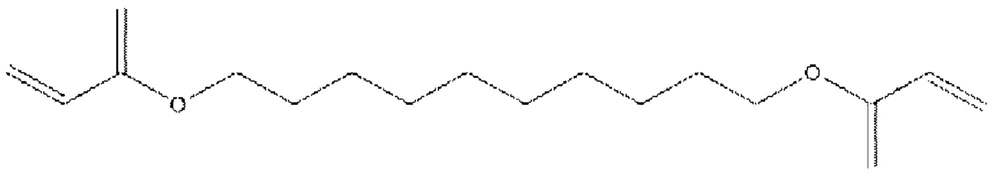

DA1 (molecular weight: 258.27) represented by the following formula:

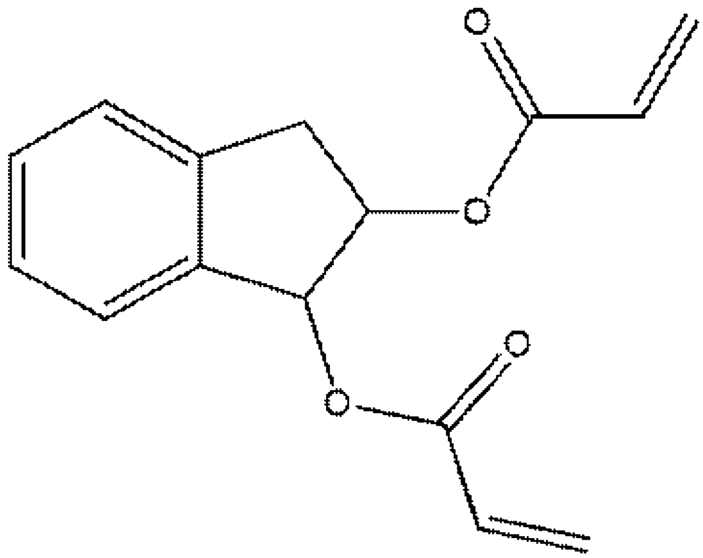

DA2 (molecular weight: 268.35) represented by the following formula:

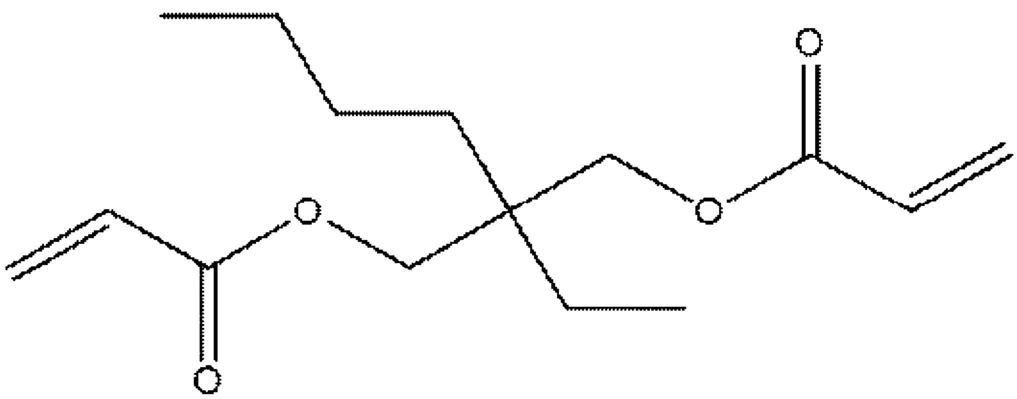

DA3 (molecular weight: 252.31) represented by the following formula:

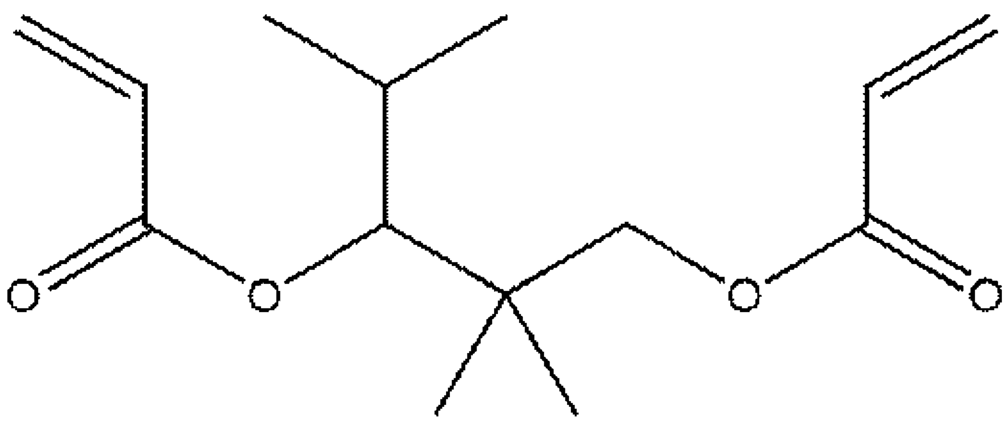

DA4 (molecular weight: 250.29) represented by the following formula:

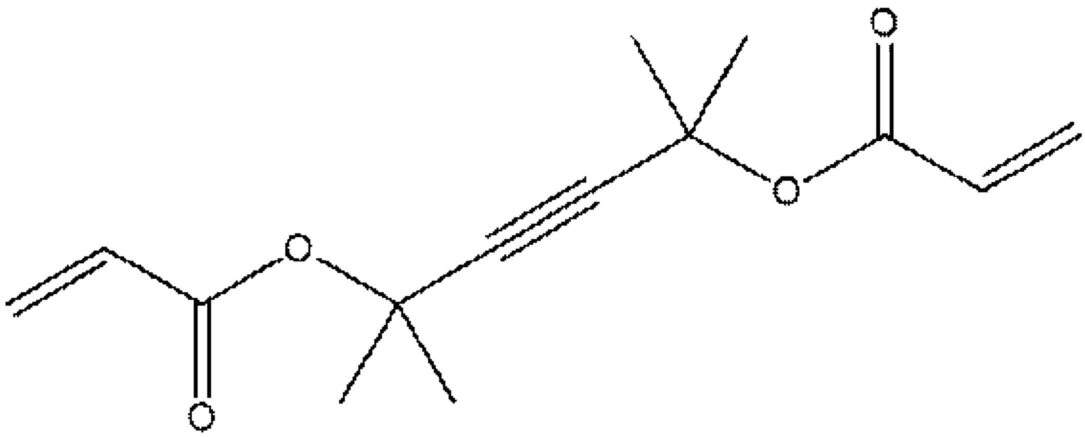

DA5 (molecular weight: 262.31) represented by the following formula:

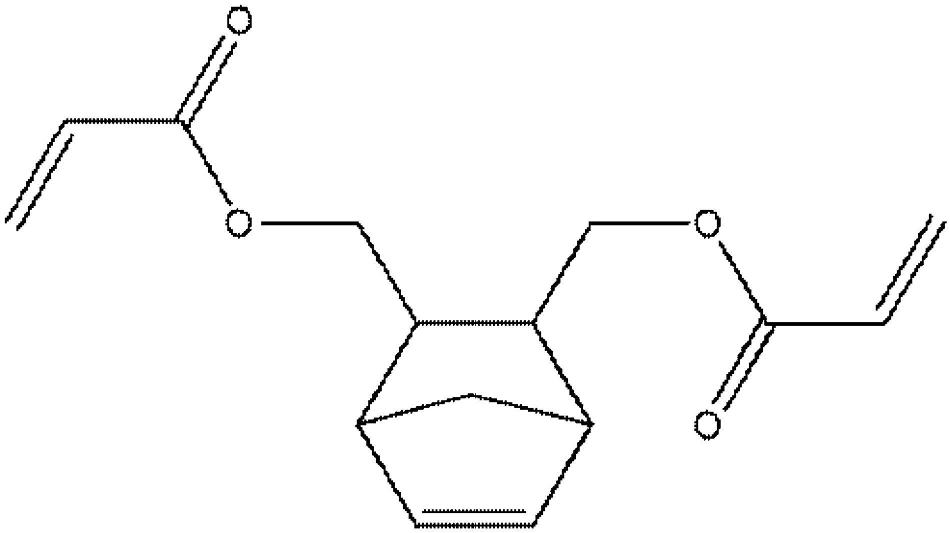

DA6 (molecular weight: 252.31) represented by the following formula:

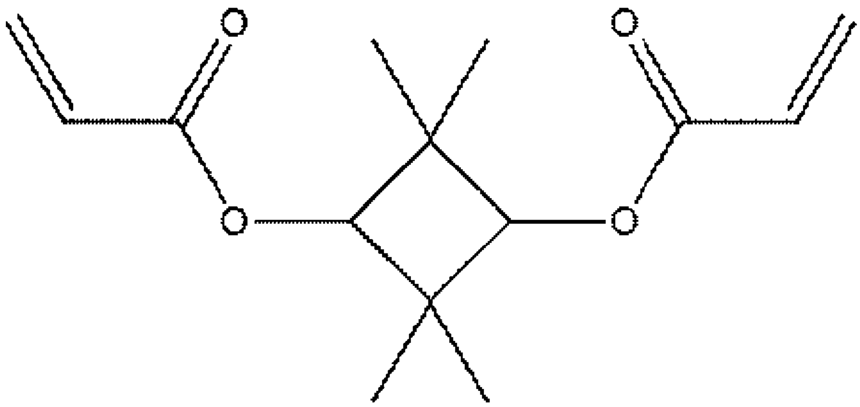

DA7 (molecular weight: 252.31) represented by the following formula:

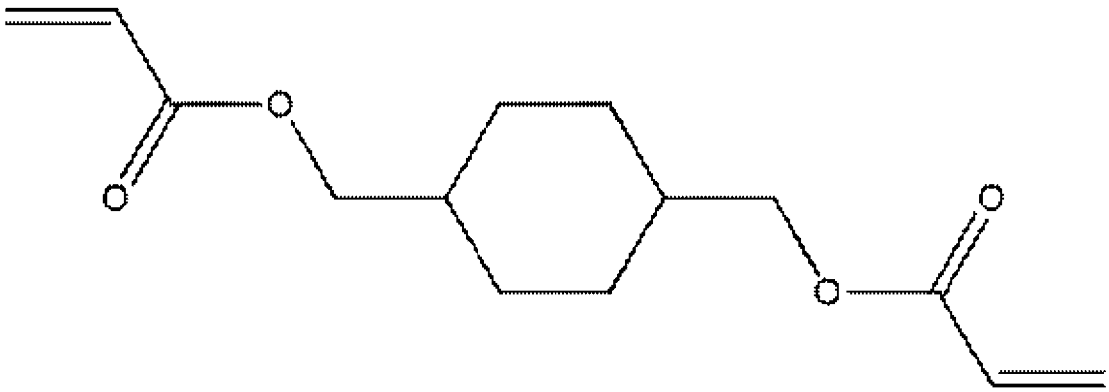

DA8 (molecular weight: 252.31) represented by the following formula:

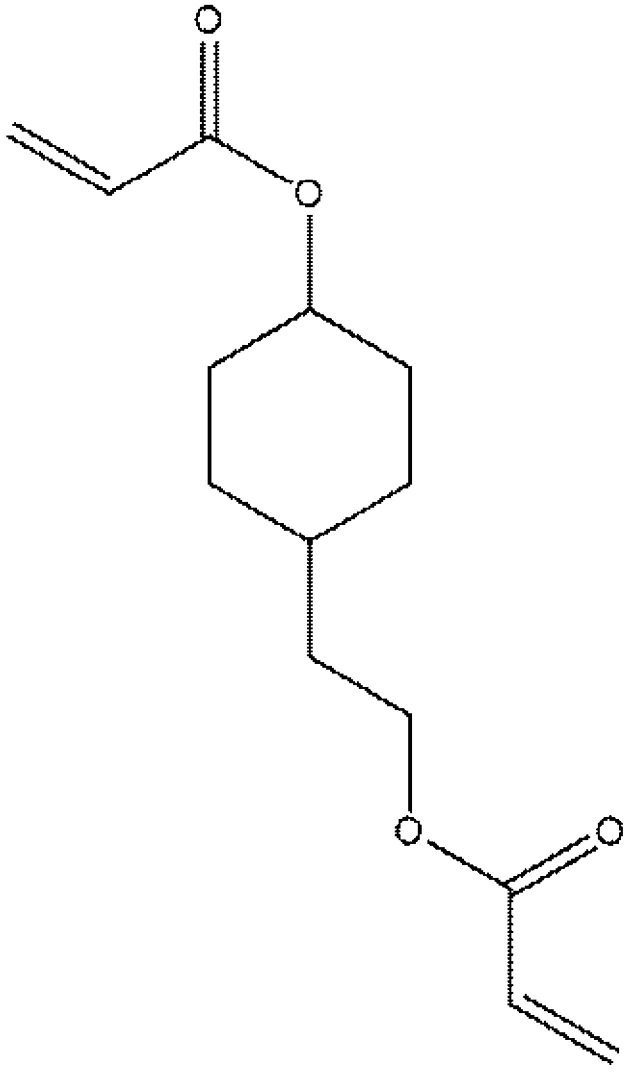

DA9 (molecular weight: 304.39) represented by the following formula:

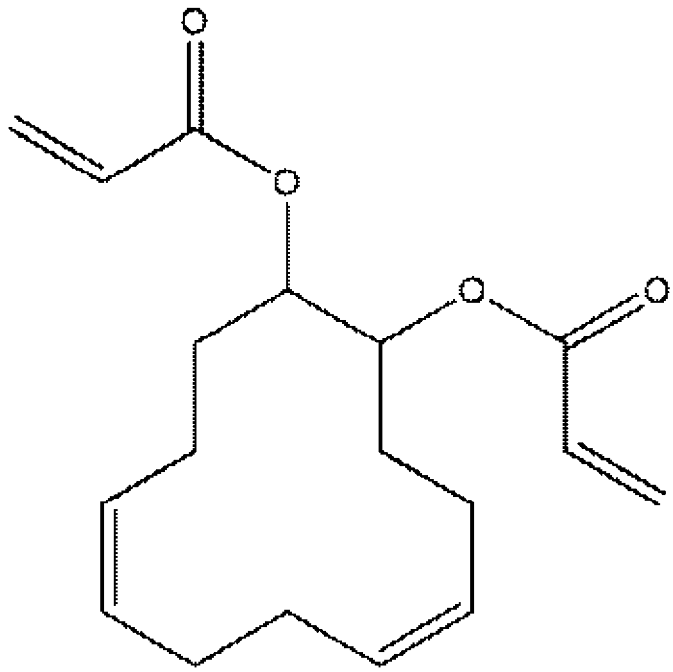

MA1 (molecular weight: 236.27) represented by the following formula:

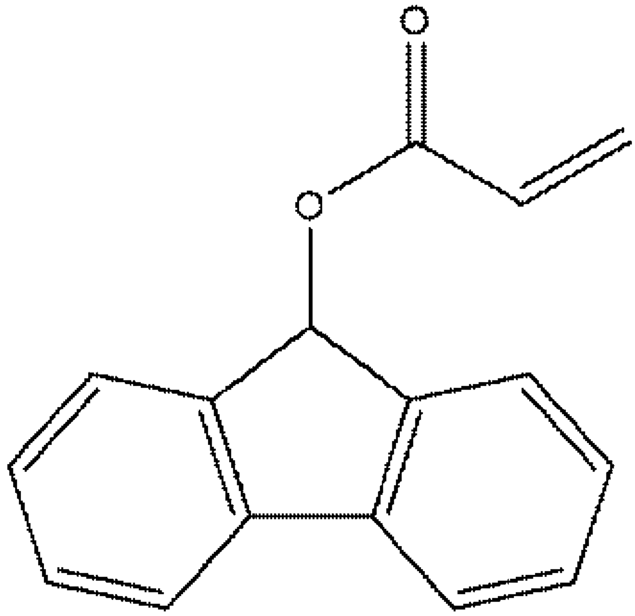

MA2 (molecular weight: 238.29) represented by the following formula:

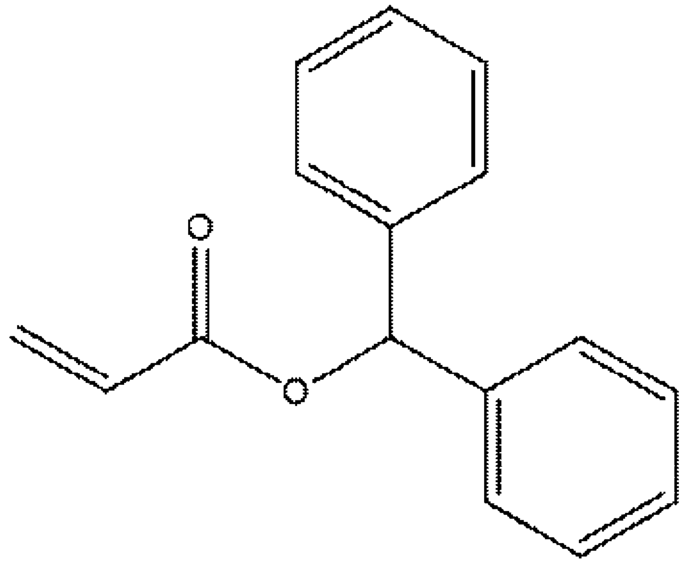

Compound (a-2): Polymerizable Compound Containing Si Atom

Component (a) may include polymerizable compound (a-2) containing at least a Si atom. When component (a) includes polymerizable compound (a-2), curable composition (A) preferably contains 10% or more by mass of Si atoms relative to the total mass of the curable composition (A) after the solvent (d) has been removed.

Polymerizable compound (a-2) containing at least a Si atom may be linear or branched. Examples include cyclic siloxane compounds expressed as the following structures, in which group Q has a polymerizable functional group, for example, a radical-polymerizable functional group. Specific examples of the radical-polymerizable functional group include (meth)acryloyl, (meth)acrylamide, vinylbenzene, acryl ether, vinyl ether, and maleimide. Group Q having a polymerizable functional group can be any of the groups having such a polymerizable functional group.

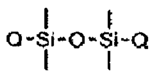
a-1

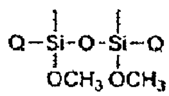
a-2

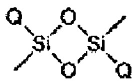
a-3

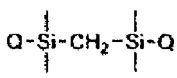
a-4

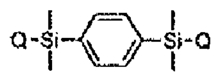
a-5

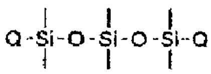
a-6

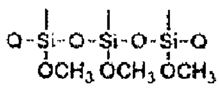
a-7

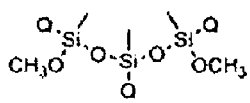
a-8

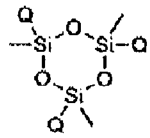
a-9

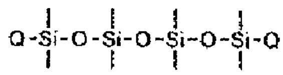
a-10

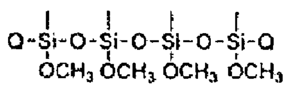
a-11

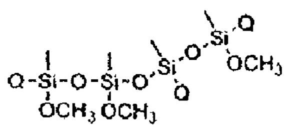
a-12

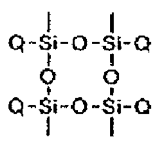
a-13

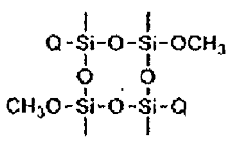
a-14

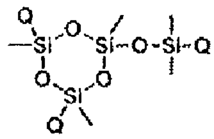
a-15

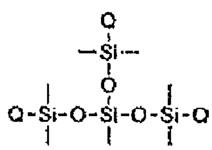
a-16

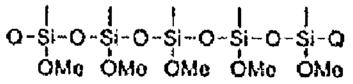

a-17

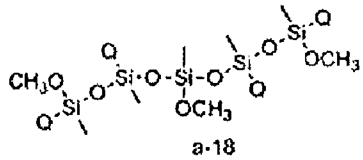

a-18

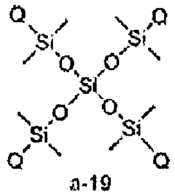

a-19

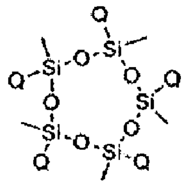

a-20

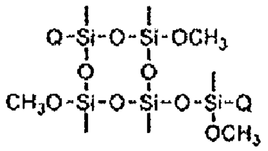

a-21

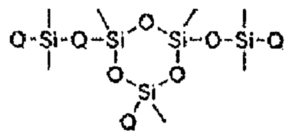

a-22

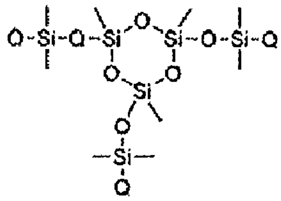

a-26

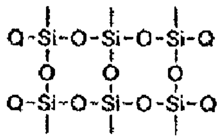

a-23

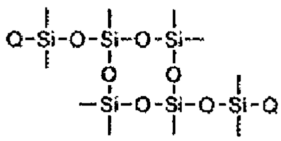

a-24

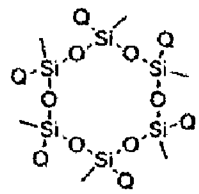

a-25

Other examples of polymerizable compound (a-2) include those having a silsesquioxane skeleton represented by the following chemical formula (I) or a silicone skeleton represented by the following chemical formula (II). In chemical formula (I), $m + n = 8$ ($8 \geq m \geq 1$) holds true, and $R_1$ is a divalent organic group. In chemical formula (II), A, B, $R_2$, and $R_3$ each independently represent an alkyl group with 1 to 6 carbon atoms, a cycloalkyl group, an alkoxy group, a phenyl group, a hydroxy group, and t represents an integer of 1 to 3, and at least one of A and B is a polymerizable functional group.

(I)

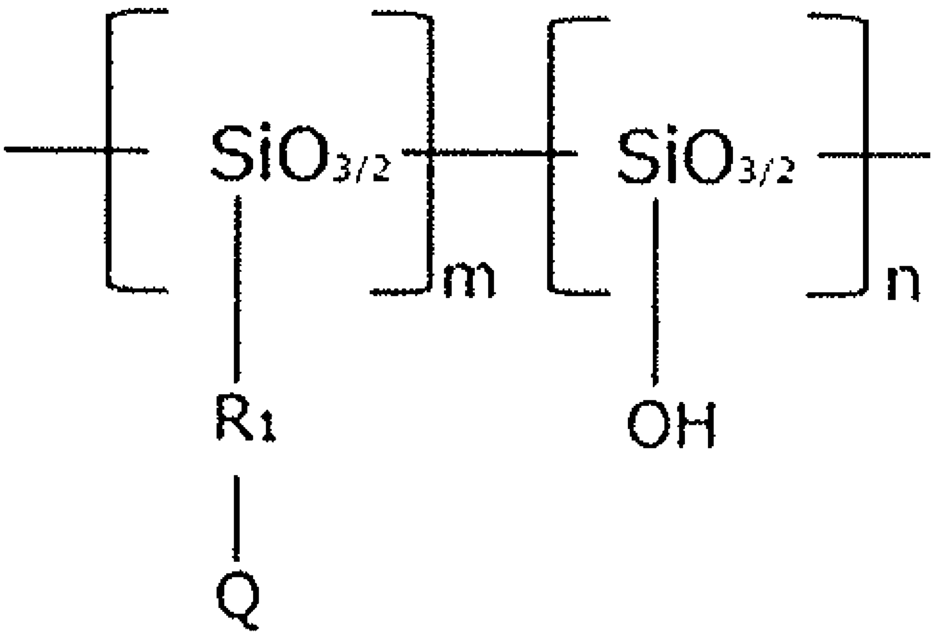

(II)

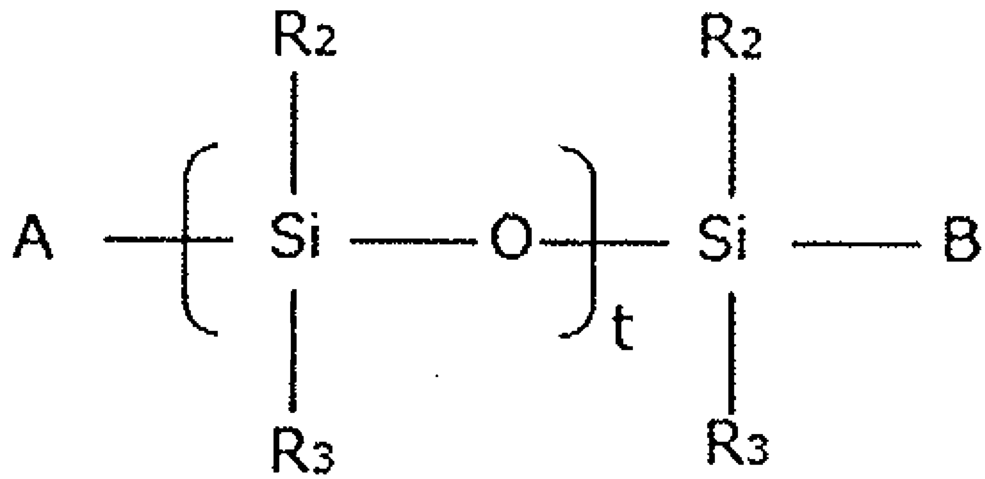

Group Q, which has a polymerizable functional group, and the polymerizable functional groups represented by A or B may be radical-polymerizable functional groups. Specific examples of such radical-polymerizable functional groups include (meth)acryloyl, (meth)acrylamide, vinylbenzene, acryl ether, vinyl ether, and maleimide. Group Q having a polymerizable functional group can be any of the groups having such a polymerizable functional group.

Silicon-containing (meth)acrylic compounds contain at least one acryloyl or methacryloyl group. Examples of silicon-containing monofunctional (meth)acrylic compounds having one acryloyl or methacryloyl group include, but are not limited to:

(2-acryloyletoxy)trimethylsilane,
N-(3-acryloyl-2-hydroxypropyl)-3-aminopropyltriethoxysilane,
acryloxymethyltrimethoxysilane,
(acryloxymethyl)phenethyltrimethylsilane,
acryloxymethyltrimethylsilane,
(3-acryloxypropyl)dimethylmethoxysilane,
(3-acryloxypropyl)methylbis(trimethylsiloxy)silane,
(3-acryloxypropyl)methyldichlorosilane,
(3-acryloxypropyl)methyldiethoxysilane,
(3-acryloxypropyl)methyldimethoxysilane,
(3-acryloxypropyl)trichlorosilane,
(3-acryloxypropyl)trimethoxysilane,
(3-acryloxypropyl)tris(trimethylsiloxy)silane,
acryloxytriisopropylsilane,
acryloxytrimethylsilane,
methacryloxymethyltrimethoxysilane,
o-(methacryloxyethoxy)carbamoylpropyl methyldimethoxysilane,
(methacryloxymethyl)bis(trimethylsiloxy)methylsilane,
N-(3-methacryloyl-2-hydroxypropyl)-3-aminopropyltriethoxysilane,
(methacryloxymethyl)methyldimethoxysilane,
(methacryloxymethyl)methyldiethoxysilane,
methacryloxymethyltriethoxysilane,
methacryloxypropyltrimethoxysilane,
methacryloxypropyltriisopropoxysilane,
o-(methacryloxyethyl)-N-(triethoxysilylpropyl) carbamate,
methacryloxypropylmethyldimethoxysilane,
methacryloxypropylmethyldiethoxysilane,
methacryloxypropyldimethylmethoxysilane,
methacryloxypropyldimethylethoxysilane,
(methacryloxymethyl)dimethylethoxysilane,

methacryloxypropyltriethoxysi lane,
methacryloxypropylsilatrane,
methacryloxypentamethyldisiloxane
(methacryloxymethyl)phenyldimethylsilane,
methacryloxytrimethylsilane,
methacryloxymethyltrimethylsilane,
(3-methacryloxy-2-hydroxypropoxypropyl)methylbis(trimethylsiloxy)silane,
methacryloxypropylpentamethyldisiloxane,
o-(methacryloxyethyl)-3-[bis(trimethylsiloxy)methylsilyl]propyl carbamate,
(methacryloxymethyltris(trimethylsiloxy)silane,
methacryloxyethoxytrimethylsilane,
methacryloxypropyltris(vinyldimethylsiloxy)silane,
methacryloxypropyltris(trimethylsiloxy)silane,
3-methacryloxypropyltriacetoxysi lane,
methacryloxypropylmethyldichlorosilane,
methacryloxypropyltrichlorosilane,
3-methacryloxypropylbis(trimethylsiloxy)methylsilane,
3-methacryloxypropyldimethylchlorosilane,
o-methacryloxy(polyethyleneoxy)trimethylsilane,
poly(methacryloxypropyl) silsesquioxane, and
methacryloxypropylheptaisobutyl-T8-silsesquioxane.

Examples of commercially available products of such silicon-containing monofunctional (meth)acrylic compounds include, but are not limited to:

SIA0160.0, SIA0180.0, SIA0182.0, SIA0184.0, SIA0186.0, SIA0190.0, SIA0194.0, SIA0196.0, SIA0197.0, SIA0198.0, SIA0199.0, SIA0200.0, SIA0200.A1, SIA0210.0, SIA0315.0, SIA0320.0, SIM6483.0, SIM6487.5, SIM6480.76, SIM6481.2, SIM6486.1, SIM6481.1, SIM6481.46, SIM6481.43, SIM6482.0, SIM6487.4, SIM6487.35, SIM6480.8, SIM6486.9, SIM6486.8, SIM6486.5, SIM6486.4, SIM6481.3, SIM6487.3, SIM6487.1, SIM6487.6, SIM6486.14, SIM6481.48, SIM6481.5, SIM6491.0, SIM6485.6, SIM6481.15, SIM6487.0, SIM6481.05, SIM6485.8, SIM6481.0, SIM6487.4LI, SIM6481.16, SIM6487.8, SIM6487.6HP, SIM6487.17, SIM6486.7, SIM6487.2, SIM6486.0, SIM6486.2, SIM6487.6-06, SIM6487.6-20, SIM6485.9, SST-R8C42, SLT-3R01, and SIM6486.65 (all produced by GELEST); and
TM-0701T, FM-0711, FM-0721, and FM-0725 (all produced by JNC).

Silicon-containing (meth)acrylamide-based compounds contain at least one acrylamide or methacrylamide group. Examples of silicon-containing monofunctional (meth)acrylamide-based compounds having one acrylamide or methacrylamide group include, but are not limited to:
3-acrylamidopropyltrimethoxysilane and 3-acrylamidopropyltris(trimethylsiloxy)silane.

Examples of commercially available products of such silicon-containing monofunctional (meth)acrylamide-based compounds include, but are not limited to:
SIA0146.0 and SIA0150.0 (both produced by GELEST).

Examples of polyfunctional (meth)acrylic compounds containing two or more acryloyl or methacryloyl groups include, but are not limited to:

linear polydimethylsiloxane modified with acryloxypropyl groups at both ends,
linear polydimethylsiloxane modified with methacryloxypropyl groups at both ends,
cyclic siloxane modified with a plurality of acryloxypropyl groups,
cyclic siloxane modified with a plurality of methacryloxypropyl groups,
silsesquioxane modified with a plurality of acryloxypropyl groups, and
silsesquioxane modified with a plurality of methacryloxypropyl groups.

Examples of commercially available products of such silicon-containing polyfunctional (meth)acrylic compounds include, but are not limited to:

SIA0200.2, SIA0200.3, SIM6487.42, DMS-R11, DMS-R05, DMS-R22, DMS-R18, and DMS-R31 (all produced by GELEST);
FM-7711, FM-7721, and FM-7725 (all produced by JNC);

X-22-2445 (produced by Shin-Etsu Chemical); and
AC-SQ TA-100, MAC-SQ TM-100, AC-SQSI-20, and MAC-SQ SI-20 (all produced by Toagosei).

Also, the following compounds may be synthesized or obtained according to a known literature, Ogawa et al., "Ultraviolet curable branched siloxanes as low-k dielectrics for imprint Lithography", J. Vac. Sci. Technol. B 31(1), 011601:

linear modified polydimethylsiloxane modified with methacryloxypropyl groups at both ends (MA-Si-12),
8-membered siloxane modified with four methacryloxypropyl groups (8-ring), and
10-membered siloxane modified with five methacryloxypropyl groups (10-ring).

The proportion of component (a) in the curable composition (A) is preferably 40% to 99% by mass relative to the mass of non-volatile component composition (A'). More preferably, the proportion of component (a) in the curable composition (A) is 50% to 95% by mass relative to the mass of non-volatile component composition (A'), still more preferably 60% to 90% by mass. When the proportion of component (a) is 40% or more by mass, the curable composition results in a cured film with high mechanical strength. Also, component (a) in a proportion of 99% by mass or less results in high proportions of components (b), (c), and (e), leading to good high photopolymerization speed or the like. At least a part of component (a), which includes one or more polymerizable compounds, may be a polymer containing a polymerizable functional group. Preferably, the polymer contains at least a cyclic structure such as an aromatic structure, an aromatic heterocyclic structure, or an alicyclic structure.

For example, the polymer preferably contains at least one of the structural units represented by the following structures (1) to (6):

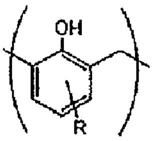
(1)
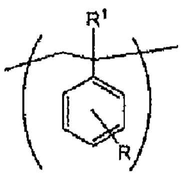
(2)
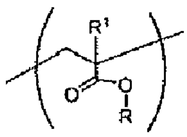
(3)
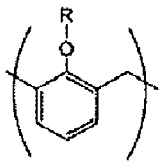
(4)
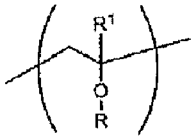
(5)
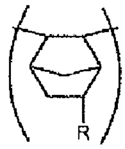
(6)

In structures (1) to (6), each R represents independently a substituent containing a partial structure with an aromatic ring, and $R^1$ represents a hydrogen atom or a methyl group. In the structural units expressed by structures (1) to (6) used herein, the portion excluding R is the main chain of a specific polymer.

The formula weight of substituent R is preferably 80 or more, more preferably 100 or more, still more preferably 130 or more, and further preferably 150 or more. The upper limit of the formula weight of substituent R is practically 500 or less.

The polymer containing a polymerizable functional group is typically a compound having a weight average molecular weight of 500 or more, preferably 1,000 or more, more preferably 2,000 or more. The upper limit of the weight average molecular weight is not specified, but is preferably, for example, 50,000 or less. When the weight average molecular weight is such a lower limit as mentioned above or higher, the polymer has a boiling point of 250°C or more, enhancing the mechanical strength of the cured film. Also, when the weight average molecular weight is the above-mentioned upper limit or less, the polymer is highly soluble in the solvent and can maintain the fluidity of the droplets to be applied discretely, with a viscosity not so high, consequently increasing the flatness of the surface of the resulting liquid film. Weight average molecular weight (Mw) mentioned herein (Mw) is a value measured by gel permeation chromatography (GPC) unless otherwise specified.

Specific examples of the polymerizable functional group of the polymer include (meth) acryloyl, epoxy, oxetane, methylol, methylol ether, and vinyl ether. (Meth)acryloyl groups are particularly preferred from the viewpoint of easy polymerization.

When a polymer containing a polymerizable functional group is added as at least a part of component (a), the polymer can be added in any proportion within the range in which the viscosity of the curable composition can be in the range specified later. For example, the amount of the polymer is preferably 0.1% to 60% by mass relative to the total mass of all constituents excluding component (d), more preferably 1% to 50% by mass, still more preferably 10% to 40% by mass. When the proportion of the polymer containing a polymerizable functional group is 0.1% or more by mass, the curable composition can exhibit enhanced heat resistance, dry etching resistance, and mechanical strength, and reduced volatility. When the proportion of the polymer containing a polymerizable functional group is 60% by mass or less, the curable composition can exhibit a viscosity within the range specified later.

Component (b): Photopolymerization Initiator

Component (b) is a photopolymerization initiator. The term "photopolymerization initiator" used herein is a compound that senses light having a specific wavelength and produces a polymerizing factor (radical). Specifically, the photopolymerization initiator is a polymerization initiator that produces a radical with light (infrared light, visible light, ultraviolet light, far ultraviolet light, X-ray), charged particle radiation such as electron beams, or other radiation (radical generator). Component (b) may be an individual photopolymerization initiator or a combination of a plurality of photopolymerization initiators.

Examples of radical generators include, but are not limited to:
substituted or unsubstituted 2,4,5-triarylimidazole dimers, such as 2-(o-chlorophenyl)-4,5-diphenylimidazole dimer, 2-(o-chlorophenyl)-4,5-di(methoxyphenyl)imidazole dimer, 2-(o-fluorophenyl)-4,5-diphenylimidazole dimer, and 2-(o- or p-methoxyphenyl)-4,5-diphenylimidazole dimer; benzophenone and benzophenone derivatives, such as N,N'-tetramethyl-4,4'-diaminobenzophenone (Michler's ketone), N,N'-tetraethyl-4,4'-diaminobenzophenone, 4-methoxy-4'-dimethylaminobenzophenone, 4-chlorobenzophenone, 4,4'-dimethoxybenzophenone, and 4,4'-diaminobenzophenone; α-amino aromatic ketone derivatives, such as 2-benzyl-2-dimethylamino-1-(4-morpholinophenyl)butan-1-one and 2-methyl-1-[4-(methylthio)phenyl]-2-morpholinopropan-1-one; quinones, such as 2-ethylanthraquinone, phenanthrenequinone, 2-t-butylanthraquinone, octamethylanthraquinone, 1,2-benzanthraquinone, 2,3-benzanthraquinone, 2-phenylanthraquinone, 2,3-diphenylanthraquinone, 1-chloroanthraquinone, 2-methylanthraquinone, 1,4-naphthoquinone, 9,10-phenanthraquinone, 2-methyl-1,4-naphthoquinone, and 2,3-dimethylanthraquinone; benzoin ether derivatives, such as benzoin methyl ether, benzoin ethyl ether, and benzoin phenyl ether; benzoin and benzoin derivatives, such as methyl benzoin, ethyl benzoin, and propyl benzoin; benzyl derivatives, such as benzyl dimethyl ketal; acridine derivatives, such as 9-phenylacridine and 1,7-bis(9,9'-acridinyl)heptane; N-phenylglycine and N-phenylglycine derivatives; acetophenone and acetophenone derivatives, such as 3-methylacetophenone, acetophenone benzyl ketal, 1-hydroxycyclohexyl phenyl ketone, and 2,2-dimethoxy-2-phenylacetophenone; thioxanthone and thioxanthone derivatives, such as diethylthioxanthone, 2-isopropylthioxanthone, and 2-chlorothioxanthone; acylphosphine oxide derivatives, such as 2,4,6-trimethylbenzoyldiphenylphosphine oxide, bis(2,4,6-trimethylbenzoyl)phenylphosphine oxide, and bis-(2,6-dimethoxybenzoyl)-2,4,4-trimethylpentylphosphine oxide; oxime ester derivatives, such as 1,2-octanedione, 1-[4-(phenylthio)-,2-(o-benzoyloxime)], and ethanone,1-[9-ethyl-6-(2-methylbenzoyl)-9H-carbazol-3-yl]-,1-(O-acetyloxime); and xanthone, fluorenone, benzaldehyde, fluorene, anthraquinone, triphenylamine, carbazole, 1-(4-isopropylphenyl)-2-hydroxy-2-methylpropan-1-one, and 2-hydroxy-2-methyl-1-phenylpropan-1-one.

Examples of commercially available products of such radical generators include, but are not limited to:
Irgacure series 184, 369, 651, 500, 819, 907, 784, and 2959, CGI-1700, -1750, and -1850, CG24-61, Darocur series I116 and 1173, and Lucirin (registered trademark) series TPO, LR 8893, and LR 8970 (all produced by BASF); and Ubecryl P36 (produced by UCB).

Among those radical generators, component (b) is preferably an acylphosphine oxide-based photopolymerization initiator. Acylphosphine oxide-based photopolymerization initiators among the above-presented radical generators include:
2,4,6-trimethylbenzoyldiphenylphosphine oxide, bis(2,4,6-trimethylbenzoyl)phenylphosphine oxide, and bis-(2,6-dimethoxybenzoyl)-2,4,4-trimethylpentylphosphine oxide.

The proportion of component (b) in the curable composition (A) is preferably 0.1% to 50% by mass to the mass of non-volatile component composition (A'). More preferably, the proportion of component (b) in the curable composition (A) is 0.1% to 20% by mass relative to the mass of non-volatile component composition (A'), still more preferably 1% to 20% by mass. When the proportion of component (b) is 0.1% or more by mass, the curable composition can be cured at a high speed; hence the reaction efficiency increases. When the proportion of component (b) is 50% by mass or less, the curable composition can form a cured film having a certain degree of mechanical strength.

Component (c): Surfactant

Component (c) is a surfactant. The term "surfactant" used herein is a compound that reduces the interfacial bonding strength between the mold and the curable composition, that is, reduces the release force in the mold releasing step described later. Surfactants that can be used include silicone surfactants, fluorosurfactants, and hydrocarbon surfactants. Component (c) may be an individual surfactant or a mixture of two or more surfactants.

Examples of fluorosurfactants include:
polyalkylene oxide (such as polyethylene oxide or polypropylene oxide) adducts of alcohols having a perfluoroalkyl group, and polyalkylene oxide (such as polyethylene oxide or polypropylene oxide) adducts of perfluoropolyether.

The fluorosurfactant may have a hydroxy, alkoxy, alkyl, amino, or thiol group or the like in a part (for example, as a terminal group) of the molecular structure. An example is pentadeca(ethylene glycol) mono-1H,1H,2H,2H-perfluorooctyl ether.

The fluorosurfactant may be a commercially available product. Examples of commercially available fluorosurfactants include:
Megafac (registered trademark) series F-444, TF-2066, TF-2067 and TF-2068 and DEO-15 (abbreviation) (all produced by DIC); Fluorad series FC-430 and FC-431 (both produced by Sumitomo 3M); Surflon (registered trademark) S-382 (produced by AGC); EFTOP EF-122A, 122B, 122C, EF-121, EF-126, EF-127, and MF-100 (all produced by Tochem Products); PF-636, PF-6320, PF-656, and PF-6520 (all produced by OMNOVA Solutions); Unidyne (registered trademark) series DS-401, DS-403, and DS-451 (all produced by Daikin Industries); and Ftergent (registered trademark) series 250, 251, 222F, and 208G (all produced by Neos).

Component (c) may be a hydrocarbon surfactant. The hydrocarbon surfactant may be an alkyl alcohol polyalkylene oxide adduct produced by adding an alkylene oxide with 2 to 4 carbon atoms to an alkyl alcohol with 1 to 50 carbon atoms.

Examples of alkyl alcohol polyalkylene oxide adducts include:
methyl alcohol ethylene oxide adduct, decyl alcohol ethylene oxide adduct, lauryl alcohol ethylene oxide adduct, cetyl alcohol ethylene oxide adduct, stearyl alcohol ethylene oxide adduct, and stearyl alcohol ethylene oxide/propylene oxide adduct.

The terminal groups of alkyl alcohol polyoxyalkylene oxide adducts are not limited to simple hydroxy groups, which are produced by adding a polyalkylene oxide to an alkyl alcohol. The terminal hydroxy group may be substituted with a polar functional group, such as carboxy, amino, pyridyl, thiol, or silanol, or a hydrophobic functional group, such as alkyl or alkoxy.

Examples of polyalkylene oxides include:
polyethylene glycol and polypropylene glycol; and their monomethyl or dimethyl ethers, monooctyl or dioctyl ethers, mononony or dinonyl ethers, monodecyl or didecyl ethers; monoadipic acid esters, mono oleic acid esters, monostearic acid esters, and monosuccinic acid esters.

A commercially available alkyl alcohol polyalkylene oxide adduct may be used. Examples of commercially available alkyl alcohol polyalkylene oxide adducts include:
polyoxyethylene methyl ethers (methyl alcohol ethylene oxide adducts) BLAUNON series MP-400, MP-550, and MP-1000, produced by Aoki Oil Industrial; polyoxyethylene decyl ethers (decyl alcohol ethylene oxide adducts) FINESURF series D-1303, D-1305, D-1307, and D-1310, produced by Aoki Oil Industrial; polyoxyethylene lauryl ether (lauryl alcohol ethylene oxide adduct) BLAUNON EL-1505, produced by Aoki Oil Industrial; polyoxyethylene cetyl ethers (cetyl alcohol ethylene oxide adducts) BLAUNON series CH-305 and CH-310, produced by Aoki Oil Industrial; polyoxyethylene stearyl ethers (stearyl alcohol ethylene oxide adducts) BLAUNON series SR-705, SR-707, SR-715, SR-720, SR-730, and SR-750, produced by Aoki Oil Industrial; random copolymer type polyoxyethylene polyoxypropylene alkyl ethers BLAUNON series SA-50/50 1000R and SA-30/70 2000R, WONDERSURF 140, and FINESURF TDP-0633K, produced by Aoki Oil Industrial; polyoxyethylene methyl ether Pluriol (registered trademark) A760E, produced by BASF; polyoxyethylene alkyl ethers EMULGEN series, produced by Kao; polyoxyethylene-polyoxypropylene block polymers PLURONIC (registered trademark) series L-44, L-43, L-42, L-31, 17R2, and 25R1, produced by ADEKA; polyoxyethylene alkyl ether Briji S10, produced by DOW; polyoxyethylene alkyl ethers BLAUNON series EN-1504, EL-1502.2P, and EN-902, produced by Aoki Oil Industrial; polyoxypropylene polyoxyethylene 2-ethylhexyl ethers TERGITOL series EH-9, EH-6, and EH-3, produced by DOW; polyoxyethylene 2-ethylhexyl ethers BLAUNON series EH-2 and EH-4, produced by Aoki Oil Industrial; polyethylene glycol trimethylnonyl ethers TERGITOL series HW-1000 and TMN-3, produced by DOW; polyoxyethylene tert-octylphenyl ethers TRITON (registered trademark) series X-15 and X-45, produced by DOW; ethoxylated acetylenic diol Dynol-604, produced by Evonik; Acetylenol series E100 and E13T, produced by Kawaken Fine Chemical); and Surfynol series SE and 420, produced by Nissin Chemical Industry).

A commercially available polyalkylene oxide may be used, and, for example, an ethylene oxide-propylene oxide copolymer Pluronic PE 6400, produced by BASF, may be used.

Examples of silicone surfactants include: SI-10 series (trade name, produced by Takemoto Oil & Fat), Megafac Paintad 31 produced by DIC), and KP-341 (produced by Shin-Etsu Chemical).

The surfactant may contain both a fluorine atom and a silicon atom. Examples of surfactants containing both fluorine and silicon atoms include:
X-70-090, X-70-091, X-70-092, and X-70-093 (all trade names, produced by Shin-Etsu Chemical); and Megafac series (trade name) R-08 and XRB-4 (both produced by DIC).

The present inventors have found, through their intensive research, that segregation of component (c) at the edges of the liquid film of the curable composition (A), as described later, increases the viscosity of the liquid film specifically at the edges, reducing the edge filling speed. In the present disclosure, accordingly, the viscosity of component (c), or surfactant, is preferably 500 mPa·s or less at 23°C and 1 atm, more preferably 400 mPa·s or less, further preferably 300 mPa·s or less. Referring to Fig. 3, at the interface 111 between the liquid film and the atmospheric gas, the surfactant acts to increase the viscosity, and the surfactant, or component (c), is in segregation. If the viscosity of the surfactant, or component (c), is higher than 500 mPa·s, the fluidity of the liquid at the interface 111 decreases relatively. Consequently,

when the non-volatile component composition (A') after the solvent, or component (d), has been volatilized is brought into contact with a mold, the edge filling speed is low. Thus, the use of the curable composition (A) disclosed herein, which contains a surfactant, or component (c), with a viscosity of 500 mPa·s or less, enables high-throughput imprinting processing.

Examples of the surfactant having a viscosity of 500 mPa·s or less at 23°C and 1 atm that can be used as component (c) include PLURONIC L-44 (435.4 mPa·s) and PLURONIC 17R2 (407.1 mPa·s), both produced by ADEKA; WONDERSURF 140 (146.6 mPa·s), BLAUNON SA-50/50 1000R (114.6 mPa·s), and BLAUNON SA-30/70 2000R (217.0 mPa·s), all produced by Aoki Oil Industrial; TERGITOL EH-9 (101.8 mPa·s), TERGITOL HW-1000 (41.2 mPa·s), TERGITOL TMN-3 (22.4 mPa·s), and TRITON (registered trademark) X-45 (374.0 mPa·s), all produced by Dow; Dynol-604 (340.45 mPa·s), produced by Evonik; Acetylenol E100 (171.3 mPa·s), produced by Kawaken Fine Chemical; Surfynol 420 (295.6 mPa·s), produced by Nissin Chemical Industry; and Acetylenol E13T (295.6 mPa·s), produced by Kawaken Fine Chemical.

The proportion of component (c) in the curable composition (A) is preferably 0.01% to 10% by mass relative to the mass of non-volatile component composition (A'). More preferably, the proportion of component (c) in the curable composition (A) is 0.1% to 5% by mass relative to the mass of non-volatile component composition (A'), still more preferably 0.5% to 3% by mass. Component (c) in a proportion of 0.01% or more by mass reduces the interfacial bonding strength between the curable composition and the mold and accordingly reduces the release force in the mold releasing step described later. Also, when the proportion of component (c) is 10% by mass or less, the curable composition can form a cured film having a certain degree of mechanical strength.

Component (e): Non-polymerizable Compound

The curable composition (A) disclosed herein may contain a non-polymerizable compound as component (e) in addition to components (a), (b), and (c), according to purposes, within a range in which the advantageous effects intended in the present disclosure are not impaired. Such component (e) can be a compound that does not have a polymerizable functional group such as (meth)acryloyl groups and cannot sense light with a specific wavelength to produce the above-mentioned polymerizing factors (radicals). Examples of non-polymerizable compounds include sensitizers, hydrogen donors, antioxidants, polymer components, and other additives. Component (e) may include a plurality of such compounds.

A sensitizer is a compound that is optionally added to promote a polymerization reaction or increase the reaction conversion rate. These sensitizer may be an individual compound or a mixture of two or more compounds.

The sensitizer may be a sensitizing dye or the like. The sensitizing dye is a compound that absorbs light with a specific wavelength to be excited and interacts with the photopolymerization initiator that is component (b).

This interaction includes energy transfer or electron transfer from the excited sensitizing dye to the photopolymerization initiator acting as component (b). Specific examples of the sensitizing dye include, but are not limited to: anthracene derivatives, anthraquinone derivatives, pyrene derivatives, perylene derivatives, carbazole derivatives, benzophenone derivatives, thioxanthone derivatives, xanthone derivatives, coumarin derivatives, phenothiazine derivatives, camphorquinone derivatives, acridine dyes, thiopyrylium salt-based dyes, merocyanine dyes, quinoline dyes, styryl quinoline dyes, ketocoumarin dyes, thioxanthene dyes, xanthene dyes, oxonol dyes, cyanine dyes, rhodamine dyes, and pyrylium salt-based dyes.

The hydrogen donor is a compound that can react with initiator radicals or chain end radicals generated from the photopolymerization initiator acting as component (b), thereby producing a more reactive radical. When the photopolymerization initiator acting as component (b) is a photoradical generator, a hydrogen donor is preferably added.

Specific examples of the hydrogen donor include, but are not limited to:
amine compounds, such as n-butylamine, di-n-butylamine, tri-n-butylphosphine, allylthiourea, s-benzylisothiuronium-p-toluene sulfonate, triethylamine, diethylaminoethyl methacrylate, triethylenetetramine, 4,4'-bis(dialkylamino)benzophenone, ethyl N,N-dimethylaminobenzoate, isoamyl N,N-dimethylaminobenzoate, pentyl 4-(dimethylamino)benzoate, triethanolamine, and N-phenylglycine; and mercapto compounds, such as 2-mercapto-N-phenylbenzoimidazole and mercaptopropionic acid esters.

The hydrogen donor to be used may be an individual compound or a mixture of two or more compounds.

The hydrogen donor may have a function as a sensitizer.

The proportion of component (e) in the curable composition (A) is preferably 0.01% to 50% by mass relative to the mass of non-volatile component composition (A'). More preferably, the proportion of component (e) in the curable composition (A) is 0.01% to 20% by mass relative to the mass of non-volatile component composition (A'). When the proportion of component (e) is 50% by mass or less, the curable composition can form a cured film having a certain degree of mechanical strength.

Component (d): Solvent

The curable composition (A) disclosed herein may contain a solvent with a boiling point of 100°C to less than 250°C under normal pressure as component (d). Component (d) may be a solvent that can dissolve components (a), (b), (c), and (e), and examples include alcohol-based solvents, ketone-based solvents, ether-based solvents, ester-based solvents, and nitrogen-containing solvents. Such solvents as component (d) may be used individually or in combination. The boiling points of component (d) is preferably 100°C or more under normal pressure, more preferably 140°C or more, still more preferably 150°C or more. The boiling points of component (d) is 250°C or less, preferably less than 200°C, under normal pressure. When component (d) has a boiling point of less than 100°C under normal pressure, the volatilization speed can be so high in the waiting step described later that component (d) volatilizes before droplets of the curable composition (A) merge. Thus, droplets of the curable composition (A) may not merge. Also, when component (d) has a boiling point of 250°C or more under normal pressure, the solvent (component (d)) cannot sufficiently volatilize and may remain in the cured product of the curable composition (A). In the case of component (d) consisting of two or more solvents, the boiling point under normal pressure of each solvent is desirably 100°C to less than 250°C (e.g., 100°C to less than 200°C).

Examples of alcohol-based solvents include:
monoalcohol-based solvents, such as methanol, ethanol, n-propanol, isopropanol, n-butanol, isobutanol, sec-butanol, tert-butanol, n-pentanol, isopentanol, 2-methylbutanol, sec-pentanol, tert-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethylheptan-4-ol, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; polyhydric alcohol-based solvents, such as ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin.

Examples of ketone-based solvents include:
acetone, methyl ethyl ketone, methyl n-propyl ketone, methyl n-butyl ketone, diethyl ketone, methyl isobutyl ketone, methyl n-pentyl ketone, ethyl n-butyl ketone, methyl n-hexyl ketone, diisobutyl ketone, trimethyl nonanone, cyclohexanone, methyl cyclohexanone, 2,4-pentanedione, acetonyl acetone, diacetone alcohol, acetophenone, and fenchone.

Examples of ether-based solvents include:
ethyl ether, isopropyl ether, n-butyl ether, n-hexyl ether, 2-ethyl hexyl ether, ethylene oxide, 1,2-propylene oxide, dioxolane, 4-methyl dioxolane, dioxane, dimethyldioxane, 2-methoxyethanol, 2-ethoxyethanol, ethylene glycol diethyl ether, 2-n-butoxyethanol, 2-n-hexoxyethanol, 2-phenoxyethanol, 2-(2-ethylbutoxy)ethanol, ethylene glycol dibutyl ether, diethylene monomethyl ether, diethylene glycol monoethyl ether, diethylene glycol diethyl ether, diethylene glycol mono-n-butyl ether, diethylene glycol di-n-butyl ether, diethylene glycol mono-n-hexyl ether, ethoxy triglycol, tetraethylene glycol di-n-butyl ether, 1-n-butoxy-2-propanol, 1-phenoxy-2-propanol, propylene glycol monomethyl ether, propylene glycol monoethyl ether, propylene glycol monopropyl ether, dipropylene glycol monomethyl ether, dipropylene glycol monoethyl ether, dipropylene glycol monopropyl ether, tripropylene glycol monomethyl ether, tetrahydrofuran, and 2-methyltetrahydrofuran.

Examples of ester-based solvents include:
diethyl carbonate, methyl acetate, ethyl acetate, amyl acetate, γ-butyrolactone, γ-valerolactone, n-propyl acetate, isopropyl acetate, n-butyl acetate, isobutyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, ethylene glycol diacetate, methoxy triglycol acetate, ethyl propionate, n-butyl propionate, isoamyl propionate, diethyl oxalate, di-n-butyl oxalate, methyl lactate, ethyl lactate, n-butyl lactate, n-amyl lactate, diethyl malonate , dimethyl phthalate, and diethyl phthalate.

Examples of nitrogen-containing solvents include:
N-methylformamide, N,N-dimethylformamide, N,N-diethylformamide, acetamide, N-methylacetamide, N,N-dimethylacetamide, N-methylpropionamide, and N-methylpyrrolidone.

Among the solvents presented above, ether-based or ester-based solvents are preferred. More preferably, ether-based or ester-based solvents with a glycol structure from the viewpoint of easy film formation.

Examples of such preferred solvents include:
propylene glycol monomethyl ether, propylene glycol monoethyl ether, propylene glycol monopropyl ether, propylene glycol monomethyl ether acetate, propylene glycol monoethyl ether acetate, and propylene glycol monopropyl ether acetate.

Particularly preferred can be propylene glycol monomethyl ether acetate. (Ethyl)isocyanurate di(meth)acrylate may also be used.

Preferably, the solvent used herein has at least one of an ester structure, a ketone structure, a hydroxy group, and an ether structure. More specifically, the solvent is an individual one or a mixture selected from the group consisting of propylene glycol monomethyl ether acetate (146°C boiling point), propylene glycol monomethyl ether, cyclohexanone, 2-heptanone, γ-butyrolactone, and ethyl lactate.

In an embodiment, the solvent, or component (d), may be a polymerizable compound with a boiling point of 80°C to less than 250°C under normal pressure. Examples of polymerizable compounds with a boiling point of 80°C to less than 250°C under normal pressure include:

cyclohexyl acrylate (198°C boiling point), benzyl acrylate (229°C boiling point), isobornyl acrylate (245°C boiling point), tetrahydrofurfuryl acrylate (202°C boiling point), trimethylcyclohexyl acrylate (232°C boiling point), isooctyl acrylate (217°C boiling point), n-octyl acrylate (228°C boiling point), ethoxyethoxyethyl acrylate (230°C boiling point), divinylbenzene (193°C boiling point), 1,3-diisopropenylbenzene (218°C boiling point), styrene (145°C boiling point), and α-methylstyrene (165°C boiling point)

In the embodiments of the present disclosure, the amount of component (d), or solvent, is more than 5% and 95% by volume or less relative to 100% by volume of the curable composition (A), preferably 15% to 85% by volume, more preferably 40% to 80% by volume. For example, the amount of the solvent (component (d)) is 40% to 85% by volume. If the amount of the solvent (component (d)) is less than 5% by volume, a thin film cannot be obtained after the solvent volatilizes, even though a substantially continuous liquid film of the curable composition is formed. If the amount of the solvent (component (d)) is more than 95% by volume, even droplets most densely dropped by an ink jet method cannot form a thick film after the solvent volatilizes.

Temperature for Preparing Curable Composition

For preparing the curable composition (A) disclosed herein, at least components (a), (b), (c), and (d) are mixed and dissolved under a specific temperature. Specifically, the specific temperature is in the range of 0°C to 100°C. The same applies to the case where the curable composition (A) contains component (e).

Viscosity of Curable Composition

The curable composition (A) disclosed herein is liquid. This is because the curable composition (A) is discretely dropped as droplets onto a substrate by an ink jet method in the application step described later. The viscosity of the curable composition (A) disclosed herein is 1.3 mPa·s to 60 mPa·s at 23°C and 1 atm, preferably 2 mPa·s to 30 mPa·s, more preferably 5 mPa·s to 15 mPa·s. If the viscosity of the curable composition (A) is less than 2 mPa·s, the ejection of the droplets by an ink jet method is unstable. Also, the curable composition (A) with a viscosity of 60 mPa·s or more cannot form droplets of about 1.0 pL to 3.0 pL in volume, which is desirable in the embodiments of the present disclosure.

The present inventors have found, through their intensive research, that the viscosity of the non-volatile component composition (A') dominates the edge filling speed. In the embodiments of the present disclosure, the viscosity of the non-volatile component composition (A') is preferably 8 mPa·s to 70 mPa·s at 23°C and 1 atm. More preferably, the viscosity of the non-volatile component composition (A'), at 23°C and 1 atm, is preferably 8 mPa·s to 30 mPa·s, more preferably 8 mPa·s to 20 mPa·s. If the viscosity is more than 70 mPa·s, the edge filling speed is low when the non-volatile component composition (A') is brought into contact with a mold. Thus, the use of the curable composition (A) disclosed herein, in which the viscosity of the non-volatile component composition (A') is controlled to 70 mPa·s or less, enables high-throughput imprinting processing.

Surface Tension of Curable Composition

In the embodiments of the present disclosure, the surface tension of the non-volatile component composition (A') is preferably 5 mN/m to 70 mN/m at 23°C and 1 atm. The non-volatile component composition (A'), which is the curable composition excluding the solvent (component (d)), preferably has a surface tension of 7 mN/m to 50 mN/m, more preferably 10 mN/m to 40 mN/m, at 23°C and 1 atm. Higher surface tension, such as 5 mN/m or more, results in stronger capillary forces. Consequently, when the non-volatile component composition (A') is brought into contact with a mold, the filling step (which includes spreading and filling) of the composition is completed in a short time. Also, the surface tension of 70 mN/m or less allows the curable composition to form a cured film with surface smoothness through curing.

Contact Angle of Curable Composition

In the embodiments of the present disclosure, the contact angle of the curable composition (A) is preferably 0° to

90° on the surface of a substrate. If the contact angle is more than 90°, the droplets on the substrate cannot come into contact with each other to form a continuous liquid film.

In the embodiments of the present disclosure, the contact angle of the non-volatile component composition (A') is preferably 0° to 90° both on the surface of the substrate and the surface (contact face) of the mold. When the contact angle exceeds 90°, capillary forces act in the negative direction (i.e., the direction causing contraction at the interface between the mold and the curable composition) within the mold pattern and in the gap between the substrate and the mold. This may hinder the non-volatile component composition (A') from filling the mold. The smaller the contact angle, the stronger the capillary forces, which increases the filling speed.

Impurities in Curable Composition

Desirably, impurities in the curable composition (A) disclosed herein are minimized. The impurities mentioned herein refer to constituents other than components (a), (b), (c), (d), and (e). Hence, the curable composition (A) disclosed herein is obtained through a purification step. The purification step is preferably filtration or the like using a filter.

Preferably, the filtration is performed by passing a mixture of components (a), (b), (c), and (e) through a filter, for example, with a pore size of 0.001 μm to 5.0 μm. Preferably, the filtration using a filter is performed in a plurality of steps or repeated several times (circulating filtration). The filtrate may be filtered again through the same filter or using some filters with different pore sizes. The filter may be made of, but not limited to, polyethylene, polypropylene, fluororesin, or nylon. Such a purification step can remove impurities such as particulate matter from the curable composition. Thus, unexpected defects can be prevented that result from unevenness formed in the cured film after curing due to impurities in the curable composition.

When the curable composition disclosed herein is used for manufacturing semiconductor integrated circuits, it is desirable to avoid contamination of the curable composition with impurities containing metal atoms (metal impurities) as much as possible to prevent interference with product operation. The concentration of metallic impurities in the curable composition is preferably 10 ppm or less, more desirably 100 ppb or less.

Glass transition temperature of Curable Composition

When the curable composition has a much higher glass transition temperature than the releasing temperature, the cured product, upon release from the mold, is in a tough glass state and, hence, exhibits a high mechanical strength, being less prone to pattern collapse or damage caused by releasing the mold. For a mold releasing step at room temperature, accordingly, the glass transition temperature of the cured product of the non-volatile component composition (A') is preferably 70°C or more, more preferably 100°C or more, still more preferably 150°C or more.

The glass transition temperature of the cured product (photocured product) can be measured using differential scanning calorimetry (DSC) or a dynamic viscoelasticity meter. A case of measuring the glass transition temperature by DSC will be described, for example. In this case, obtained are the straight line formed by extending the base line of the DSC curve of the cured product on the low temperature side (the portion of the DSC curve where no phase transitions or reactions occur in the specimen) toward the high temperature side, the tangent drawn at the point where the slope of the curve reaches its maximum during the step-like change in the glass transition region. Then, the extrapolated glass transition start temperature (Tig) is obtained by finding the intersection of the straight line with the tangent and is defined as the glass transition temperature. For example, STA-6000 (manufactured by Perkin Eimer) is one of the main measuring apparatuses. In another case, where the glass transition temperature is measured using a dynamic viscoelasticity meter, the temperature at which the loss tangent (tan δ) of the cured product reaches its maximum is defined as the glass transition temperature. The apparatus for measuring the dynamic viscoelasticity may be, for example, MCR301 (manufactured by Anton Paar).

Substrate

In the description of the present disclosure, the member onto which droplets of the curable composition (A) are dropped discretely is referred to as a substrate.

The substrate is a substrate to be processed and is typically a silicon wafer. The substrate may have a layer to be processed at its surface. The substrate may include another layer under the layer to be processed. The use of quartz as the substrate enables the fabrication of a replica of the mold (replica mold) for imprinting. However, the substrate is not limited to a silicon wafer or a quartz substrate. The substrate may be arbitrarily selected from materials known as substrates for semiconductor devices, such as aluminum, titanium-tungsten alloy, aluminum-silicon alloy, aluminum-copper-silicon alloy, silicon oxide, and silicon nitride. Preferably, the substrate or the surface of the layer to be processed is surface-treated by silane coupling treatment, silazane treatment, or the deposition of an organic thin film to increase the adhesion with the curable composition (A). For example, the adhesion layer disclosed in PCT Japanese Translation Patent

Publication No. 2009-503139 is one example of the organic thin film deposited as surface treatment.

Pattern Formation Method

The method for forming a pattern in the present disclosure will now be described with reference to Figs. 1A to 1G. The cured film formed in the present disclosure preferably has a pattern with a size of 1 nm to 10 mm and more preferably has a pattern with a size of 10 nm to 100 μm. Techniques for forming nanometer-scale (1 nm to 100 nm) patterns (relief structures) using light are generally called nanoimprinting. The film formation method used herein forms a film of a curable composition in the gap between a mold and a substrate using a photo-imprinting method. Alternatively, the curable composition may be cured using other energy, such as heat or electromagnetic waves. The film formation method described herein may be used as a pattern formation method for forming a film with a pattern or as a planarizing film formation method for forming a film with no pattern (e.g., planarizing film).

An example in which the film formation method described herein is applied to a pattern formation method will now be described. The pattern formation method includes, for example, a formation step, an application step, a waiting step, a contact step, a curing step, and a mold releasing step. In the formation step, a priming layer is formed. In the application step, droplets of the curable composition (A) are applied discretely onto the priming layer. The waiting step is a duration of waiting for the merging of droplets of the curable composition (A) and the volatilization of the solvent (component (d)). In the contact step, the curable composition (A) is brought into contact with a mold. In the curing step, the curable composition (A) is cured. In the mold releasing step, the cured film of the curable composition (A) is separated from the mold. The application step is performed after the formation step. The waiting step follows the application step. The contact step is performed after the waiting step. The curing step is performed after the contact step. The mold releasing step is performed after the curing step.

Application Step

In the application step, droplets 102 of a curable composition (A) are applied discretely onto a substrate 101, as schematically illustrated in Fig. 1A. In this step, droplets 102 of the curable composition (A), each with a volume of 1.0 pL or more, are applied at a density of 80 droplets/$mm^2$ or more. A priming layer may be deposited on the substrate 101. The substrate 101 may be surface-treated by silane coupling treatment, silazane treatment, or the deposition of an organic thin film to increase the adhesion with the curable composition (A).

For applying droplets 102 of the curable composition (A) onto the substrate, an ink jet method is particularly preferred. Preferably, droplets 102 of the curable composition (A) are densely applied over the area of the substrate 101 opposing the area of the mold 106 where the recesses of the pattern are densely arranged. In contrast, the droplets 102 are sparsely applied over the area of the substrate 101 opposing the area of the mold 106 where the recesses of the pattern are sparsely arranged. As a result, the film (residual film) of the curable composition (A) described later, formed on the substrate 101 is controlled to have a uniform thickness irrespective of the pattern density of the mold 106.

In order to specify the volume of the non-volatile component composition (A') to be applied, an indicator, average liquid film thickness, is defined. The average liquid film thickness is the quotient obtained by dividing the volume of the non-volatile component composition (A') applied in the application step by the area of the film formation region of the mold. The volume of the non-volatile component composition (A') is the sum of the volumes of droplets of the curable composition (A) after the solvent (component (d)) has volatilized. This definition enables the average liquid film thickness to be specified irrespective of any irregularities of the substrate surface. The average liquid film thickness may be interpreted to be the quotient obtained by dividing the volume of the non-volatile component composition (A') remaining after the waiting step by the area of the film formation region and is preferably 5 nm to 170 nm.

Waiting Step

In the present disclosure, the waiting step follows the application step and precedes the contact step. The average initial liquid film thickness is now defined as the quotient obtained by dividing the total volume of droplets of the curable composition (A) dropped by a single patterning operation by the total area of the region where the pattern is formed by the single patterning operation (pattern formation region). In the waiting step, droplets 102 of the curable composition (A) spread over the substrate 101, as schematically illustrated in Fig. 1B. Consequently, the curable composition (A) covers the entirety of the pattern formation region of the substrate 101.

The behavior during the waiting step of droplets of the curable composition (A) applied onto the substrate will now be described with reference to Figs. 2A to 2D. The droplets 102 of the curable composition (A) are applied discretely onto the substrate 101, as illustrated in Fig. 2A, and gradually spread over the substrate, as illustrated in Fig. 2B. Then, the droplets of the curable composition (A) on the substrate begin to merge to form a liquid film as illustrated in Fig. 2C, thus forming a continuous liquid film (covering the surface of the substrate 101 without leaving any exposed faces) as illustrated

in Fig. 2D. The state of the curable composition (A) as depicted in Fig. 2D is referred to as a "substantially continuous liquid film".

Furthermore, in the waiting step, the solvent 105 (component (d)) in the liquid film 104 is volatilized, as schematically illustrated in Fig. 1D. The amount of solvent (component (d)) remaining in the liquid film 103 remaining after the waiting step is preferably controlled to 10% by volume or less, when the total volume of the components excluding the solvent (component (d)) is considered 100% by volume. If 10% by volume or more of solvent (component (d)) is left, the mechanical properties of the resulting cured film may decrease.

In the waiting step, in order to accelerate the volatilization of the solvent (component (d)), a baking step may be performed by heating the substrate 101 and the curable composition (A), or the atmosphere surrounding the substrate 101 may be ventilated. This heating is performed, for example, at temperatures of 30°C to 200°C, preferably 80°C to 150°C, and particularly 90°C to 110°C. The heating time may be 10 s to 600 s. The baking step may use a heating device, such as a hot plate or an oven.

The duration of the waiting step is, for example, 0.1 s to 600 s, preferably 10 s to 300 s. If the duration of the waiting step is shorter than 0.1 s, the droplets of the curable composition (A) cannot sufficiently merge, failing to form a substantially continuous liquid film. In contrast, a duration of the waiting step exceeding 600 s reduces productivity. Therefore, to reduce the decrease in productivity, substrates after the completion of the application step may be transferred to the waiting step one after another, so that multiple substrates are subjected to the waiting step in parallel, and the substrates after the completion of the waiting step are transferred to the contact step one after another. In the known art, it theoretically takes thousands to tens of thousands of seconds to form a substantially continuous liquid film. In practice, however, volatilization interferes with the spreading of droplets of the curable composition, failing to form a continuous liquid film.

In the waiting step, on volatilizing the solvent (component (d)), a substantially continuous liquid film 104 of the non-volatile component composition (A'), which consists of components (a), (b), (c), and (e) is left. The average liquid film thickness of the substantially continuous liquid film 104 after the solvent (component d) has volatilized (has been removed) is smaller than that of the liquid film 103 by the amount of the volatilized solvent (component (d)). The pattern formation region of the substrate 101 is held coated entirely with the substantially continuous liquid film 104 of the curable composition (A) from which the solvent (component (d)) is removed.

Contact Step

In the curing step, the substantially continuous liquid film 104 of the curable composition (A) from which the solvent (component (d)) is removed, that is, the non-volatile component composition (A'), is brought into contact with a mold 106, as schematically illustrated in Fig. 1E. The contact step includes the sub step of changing the state of the non-volatile component composition (A') and the mold 106 from a state where they are not in contact to a state where they are in contact, and the sub step of maintaining the state where they are in contact. Through these sub steps, the liquid of the non-volatile component composition (A') fills the recesses of the fine pattern in the surface of the mold 106 to form a liquid film filling the fine pattern of the mold 106.

In the present disclosure, during the waiting step, the curable composition (A) forms a substantially continuous liquid film 104 of the non-volatile component composition (A'), from which the solvent (component (d)) has been removed, thus reducing the volume of gases trapped between the mold 106 and the substrate 101. Consequently, the spreading of the non-volatile component composition (A') is rapidly completed in the contact step.

Rapid completion of the spreading and filling of the non-volatile component composition (A') in the contact step reduces the duration of the state where the mold 106 is held in contact with the non-volatile component composition (A') (the time required for the contact step). Reducing the time required for the contact step leads to a reduction in the time required for pattern formation (film formation), thereby increasing productivity. Preferably, the duration of the contact step is 0.1 s to 3 s, particularly 0.1 s to 1 s. A contact step shorter than 0.1 s results in insufficient spreading and filling, leading to a tendency for defects known as incomplete filling to occur frequently.

According to the present disclosure, the duration of the state where the mold 106 is held in contact with the non-volatile component composition (A') (the time required for the contact step) can be reduced in the contact step. Reducing the time required for the contact step leads to a reduction in the time required for pattern formation (film formation), thereby increasing productivity (throughput). Preferably, the duration of the contact step is 0.1 s to 3 s, particularly 0.1 s to 1 s. A contact step shorter than 0.1 s results in insufficient filling of edges, leading to a tendency for defects known as incomplete edge filling to occur frequently. Thus, the use of the non-volatile component composition (A) disclosed herein enables highly productive (high-throughput) imprinting processing.

When the curing step includes a sub step of irradiation with light, the mold 106 is made of an optically transparent material, taking into account the irradiation sub step. Examples of the material of the mold 106 include glass, quartz, optically transparent resins, such as polymethyl methacrylate (PMMA), and polycarbonate, transparent metal films formed by vapor deposition, soft films of polydimethylsiloxane or the like, photo-cured films, and metal films. When an optically

transparent resin is used as the material of the mold 106, a resin insoluble in any constituent of the curable composition (A) is selected. Quartz is suitable as the material of the mold 106 because it has a small thermal expansion coefficient and minimizes pattern distortion.

The pattern formed in the surface of the mold 106 has a height of, for example, 4 nm to 200 nm. The smaller the height of the pattern of the mold 106, the smaller the force required to separate the mold 106 from the cured film of the curable composition, that is, the smaller the releasing force, in the mold releasing step. This reduces the number of defects in mold releasing where the pattern of the curable composition is torn off and remains in the mold 106. In addition, the impact of separating the mold may cause elastic deformation of the pattern of the curable composition, which can cause adjacent pattern elements to come into contact with each other, leading to adhesion or damage. To avoid such problems, however, it is advantageous that the height of pattern elements is about twice or less the width of the pattern elements (aspect ratio of 2 or less). Also, an excessively small height of the pattern elements leads to a reduced processing precision of the substrate 101.

The mold 106 may be subjected to surface treatment before the contact step to improve its release from the curable composition (A). For the surface treatment, a releasing agent may be applied to the surface of the mold 106 to form a releasing agent layer. Examples of the releasing agent to be applied to the surface of the mold 106 include silicon-containing releasing agents, fluorine-containing releasing agents, hydrocarbon releasing agents, polyethylene-based releasing agents, polypropylene-based releasing agents, paraffin releasing agents, montanic releasing agents, and carnauba releasing agents. Commercially available coating-type releasing agents, such as Optool (registered trademark) DSX produced by Daikin Industries, can be suitably used. An individual releasing agent may be used, or two or more releasing agents may be used in combination. Fluorine-containing and hydrocarbon releasing agents are particularly preferred.

When the mold 106 is brought into contact with the non-volatile component composition (A') in the contact step, the pressure applied to the curable composition (A) is, for example, but not limited to, 0 MPa to 100 MPa. Preferably, the pressure applied to the curable composition (A) for bringing the mold 106 into contact with the non-volatile component composition (A') is 0 MPa to 50 MPa, more preferably 0 MPa to 30 MPa, particularly 0 MPa to 20 MPa.

Although the contact step can be performed in any atmosphere of air, reduced pressure, and an inert gas, an atmosphere of reduced pressure or an inert gas is preferred. Such atmospheres can prevent oxygen or moisture from affecting the curing reaction. Examples of inert gases that can be used in the contact step include nitrogen, carbon dioxide, helium, argon, chlorofluorocarbon gases, and mixtures of these gases. Gases containing 10% by mole of carbon dioxide or helium are preferred, particularly a gas containing 10% by mass of carbon dioxide. Helium gas diffuses easily into the mold, the substrate, the curable composition, and the like, dissipating the atmospheric gas trapped in the mold pattern and the like. Carbon dioxide dissolves easily in the curable composition or the priming layer under on the substrate, dissipating the atmospheric gas trapped in the mold pattern and the like (see Japanese Patent Laid-Open No. 2022-99271). In this instance, the curable composition is preferably such that carbon dioxide exhibits a solubility coefficient of 0.5 $kg/m^3 \cdot atm$ to 10 $kg/m^3 \cdot atm$. When the contact step is performed in an atmosphere of a specific gas, including atmospheric air, the pressure of the gas is preferably 0.0001 to 10 atmospheres.

## Curing Step

In the curing step, the non-volatile component composition (A') is cured by being irradiated with irradiation light 107 as curing energy, as schematically illustrated in Fig. 1F, thus forming a cured film. In the curing step, the irradiation light 107 is applied to the non-volatile component composition (A') through the mold 106. More specifically, the irradiation light 107 is applied to the non-volatile component composition (A') filling the fine pattern of the mold 106 through the mold 106. Thus, the non-volatile component composition (A') filling the fine pattern of the mold 106 is cured into a cured film 108 with a pattern.

The irradiation light 107 is selected according to the wavelength that the non-volatile component composition (A') senses. Specifically, the irradiation light 107 is selected from those with wavelengths of 150 nm to 400 nm, such as ultraviolet light, X-ray radiation, and electron beams. Ultraviolet light is particularly preferred as the irradiation light 107. This is because many of the commercially available curing aids (photopolymerization initiators) are sensitive to ultraviolet light. Examples of light sources that emit ultraviolet light include highpressure mercury-vapor lamps, ultrahigh-pressure mercury-vapor lamps, low-pressure mercury-vapor lamps, Deep-UV lamps, carbon arc lamps, chemical lamps, metal halide lamps, xenon lamps, KrF excimer lasers, ArF excimer lasers, and $F_2$ lasers. Ultrahigh-pressure mercury-vapor lamps are particularly preferred as the light source emitting ultraviolet light. The number of light sources may be one or more. The entirety of the non-volatile component composition (A') filling the fine pattern of the mold or a portion (limited to a specific area) of the non-volatile component composition may be irradiated with light. The irradiation with light may be performed over the entire region of the substrate intermittently several times or continuously.

Alternatively, for example, a first region may be irradiated in a first irradiation stage, and a second region, different from the first region, may be irradiated in a second irradiation stage.

Mold Releasing Step

In the mold releasing step, the mold 106 is separated from the cured film 108, as schematically illustrated in Fig. 1G. The separation of the mold 106 from the cured film 108 with a pattern provides an independent cured film 108 with the pattern, which is the inverse of the fine pattern of the mold 106.
In this state, the cured film 108 with the pattern retains the cured product of the curable composition in the recesses of the cured film. This cured product is called the residual film.
For separating the mold 106 from the cured film 108 with the pattern, separation conditions are not limited, provided that part of the cured film 108 with the pattern is not physically damaged. For example, the substrate 101 is fixed, and the mold 106 is moved away from the fixed substrate 101. Alternatively, the mold 106 may be fixed, and the substrate 101 is moved away from the fixed mold 106. The mold 106 may be separated from the cured film 108 with the pattern by moving both the mold 106 and the substrate 101 in opposite directions.

Repetition

The series of steps from the application step to the mold releasing step in this order (manufacturing process) forms a cured film having a desired relief pattern structure (pattern structure following the relief pattern structure of the mold 106) in a desired position.
The pattern formation method disclosed herein allows the series (shot) of steps from the application step to the mold releasing step to be performed on an identical substrate repeatedly several times, thus providing a cured film 108 with a plurality of desired patterns. Planarizing Film Formation Method
An example in which the film formation method described herein is applied to a planarizing film formation method will now be described. The planarizing film formation method includes, for example, an application step, a waiting step, a contact step, a curing step, and a mold releasing step. In the application step, droplets of a curable composition (A) are applied onto a substrate. The waiting step is a duration of waiting for the merging of droplets of the curable composition (A) and the volatilization of the solvent (component (d)). In the contact step, the non-volatile component composition (A') is brought into contact with a mold. In the curing step, the non-volatile component composition (A') is cured. In the mold releasing step, the cured film of the non-volatile component composition (A') is separated from the mold. In the planarizing film formation method, a cured film with a surface following a flat surface of a mold is formed through the contact step, the curing step, and the mold releasing step, using a substrate having a surface with irregularities of about 10 nm to 1,000 nm in height difference and the mold with the flat surface. In the application step, droplets of a curable composition (A) are densely applied in the recesses of the substrate, while the curable composition (A) is sparsely applied on the protrusions of the substrate. The waiting step follows the application step. The contact step is performed after the waiting step. The curing step is performed after the contact step. The mold releasing step is performed after the curing step.

Method for Manufacturing Article

A method for manufacturing an article includes a film formation step of forming a film of a curable composition on a substrate using the above-described film formation method, a processing step of processing the substrate with the film of the curable composition formed in the film formation step, and a fabricating step of fabricating an article using the substrate processed in the processing step. The film formation method may be implemented as a pattern formation method or a planarizing film formation method, as described above.
The cured film 108 having a pattern formed by the pattern formation method described herein may be used as it is, as at least a component of various articles. Alternatively, the cured film 108 having a pattern formed by the pattern formation method described herein may be temporarily used as a mask for etching or ion implantation of a substrate 101 (or a layer to be processed when the substrate 101 has the layer to be processed). The mask is removed after the etching or ion implantation in the step of processing the substrate 101. Thus, various articles are manufactured.
For removing the cured product (residual film) in the recesses of the pattern in the cured film by etching, known techniques, such as dry etching, may be used without limitation to a specific technique. For dry etching, a known dry etching apparatus may be used. The dry etching source gas is appropriately selected according to the elemental composition of the cured product to be etched. Specifically, examples of the source gas include halogen-based gases, such as $CF_4$, $C_2F_6$, $C_3F_8$, $CCl_2F_2$, $CCl_4$, $CBrF_3$, $BCl_3$, $PCl_3$, $SF_6$, and $Cl_2$. Other examples of the source gas include oxygen-containing gases, such as $O_2$, CO, and $CO_2$; and inert gases, such as He, $N_2$, and Ar. $H_2$ or $NH_3$ may also be used. The source gas may be a mixed gas of these gases. In this operation, the cured film needs to have high resistance to dry etching to achieve high yield when the underlying substrate is processed.
Articles mentioned herein include electrical circuit elements, optical devices, microelectromechanical systems (MEMS), recording devices, sensors, and molds. Examples of electrical circuit elements include volatile or non-volatile semiconductor memory, such as dynamic random-access memory (DRAM), static random-access memory (SRAM), flash

Memory, or magnetoresistive random-access memory (MRAM); and semiconductor devices, such as large-scale integrated circuits (LSI), charge-coupled devices (CCD), image sensors, and field-programmable gate arrays (FPGA). Exemplary optical devices include microlenses, light guides, waveguides, antireflection films, diffraction gratings, polarizers, color filters, light-emitting devices, displays, and solar cells Examples of MEMS devices include digital micromirror devices (DMD), microfluidic channels, and electromechanical conversion elements. Examples of recording devices include optical disks, such as CDs and DVDs, magnetic disks, magneto-optical disks, and magnetic heads. Examples of sensors include magnetic sensors, optical sensors, and gyro sensors. Examples of molds include those used for imprinting.

Known lithography processes, such as imprint lithography and extreme ultraviolet (EUV) lithography, can be conducted on a planarizing film formed by the planarizing film formation method described herein. Also, the curable composition disclosed herein can be applied onto a stack including a spin-on-glass (SOG) film and/or a silicon oxide layer for a photolithography process. Thus, a device such as a semiconductor device can be manufactured. Also, electronic apparatuses including such a device, such as displays, cameras, and medical apparatuses, can be fabricated. Examples of such devices include LSI, system LSI, DRAM, synchronous dynamic random-access memory (SDRAM), Rambus DRAM (RDRAM), direct Rambus DRAM (D-RDRAM), and NAND flash memory.

EXAMPLES

Specific examples will be described to supplement the above-described embodiments.

EXAMPLE 1

When a mixture of a curable composition and a surfactant comes into contact with an ambient gas, the surfactant, if it is highly hydrophobic and has a low SP value, segregates within several nanometers near the ambient gas interface. The degree of segregation can be determined by applying the Flory-Huggins theory to the mixture system containing the curable composition, the surfactant, and air, and calculating the material distribution at which the free energy of the system is minimized. The material distribution is determined by the relationship between the SP values of the curable composition, the surfactant, and air. For example, air has an SP value of 10, while the hydrophobic moiety of a surfactant, Surfynol, has an SP value of 13.8, and a polymerizable compound, tricyclodecanedimethanol diacrylate, has an SP value of 15.8. Consequently, the surfactant, which has a closer SP value, segregates at the air interface.

EXAMPLE 2

Example 2 is intended to demonstrate that the edge filling speed v is given by equation 1 using the viscosity $\mu$ (mPa·s) of the non-volatile component composition and the average liquid film thickness h (m) of the curable composition.

$$v(\mu, h) = C \times h^{\alpha} \times \mu_0 / \mu \quad \text{(Equation 1)}$$

where $C = 9.75e^{-2}$, $\alpha = 0.489$, and $\mu_0 = 50$ (mPa·s)

Assuming a contact process, the present example determined the edge filling velocity using a simultaneous system of equations combining the Navier-Stokes equations, approximated as the thin film confined between walls, and the equation of the elastic deformation of the mold. Fig. 4 shows the state of the computational region. Reference numeral 106 designates a mold;102 designates a liquid film; 101 designates a substrate; 109 designates an edge of a pattern formation region; and 110 designates an initial position of an end of the liquid film. The x and y axes are taken as depicted in Fig. 4. The calculation was approximated as a two-dimensional matter, in which the negative end of the x-axis was treated as a symmetric boundary and the direction perpendicular to the plane of Figure 4 is assumed symmetric.

The mold was modeled as a linear elastic body with a Young's modulus of 72 GPa and a Poisson's ratio of 0.17. The surface tension coefficient of the liquid film was set to 30 mN/m. As shown in Fig. 4, the average initial liquid film thickness was fixed, and distance between 110 and 109 was set to 100 $\mu$m. On the negative side of the x axis relative to A05, the gap between the mold and the substrate was assumed to be filled with the liquid film with no gap between the liquid film and the mold. The liquid film is in contact with the substrate with a contact angle of 0° at A05. The simulation was started in a stationary state. The numerical calculation method used in the present example is merely an example, and other calculation methods may be used.

Fig. 5 shows changes in edge filling speed with varying viscosity coefficient of a liquid film with an average liquid film thickness of 40 nm. In Fig. 5, the horizontal axis represents time, and the vertical axis represents the distance between the end of the liquid film and the edge of the pattern formation region. It should be noted that the vertical axis is oriented with the downward direction as positive. B01, B02, and B03 correspond to the results of the liquid films with viscosities of 50 mPa·s, 150 mPa·s, and 300 mPa·s, respectively. These results indicate that the lower the viscosity, the faster the edge

filling speed. Fig. 6 shows results from the same calculation with the horizontal axis plotted as time/viscosity coefficient. As indicated by C01, the results form an identical curve. These results show that the edge filling speed is inversely proportional to the viscosity coefficient. Thus, it has been demonstrated that the flow rate of the liquid film is inversely proportional to the viscosity coefficient.

Fig. 7 is a plot of changes in edge filling speed with varying average thickness of a liquid film with a viscosity coefficient of 50 mPa·s. In Fig. 7, the horizontal axis represents time, and the vertical axis represents the distance between the end of the liquid film and the edge of the pattern formation region. It should be noted that the vertical axis is oriented with the downward direction as positive. D01, D02, D03, D04, and D05 correspond to the results of the liquid films with average liquid film thicknesses of 1000 nm, 200 nm, 100 nm, 80 nm, 40 nm, respectively. These results indicate that the larger the average liquid film thickness, the faster the edge filling speed.

Fig. 8 shows a graph with the average liquid film thickness on the horizontal axis and the edge filling speed on the vertical axis. The plotted points indicate calculation results, and the curve represents Equation 1. Thus, the dependence on average liquid film thickness of the edge filling speed can be expressed using Equation 1. As discussed above, the edge filling speed is inversely proportional to the viscosity coefficient, thus suggesting that the viscosity coefficient dependence can also be expressed by Equation 1.

Thus, it has been demonstrated that the edge filling speed can be expressed as a function of $\mu$ and h (Equation 1).

Table 1 presents the viscosity measurements of surfactants (component (c)) at 23°C and 1 atm.

Table 1

| | Name | Viscosity (at 23°C) / mPa·s |
|---|---|---|
| Example 2 | PLURONIC L-44, produced by ADEKA | 435.4 |
| Example 3 | PLURONIC 17R2, produced by ADEKA | 407.1 |
| Example 4 | WONDERSURF 140, produced by produced by Aoki Oil Industrial | 146.6 |
| Example 5 | BLAUNON SA-50/50 1000R, produced by produced by Aoki Oil Industrial | 114.6 |
| Example 6 | BLAUNON SA-30/70 2000R, produced by produced by Aoki Oil Industrial | 217 |
| Example 7 | TERGITOL EH-9, produced by Dow | 101.8 |
| Example 8 | TERGITOL HW-1000, produced by Dow | 41.2 |
| Example 9 | TERGITOL TMN-3, produced by Dow | 22.4 |
| Example 10 | TRITON X-45, produced by Dow | 374 |
| Example 11 | Dynol-604, produced by Evonik | 340.45 |
| Example 12 | Acetylenol E100, produced by Kawaken Fine Chemical | 171.3 |
| Example 13 | Surfynol 420, produced by Nissin Chemical Industry | 295.6 |
| Example 14 | Acetylenol E13T, produced by Kawaken Fine Chemical | 295.6 |

Table 2 presents the viscosity at 23°C and 1 atm, and the edge filling speed of the non-volatile component (A') obtained by mixing components (a), (b), (e), and (d) to total 100 % by mass to prepare a curable composition (A) and removing component (d) from the curable composition (A). In Table 2, the first constituent, DCPDA, in component (a) refers to tricyclodecanedimethanol diacrylate, while the second constituent, DDODA, refers to 1,10-decanediol diacrylate. PGMEA in component (d) stands for propylene glycol monomethyl ether. The edge filling speed was estimated using equation 2 and evaluated with an average liquid film thickness of 300 nm, according to the following criteria:

A: Edges are filled at 100 $\mu$m/s or more.

B: Edges are filled at less than 100 $\mu$m/s.

Table 2

| | Polymerizable compounds (a) | | | | Polymerization initiator (b) | | Solvent (d) | | Viscosity (at 23°C) after solvent removal / mPa·s | Edge filling speed |
|---|---|---|---|---|---|---|---|---|---|---|
| | 1st constituent | | 2nd constituent | | | | | | | |
| | Name | Amount | Name | Amount | Name | Amount | Name | Amount | | |
| Example 15 | DCPDA | 5 | DDODA | 15 | Omnirad 819 | 1.0 | PGMEA | 79.00 | 18 | A |
| Example 16 | DCPDA | 8 | DDODA | 12 | Omnirad 819 | 1.0 | PGMEA | 79.00 | 28 | A |
| Comparative Example 1 | DCPDA | 15 | DDODA | 5 | Omnirad 819 | 1.0 | PGMEA | 79.00 | 79 | B |
| Comparative Example 2 | DCPDA | 20 | DDODA | 0 | Omnirad 819 | 1.0 | PGMEA | 79.00 | 126 | B |

As described above, the curable composition disclosed herein exhibits high edge filling speed and achieves high productivity when used for imprinting.

The concept of the present disclosure is not limited to the above-described embodiments, and various modifications and changes may be made without departing from the spirit and scope of the invention. Accordingly, the claims will be appended below to make public the scope of the disclosure.

Accordingly, the present disclosure provides a novel technique for curable compositions.

Various embodiments have been described in detail above but it will be understood that the present disclosure is not limited to these embodiments and encompasses all modifications, variants, alternatives and equivalents falling within the scope of the appended claims.

1. A curable composition comprising:

a polymerizable compound (a);
a photopolymerization initiator (b), and
a solvent (d) having a boiling point of less than 250°C in an amount ranging from more than 5% to 95% by volume relative to the entire curable composition,
wherein
the curable composition has a viscosity of 1.3 mPa·s to 60 mPa·s at 23°C and 1 atm, and
the viscosity of a composition formed by excluding the solvent (d) from the curable composition is 8 mPa·s to 30 mPa·s at 23°C and 1 atm.

2. A curable composition comprising:

a polymerizable compound (a);
a photopolymerization initiator (b);
a surfactant (c) having a viscosity of 500 mPa·s or less at 23°C and 1 atm; and
a solvent (d) having a boiling point of less than 250°C in an amount ranging from more than 5% to 95% by volume relative to the entire curable composition,
wherein the curable composition has a viscosity of 1.3 mPa·s to 60 mPa·s at 23°C and 1 atm.

3. The curable composition according to item 1 or 2, wherein a composition formed by excluding the solvent (d) from the curable composition has a viscosity of 8 mPa·s to 20 mPa·s at 23°C and 1 atm.

4. The curable composition according to item 2, wherein the surfactant (c) has a viscosity of 400 mPa·s or less at 23°C and 1 atm.

5. The curable composition according to item 1 or 2, wherein the solvent (d) includes one or more solvents, and each of the one or more solvents has a boiling ranging from 100°C to less than 250°C at 1 atm.

6. The curable composition according to item 1 or 2, wherein the polymerizable compound (a) includes one or more polymerizable compounds, and each of the one or more polymerizable compounds has a boiling point of 250°C or more at 1 atm.

7. The curable composition according to item 1 or 2, wherein the polymerizable compound (a) includes a monofunctional polymerizable compound and a polyfunctional polymerizable compound, and
wherein the polyfunctional polymerizable compound accounts for 20% or more by mass of the polymerizable compound (a).

8. The curable composition according to item 1 or 2, wherein the polymerizable compound (a) includes one or more polymerizable compounds, and each of the one or more polymerizable compounds has a molecular weight of 200 or more.

9. The curable composition according to item 1, wherein the polymerizable compound (a) includes a polymer having a polymerizable functional group.

10. The curable composition according to any one of items 1 to 9, wherein the curable composition exhibits a glass transition temperature of 70°C or more after being cured.

11. The curable composition according to any one of items 1 to 9, wherein the polymerizable compound (a) includes one or more polymerizable compounds, and each of the one or more polymerizable compounds has a vapor pressure of 0.001 mmHg or less at 80°C and 1 atom.

12. The curable composition according to any one of items 1 to 9, wherein the polymerizable compound (a) includes a compound (a-1) having an aromatic structure, an aromatic heterocyclic structure, or an alicyclic structure.

13. The curable composition according to any one of items 1 to 9,
wherein

the polymerizable compound (a) includes one or more polymerizable compounds and
the polymerizable compound (a) has an Ohnishi parameter abbreviated to OP of 1.80 to 4.00, the Ohnishi parameter being the molar fraction weighted average of the N/(Nc - No) value of each molecule of the one or more polymerizable compounds, wherein N represents the total number of atoms in a molecule, Nc is the number of carbon atoms in the molecule, and No is the number of oxygen atoms in the molecule.

14. The curable composition according to any one of items 1 to 9, wherein the composition obtained by removing the solvent (d) contains 10% or more by mass of silicon atoms.

15. The curable composition according to any one of items 1 to 9, wherein the curable composition has a carbon dioxide solubility coefficient of 0.5 $kg/m^3 \cdot atm$ to 10 $kg/m^3 \cdot atm$.

16. The curable composition according to any one of items 1 to 9, wherein the curable composition is used for an ink jet method.

17. A film formation method for forming a film of a curable composition on a substrate (101) using a mold, the method comprising:

applying a plurality of droplets (102) of the curable composition according to any one of items 1 to 16 discretely onto the substrate (101);
bringing the plurality of droplets (102) on the substrate (101) into contact with a mold (106) to form a liquid film (104) between the substrate (101) and the mold (104) after the application of the droplets (102);
curing the liquid film (104) into a cured film (108) after the contact of the droplets with the mold; and
releasing the cured film (108) from the mold (106) after the curing.

18. The film formation method according to item 17, further comprising waiting until the droplets of the curable composition merge on the substrate to form a substantially continuous liquid film between the application and the contact and until the solvent in the liquid film volatilizes.

19. The film formation method according to item 18, wherein the waiting lasts until the solvent in the liquid film volatilizes to 10% by volume or less relative to the entire liquid film.

20. The film formation method according to item 18, wherein the substrate is heated at a temperature of 30°C to 200°C for 10 s to 600 s in the waiting step.

21. The film formation method according to item 17, wherein the application is performed by applying droplets of the curable composition, each with a volume of 1.0 pL or more, onto the substrate at a density of 80 droplets/$mm^2$ or more.

22. The film formation method according to item 17, wherein the mold has a contact face with a relief pattern, and the contact is achieved by bringing the liquid film into contact with the pattern of the mold, and
wherein the film formation method further comprises additionally curing the cured film formed through the contact and the curing of the liquid film, thereby forming a cured film with a pattern corresponding to the pattern of the mold.

23. The film formation method according to item 17, wherein the mold has a contact face with a flat surface, and the contact is achieved by bringing the liquid film into contact with the flat surface of the mold, and
wherein the film formation method further comprises additionally curing the cured film formed through the contact and the curing of the liquid film, thereby forming a cured film with a surface following the flat surface of the mold.

24. A method for manufacturing an article, comprising:

forming a film of a curable composition on a substrate using the film formation method according to item 17;
processing the substrate with the film formed in the formation of a film; and
fabricating an article using the substrate processed in the processing of the substrate.

**Claims**

**1.** A curable composition comprising:

a polymerizable compound (a);
a photopolymerization initiator (b), and
a solvent (d) having a boiling point of less than 250°C in an amount ranging from more than 5% to 95% by volume relative to the entire curable composition,
wherein
the curable composition has a viscosity of 1.3 mPa·s to 60 mPa·s at 23°C and 1 atm, and
the viscosity of a composition formed by excluding the solvent (d) from the curable composition is 8 mPa·s to 30 mPa·s at 23°C and 1 atm.

**2.** A curable composition comprising:

a polymerizable compound (a);
a photopolymerization initiator (b);
a surfactant (c) having a viscosity of 500 mPa·s or less at 23°C and 1 atm; and
a solvent (d) having a boiling point of less than 250°C in an amount ranging from more than 5% to 95% by volume relative to the entire curable composition,
wherein the curable composition has a viscosity of 1.3 mPa·s to 60 mPa·s at 23°C and 1 atm.

**3.** The curable composition according to claim 1 or 2, wherein the polymerizable compound (a) includes one or more polymerizable compounds, and each of the one or more polymerizable compounds has a boiling point of 250°C or more at 1 atm.

**4.** The curable composition according to claim 1 or 2, wherein the polymerizable compound (a) includes a monofunctional polymerizable compound and a polyfunctional polymerizable compound, and
wherein the polyfunctional polymerizable compound accounts for 20% or more by mass of the polymerizable compound (a).

**5.** The curable composition according to claim 1 or 2, wherein the polymerizable compound (a) includes one or more polymerizable compounds, and each of the one or more polymerizable compounds has a molecular weight of 200 or more.

**6.** The curable composition according to any one of claims 1 to 5, wherein the curable composition exhibits a glass transition temperature of 70°C or more after being cured.

**7.** The curable composition according to any one of claims 1 to 5, wherein the polymerizable compound (a) includes one or more polymerizable compounds, and each of the one or more polymerizable compounds has a vapor pressure of 0.001 mmHg or less at 80°C and 1 atom.

**8.** The curable composition according to any one of claims 1 to 5, wherein the polymerizable compound (a) includes a compound (a-1) having an aromatic structure, an aromatic heterocyclic structure, or an alicyclic structure.

**9.** The curable composition according to any one of claims 1 to 5,
wherein

the polymerizable compound (a) includes one or more polymerizable compounds and
the polymerizable compound (a) has an Ohnishi parameter abbreviated to OP of 1.80 to 4.00, the Ohnishi parameter being the molar fraction weighted average of the N/(Nc - No) value of each molecule of the one or more

polymerizable compounds, wherein N represents the total number of atoms in a molecule, Nc is the number of carbon atoms in the molecule, and No is the number of oxygen atoms in the molecule.

**10.** A film formation method for forming a film of a curable composition on a substrate (101) using a mold, the method comprising:

applying a plurality of droplets (102) of the curable composition according to any one of claims 1 to 16 discretely onto the substrate (101);
bringing the plurality of droplets (102) on the substrate (101) into contact with a mold (106) to form a liquid film (104) between the substrate (101) and the mold (104) after the application of the droplets (102);
curing the liquid film (104) into a cured film (108) after the contact of the droplets with the mold; and
releasing the cured film (108) from the mold (106) after the curing.

**11.** The film formation method according to claim 10, further comprising waiting until the droplets of the curable composition merge on the substrate to form a substantially continuous liquid film between the application and the contact and until the solvent in the liquid film volatilizes.

**12.** The film formation method according to claim 11, wherein the waiting lasts until the solvent in the liquid film volatilizes to 10% by volume or less relative to the entire liquid film.

**13.** The film formation method according to claim 11, wherein the substrate is heated at a temperature of 30°C to 200°C for 10 s to 600 s in the waiting step.

**14.** A method for manufacturing an article, comprising:

forming a film of a curable composition on a substrate using the film formation method according to claim 10;
processing the substrate with the film formed in the formation of a film; and
fabricating an article using the substrate processed in the processing of the substrate.

FIG. 1A

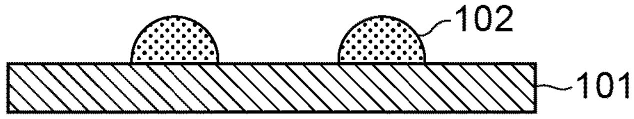


FIG. 1B

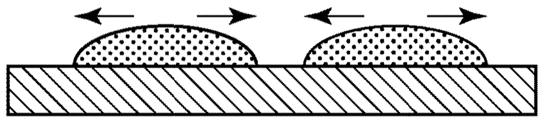

FIG. 1C

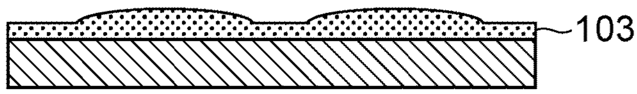


FIG. 1D

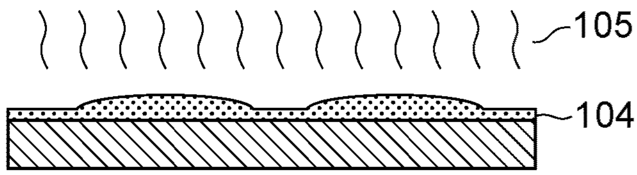


FIG. 1E

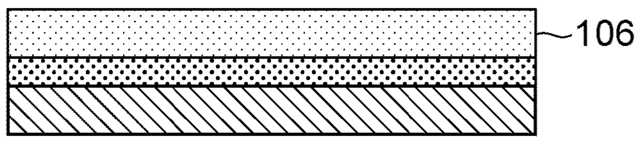


FIG. 1F

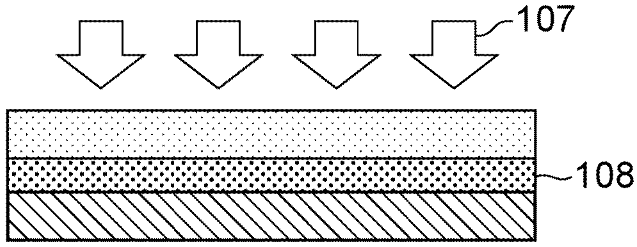


FIG. 1G

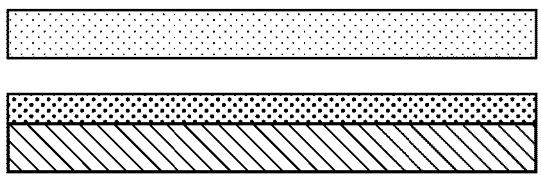

FIG. 2A

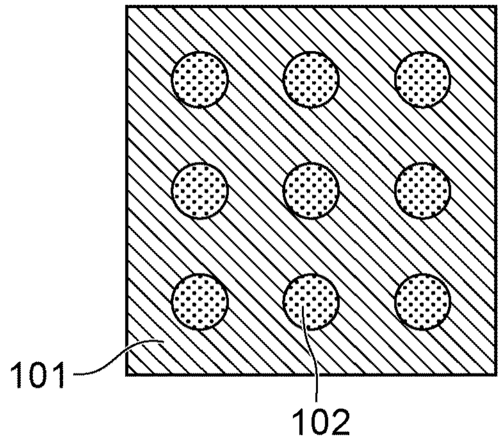


FIG. 2B

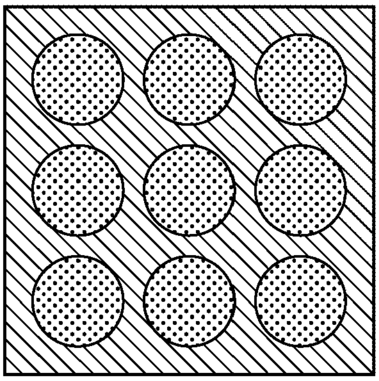

FIG. 2C

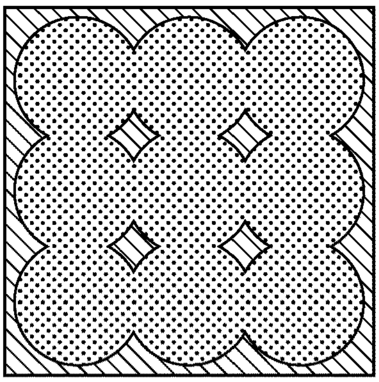

FIG. 2D

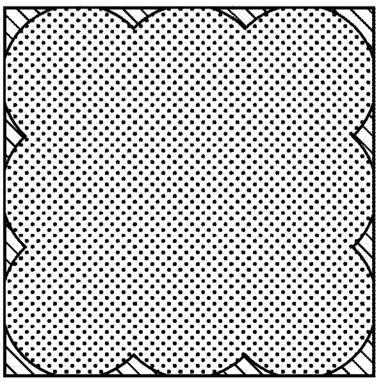

FIG. 3

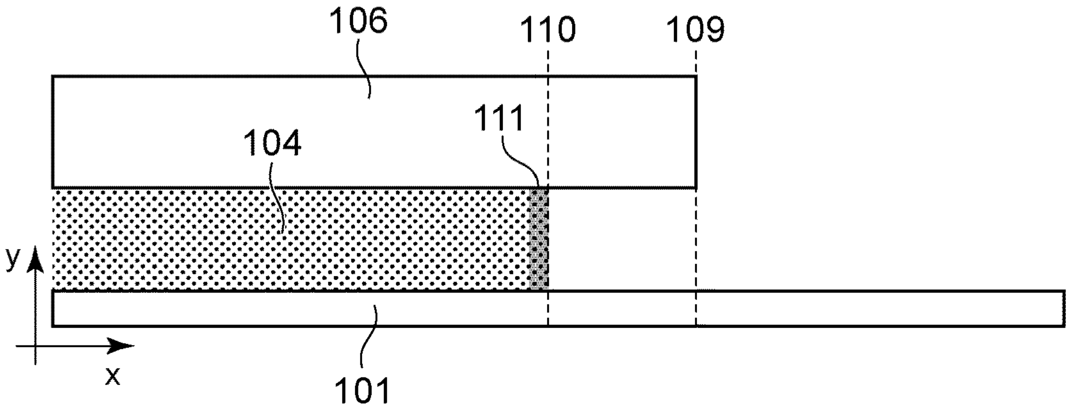


FIG. 4

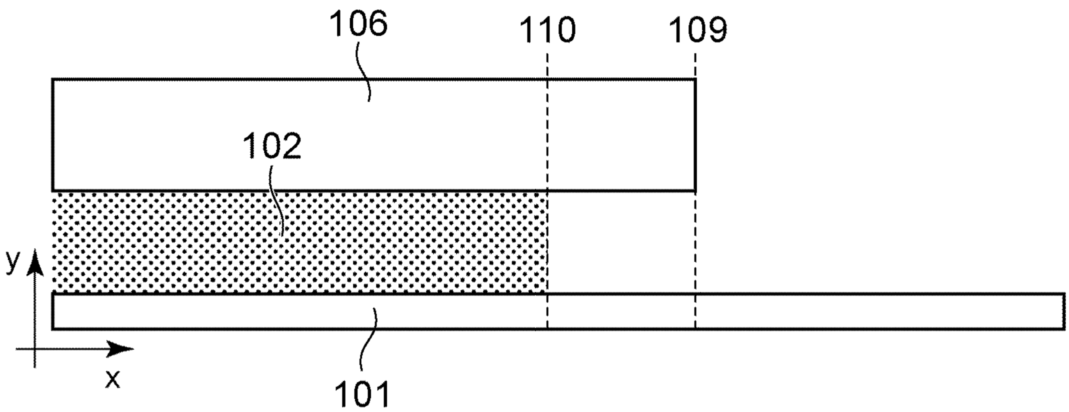

FIG. 5

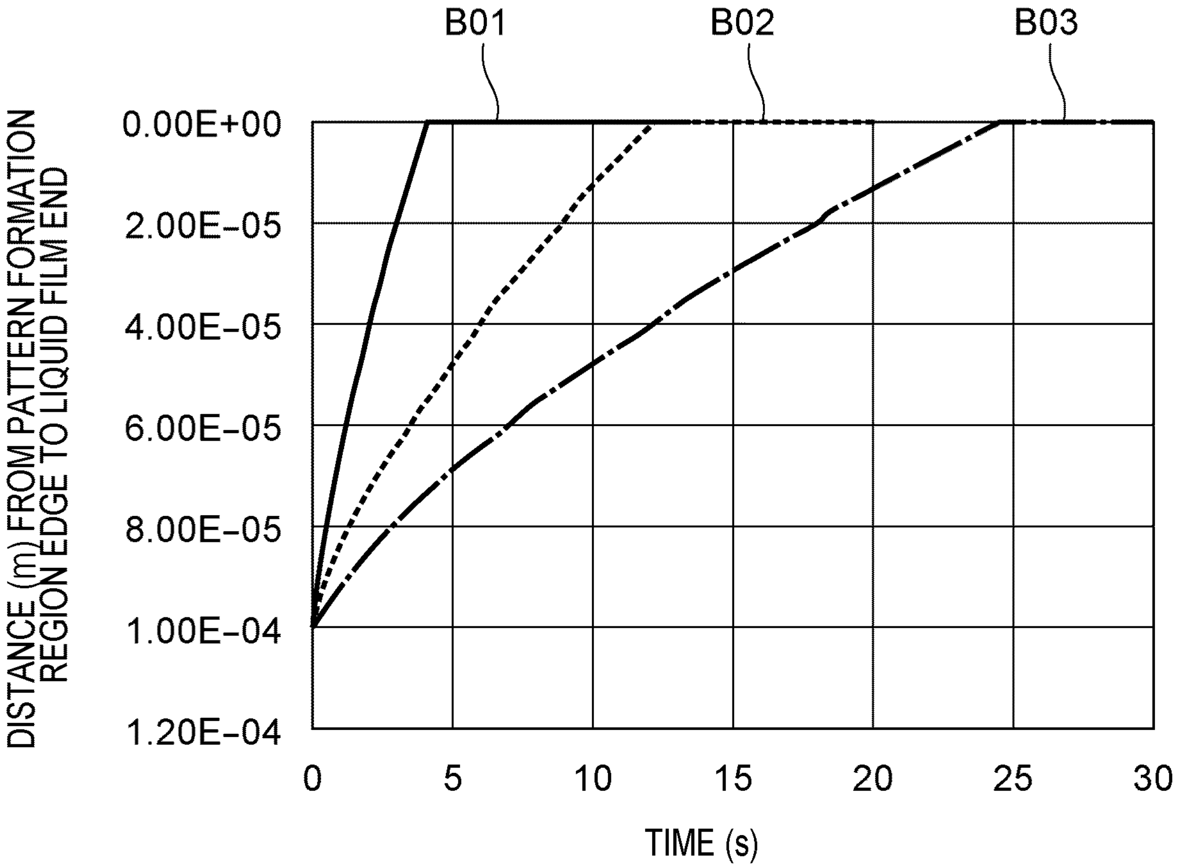
B01
B02
B03
DISTANCE (m) FROM PATTERN FORMATION REGION EDGE TO LIQUID FILM END
0.00E+00
2.00E−05
4.00E−05
6.00E−05
8.00E−05
1.00E−04
1.20E−04
0
5
10
15
20
25
30
TIME (s)

FIG. 6

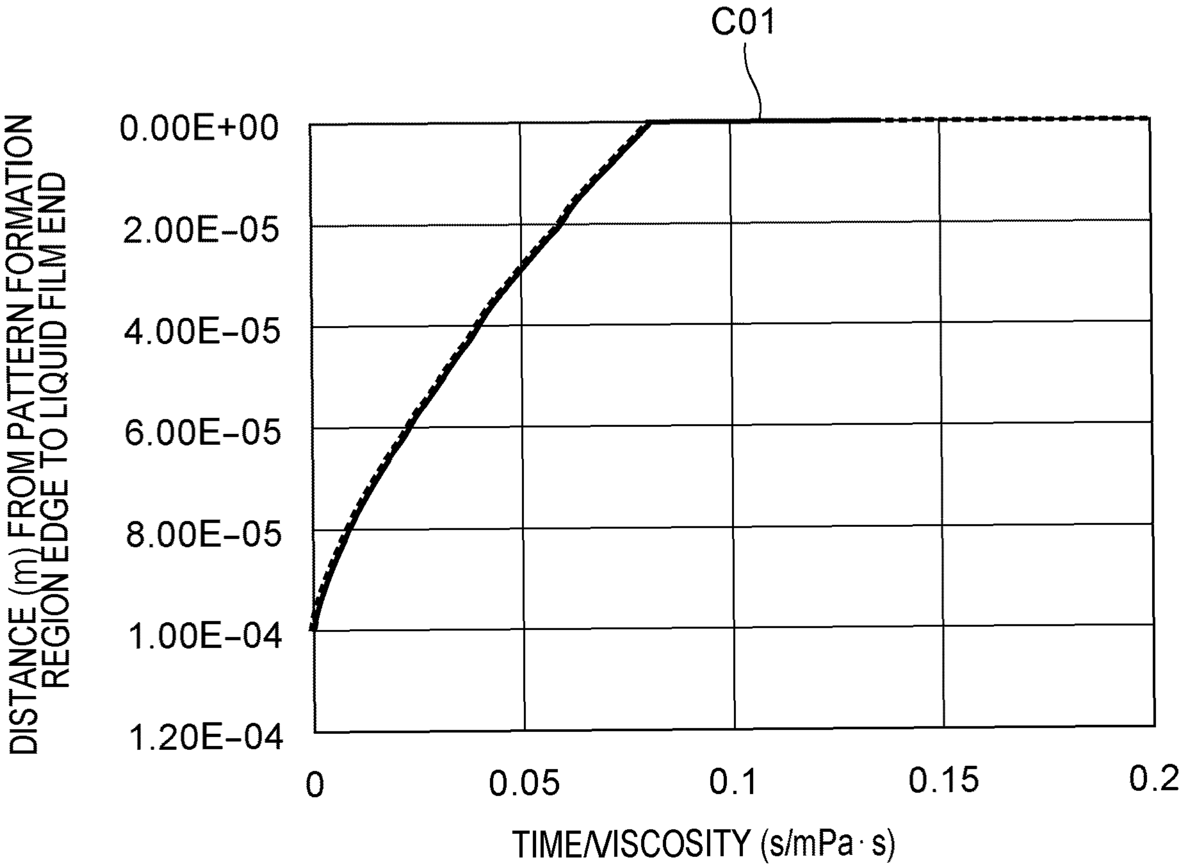
C01
DISTANCE (m) FROM PATTERN FORMATION REGION EDGE TO LIQUID FILM END
0.00E+00
2.00E-05
4.00E-05
6.00E-05
8.00E-05
1.00E-04
1.20E-04
0
0.05
0.1
0.15
0.2
TIME/VISCOSITY (s/mPa·s)

FIG. 7

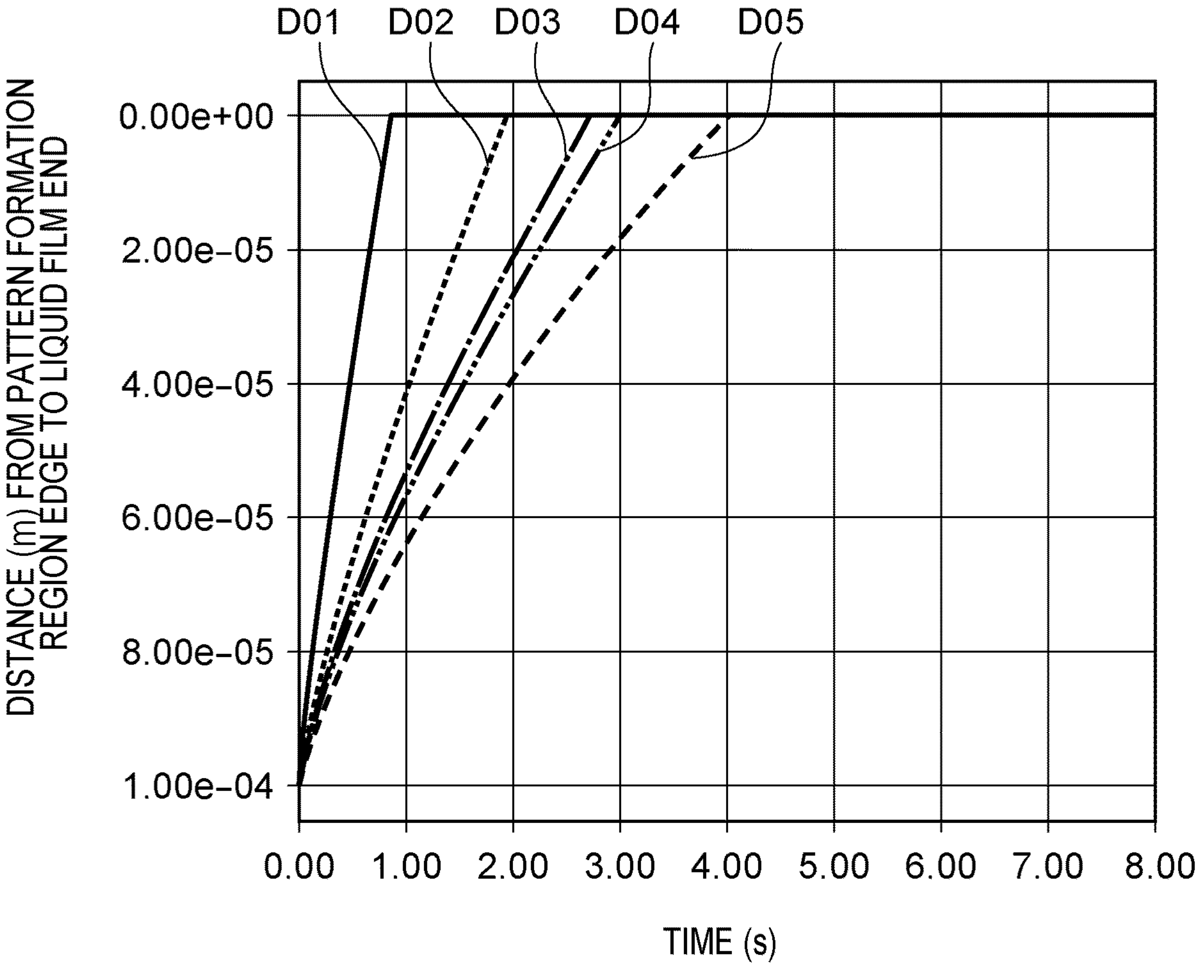
D01
D02
D03
D04
D05
DISTANCE (m) FROM PATTERN FORMATION REGION EDGE TO LIQUID FILM END
0.00e+00
2.00e−05
4.00e−05
6.00e−05
8.00e−05
1.00e−04
0.00
1.00
2.00
3.00
4.00
5.00
6.00
7.00
8.00
TIME (s)

FIG. 8

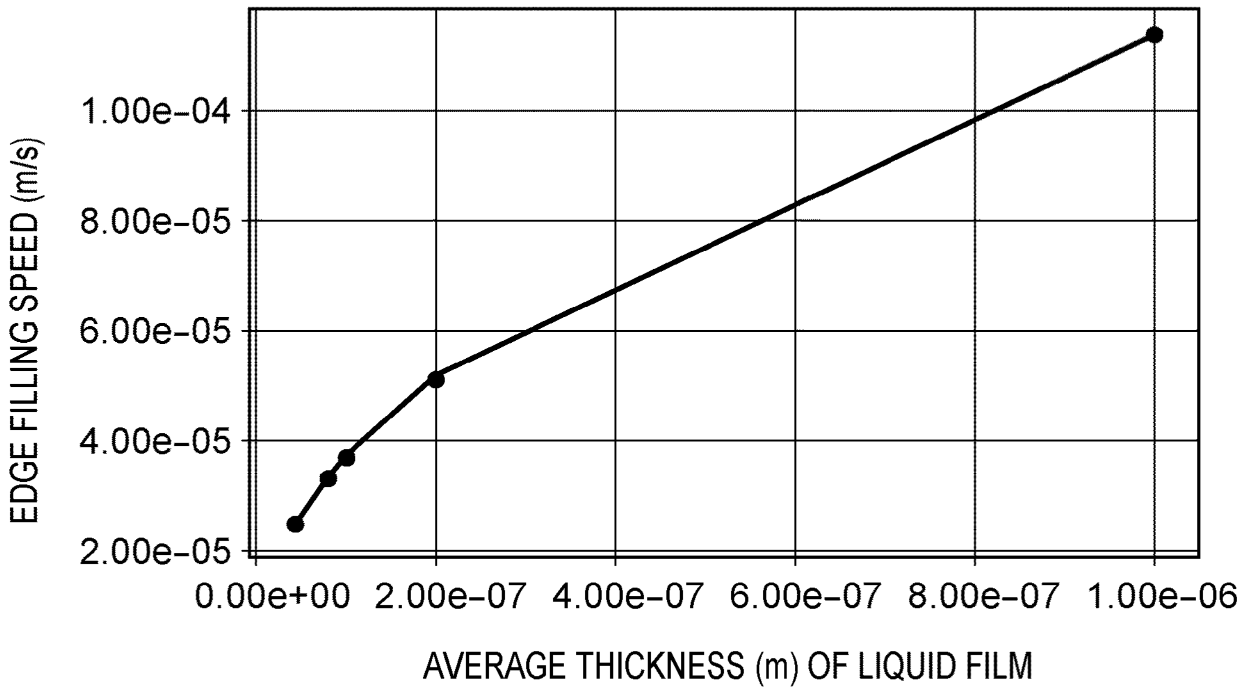
1.00e−04
8.00e−05
6.00e−05
4.00e−05
2.00e−05
EDGE FILLING SPEED (m/s)
0.00e+00
2.00e−07
4.00e−07
6.00e−07
8.00e−07
1.00e−06
AVERAGE THICKNESS (m) OF LIQUID FILM

Europäisches Patentamt
European Patent Office
Office européen des brevets

# EUROPEAN SEARCH REPORT

Application Number
EP 25 21 2298

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2023 181983 A (CANON KK) 25 December 2023 (2023-12-25) * comparative examples 7-8; claims 8-9, 16; table 5 * ----- | 1,3-14 | INV. G03F7/00 G03F7/027 |
| X | US 2021/032385 A1 (IIDA YUKA [JP] ET AL) 4 February 2021 (2021-02-04) * examples 1-9, 13-14; tables 1-3 * ----- | 2-4,6-9 | |

TECHNICAL FIELDS SEARCHED (IPC)
B29C
C08F
G03F

The present search report has been drawn up for all claims

1

| Place of search | Date of completion of the search | Examiner |
|---|---|---|
| The Hague | 10 February 2026 | Jegou, Gwénaëlle |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..................................................
& : member of the same patent family, corresponding document

EPO FORM 1503 03.82 (P04C01)

## ANNEX TO THE EUROPEAN SEARCH REPORT ON EUROPEAN PATENT APPLICATION NO. EP 25 21 2298

This annex lists the patent family members relating to the patent documents cited in the above-mentioned European search report. The members are as contained in the European Patent Office EDP file on
The European Patent Office is in no way liable for these particulars which are merely given for the purpose of information.

10-02-2026

| Patent document cited in search report | Publication date | Patent family member(s) | Publication date |
|---|---|---|---|
| JP 2023181983 A | 25-12-2023 | NONE | |
| US 2021032385 A1 | 04-02-2021 | CN 112004850 A | 27-11-2020 |
| | | EP 3786204 A1 | 03-03-2021 |
| | | JP 7452588 B2 | 19-03-2024 |
| | | JP 2022176959 A | 30-11-2022 |
| | | JP WO2019208554 A1 | 22-04-2021 |
| | | TW 201945416 A | 01-12-2019 |
| | | US 2021032385 A1 | 04-02-2021 |
| | | WO 2019208554 A1 | 31-10-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019140394 A
- JP 2022188736 A
- US 20200286740 A
- JP 2022099271 A


### Non-patent literature cited in the description


- **OGAWA et al.** Ultraviolet curable branched siloxanes as low-k dielectrics for imprint Lithography. *J. Vac. Sci. Technol. B*, vol. 31 (1), 011601